(19) Europäisches Patentamt
European Patent Office
Office européen des brevets

(11) EP 2 147 472 B1

(12) **EUROPEAN PATENT SPECIFICATION**

(45) Date of publication and mention of the grant of the patent:
**08.01.2014 Bulletin 2014/02**

(21) Application number: **08754288.2**

(22) Date of filing: **09.05.2008**

(51) Int Cl.:
***H01L 51/50*** *(2006.01)* *H01L 51/00* *(2006.01)*

(86) International application number:
**PCT/US2008/005941**

(87) International publication number:
**WO 2008/143796 (27.11.2008 Gazette 2008/48)**

# (54) HYBRID OLED WITH FLUORESCENT AND PHOSPHORESCENT LAYERS

HYBRID-OLED MIT FLUORESZENZ- UND PHOSPHORESZENZSCHICHTEN

OLED HYBRIDE A COUCHES FLUORESCENTES ET PHOSPHORESCENTES

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **17.05.2007 US 749883**

(43) Date of publication of application:
**27.01.2010 Bulletin 2010/04**

(73) Proprietor: **Global OLED Technology LLC**
**Herndon, VA 20171 (US)**

(72) Inventors:
- **DEATON, Joseph Charles**
  **Rochester, New York 14650 (US)**
- **KONDAKOVA, Marina Eduardovna**
  **Rochester, New York 14650 (US)**
- **GIESEN, David John**
  **Rochester, New York 14650 (US)**
- **BEGLEY, William James**
  **Rochester, New York 14650 (US)**
- **KONDAKOV, Denis Yurievich**
  **Rochester, New York 14650 (US)**

(74) Representative: **Wibbelmann, Jobst**
**Wuesthoff & Wuesthoff**
**Patent- und Rechtsanwälte**
**Schweigerstrasse 2**
**81541 München (DE)**

(56) References cited:
**WO-A-2006/097064 JP-A- 2007 027 620**

- **BALDO M A ET AL: "HIGHLY EFFICIENT PHOSPHORESCENT EMISSION FROM ORGANIC ELECTROLUMINESCENT DEVICES" NATURE, NATURE PUBLISHING GROUP, LONDON, UK, vol. 395, no. 6698, 10 September 1998 (1998-09-10), pages 151-154, XP001002103 ISSN: 0028-0836**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 147 472 B1

## Description

### FIELD OF THE INVENTION

This invention relates to an organic light emitting diode (OLED) electroluminescent (EL) device comprising a hybrid fluorescent/phosphorescent structure wherein the blue fluorescent emission component is produced with high efficiency while simultaneously allowing energetically more favored diffusion of triplet excitons from the blue singlet emissive region to the phosphorescent emissive regions that can provide desirable electroluminescent properties such as high luminous and power efficiencies and low operational voltage.

### BACKGROUND OF THE INVENTION

While organic electroluminescent (EL) devices have been known for over two decades, their performance limitations have represented a barrier to many desirable applications. In simplest form, an organic EL device is comprised of an anode for hole injection, a cathode for electron injection, and an organic medium sandwiched between these electrodes to support charge recombination that yields emission of light. These devices are also commonly referred to as organic light emitting diodes, or OLEDs. Representative of earlier organic EL devices are Gurnee et al ,U.S. Pat. No. 3,172,862, issued Mar. 9, 1965; Gurnee U.S. Pat. No. 3,173,050, issued Mar. 9, 1965; Dresner, "Double Injection Electroluminescence in Anthracene", RCA Review, 30, 322, (1969); and Dresner U.S. Pat. No. 3,710,167, issued Jan. 9, 1973. The organic layers in these devices, usually composed of a polycyclic aromatic hydrocarbon, were very thick (much greater than 1 μm). Consequently, operating voltages were very high, often >100V.

More recent organic EL devices include an organic EL element consisting of extremely thin layers (e.g. <1.0 μm) between the anode and the cathode. Herein, the term "organic EL element" encompasses the layers between the anode and cathode. Reducing the thickness lowered the resistance of the organic layers and has enabled devices that operate at much lower voltage. In a basic two-layer EL device structure, described first in US 4,356,429, one organic layer of the EL element adjacent to the anode is specifically chosen to transport holes, and therefore is referred to as the hole transporting layer, and the other organic layer is specifically chosen to transport electrons and is referred to as the electron transporting layer. Recombination of the injected holes and electrons within the organic EL element results in efficient electroluminescence.

There have also been proposed three-layer organic EL devices that contain an organic light emitting layer (LEL) between the hole transporting layer and electron transporting layer, such as that disclosed by C. Tang et al. (J. Applied Physics, Vol. 65, 3610 (1989)). The light emitting layer commonly consists of a host material doped with a guest material, otherwise known as a dopant. Still further, there has been proposed in US 4,769,292 a four-layer EL element comprising a hole injecting layer (HIL), a hole transporting layer (HTL), a light emitting layer (LEL) and an electron transporting/injecting layer (ETL). These structures have resulted in improved device efficiency.

Many emitting materials that have been described as useful in an OLED device emit light from their excited singlet state by fluorescence. The excited singlet state can be created when excitons formed in an OLED device transfer their energy to the singlet excited state of the emitter. However, only 25% of the excitons created in an EL device are singlet excitons. The remaining excitons are triplet, which cannot readily transfer their energy to the emitter to produce the singlet excited state of a emitter. This results in a large loss in efficiency since 75% of the excitons are not used in the light emission process.

Triplet excitons can transfer their energy to a emitter if it has a triplet excited state that is low enough in energy. If the triplet state of the emitter is emissive it can produce light by phosphorescence. In many cases, singlet excitons can also transfer their energy to the lowest singlet excited state of the same emitter. The singlet excited state can often relax, by an intersystem crossing process, to the emissive triplet excited state. Thus, it is possible, by the proper choice of host and emitter, to collect energy from both the singlet and triplet excitons created in an OLED device and to produce a very efficient phosphorescent emission. The term electrophosphorescence is sometimes used to denote electroluminescence wherein the mechanism of luminescence is phosphorescence.

Another process by which excited states of a emitter can be created is a sequential process in which a hole is trapped by the emitter and subsequently recombines with an electron, or an electron is trapped and subsequently recombines with a hole, in either case producing an excited state of the emitter directly. Singlet and triplet states, and fluorescence, phosphorescence, and intersystem crossing are discussed in J. G. Calvert and J. N. Pitts, Jr., Photochemistry (Wiley, New York, 1966) and further discussed in publications by S. R. Forrest and coworkers such as M. A. Baldo, D. F. O'Brien, M. E. Thompson, and S. R. Forrest, Phys. Rev. B, 60, 14422 (1999) and M. A. Baldo, S. R. Forrest, Phys. Rev. B, 62, 10956 (2000).

Emission from triplet states is generally very weak for most organic compounds because the transition from the triplet excited state to the singlet ground state is spin-forbidden. However, it is possible for compounds with states possessing a strong spin-orbit coupling interaction to emit strongly from triplet excited states to the singlet ground state

(phosphorescence). For example, *fac*-tris(2-phenyl-pyridinato-N,$C^{2'}$-)Iridium(III) ($Ir(ppy)_3$) emits green light (K.A. King, P.J. Spellane, and R.J. Watts, J. Am. Chem. Soc., 107, 1431 (1985); M.G. Colombo, T.C. Brunold, T. Reidener, H.U. Güdel, M. Fortsch, and H.-B. Bürgi, Inorg. Chem., 33, 545 (1994)). Additional disclosures of phosphorescent materials and organic electroluminescent devices employing these materials are found in US 6,303238 B1, WO 2000/57676, WO 2000/70655, WO 2001/41512 A1, WO 2002/02714 A2, WO 2003/040256 A2, and WO 2004/016711 A1.

OLEDs employing phosphorescent emitters are capable in principle of achieving 100% internal quantum efficiency because they are capable of harvesting all of the excitons (both electron spin singlets and triplets) produced by injection of electrical charge into the device as light emission. On the other hand, OLEDs employing fluorescent emitters are generally capable achieving only up to 25% internal quantum efficiency because they are capable of harvesting only the singlet excitons. Unfortunately, OLEDs utilizing blue phosphorescent emitters have been deficient in operational stability and therefore not suitable for most practical uses. Therefore, OLEDs combining especially blue fluorescent emitters with longer wavelength phosphorescent emitters have been sought as a practical alternative to achieving high efficiencies in white light producing devices. Many of the proposed device structures appear to simply divide the electron and hole recombination events resulting from electrical charge injection among emissive layers comprising the fluorescent emitters and emissive layers comprising phosphorescent emitters. The potential efficiencies of these devices are limited because the triplet states formed by recombination within the fluorescent emissive layer would not be harvested as useful light. Furthermore, it would be difficult to attain desirable CIE coordinates and CRI values together with high efficiencies because the longer wavelengths from the highly efficient phosphorescent emitters would dominate the blue emission from the fluorescent emitter.

Recently, Y. Sun et al (Nature, 440, 908-912 (2006)) have proposed that hybrid fluorescent/phosphorescent white OLEDs could potentially convert all of the electron-hole recombination into light emission if the triplet states formed in the fluorescent emissive layer could diffuse to a layer comprising the phosphorescent emitter(s) where they could be captured and emit light. Sun *et al* employed a blue fluorescent emitter in a host material. However, the triplet energy level of the blue fluorescent emitter in Sun *et al* was well below that of the host material used for the phosphorescent emitter. Therefore, it is possible that a significant amount of the triplet excitons could become trapped on the fluorescent emitter where they would decay non-radiatively.

Pfeiffer et al (WO2006097064) attempt to achieve high efficiency with devices that comprise fluorescent blue emitters that have triplet energies greater than that of the phosphorescent emitter(s) in order that transfer of triplet excitons from the fluorescent emitter to the phosphorescent emitter will be energetically favorable. According to this reference, the triplet energy of the fluorescent emitter should be substantially less than the triplet energy of the phosphorescent host material, so that the diffusion of triplets into the phosphorescent layer will not easily be able to diffuse further than the phosphorescent emitters at the interface between the two layers. This is because these emitters are dilute with respect to the host and the diffusion of triplet excitons requires close contact of molecules for molecule to molecule transfer (often referred to as Dexter transfer, see A. Lamola and N. Turro, 'Energy Transfer and Organic Photochemistry', Technique of Organic Chemistry, Vol. XIV, Interscience Publishers, 1969). In Pfeiffer *et al,* the fluorescent emitters disclosed were single component materials.

Y.J. Tung et al, US App 2006/0232194 A1 discloses white OLED devices with a fluorescent blue emitting material as a emitter in a host material and a second emissive layer comprising a phosphorescent emitting material as a emitter in a host material. There may be a spacer layer between the two emissive layers.

Nagara et al, US App 2006/0125380 A1 describes organic EL devices with a fluorescent light emitting layer nearer to the cathode, a non-light emitting interface layer and a phosphorescent light emitting layer.

JP 2007/027620 discloses an hybrid organic light emitting device comprising a fluorescent layer/ a spacer/ a phosphorescent layer.

However, all these disclosures show limited efficiency of blue light output, which limits the overall efficiency of white devices since the green and red components of the white emission must be balanced with the blue component in order to achieve desirable CIE coordinates and CRI.

OLEDs producing a white emission are of interest for solid-state lighting applications, backlights for LCDs, and OLED displays incorporating color filters.

Notwithstanding all these developments, there remains a need to further improve efficiency of OLED devices.

## SUMMARY OF THE INVENTION

A first embodiment of the invention provides an OLED device comprising:

a) a fluorescent light emitting layer comprising at least one blue fluorescent emitter and a host material;
b) a phosphorescent light emitting layer comprising at least one emitter and one host material; and
c) a spacer layer interposed between the fluorescent LEL and the phosphorescent LEL;

wherein the triplet energy of the fluorescent emitter is not more than 0.2 eV below the triplet energy of the spacer material, and of the phosphorescent host material, and wherein the triplet energy of the spacer material is not more than 0.2 eV below that of the phosphorescent host material.

A second embodiment of the invention provides an OLED device comprising:

a) a fluorescent light emitting layer comprising at least one blue fluorescent emitter and one host material;
b) a phosphorescent light emitting layer comprising at least one phosphorescent emitter and one host material;
c) a spacer layer interposed between the fluorescent LEL and the phosphorescent LEL

wherein the triplet energy of the fluorescent host is not more than 0.2 eV greater than that of the fluorescent emitter, and not more than 0.2 eV below the triplet energy of the spacer material, and not more than 0.2 eV below the triplet energy of the phosphorescent host, and wherein the triplet energy of the spacer material is not more than 0.2 eV below that of the phosphorescent host material.

Additional embodiments include where the hybrid light emitting units of the invention include an additional light emitting unit to form a stacked OLED device.

The devices of the invention exhibit improved efficiency and reduced drive voltage.

## BRIEF DESCRIPTION OF THE DRAWINGS

FIG. 1 shows a schematic cross-section of one embodiment of an OLED device (corresponding to experimental device 1-5) in which this invention is used.

FIG. 2 shows a schematic cross-section of another embodiment of an OLED device (corresponding to experimental device 5-1) in which this invention is used.

It will be understood that FIGS.1-2 are not to scale since the individual layers are too thin and the thickness differences of various layers are too great to permit depiction to scale.

FIG. 3 shows a comparison between the EL spectra of a 2-stack hybrid OLED device (experimental device 6-1) with a blue-red unit and green phosphorescent unit and corresponding devices having only blue-red (6-2) and blue (6-3) units.

## DETAILED DESCRIPTION OF THE INVENTION

The electroluminescent device is summarized above. The device can also include a hole injecting layer, a hole transporting layer, a hole blocking layer, an electron transporting layer, or more than one of these optional layers.

In the following discussion, it should be understood that a fluorescent emissive layer refers to any light emitting layer which contains a material that emits light via a singlet excited state, a phosphorescent emissive layer refers to any light emitting layer which contains a material that emits light via a triplet excited state, a hybrid OLED device is one that contains at least one fluorescent emissive layer and at least one phosphorescent emissive layer, and a stacked (also referred to as tandem or cascaded) OLED device is one in which there are at least two separate light emitting regions in a vertical direction, separated by an electrically conductive, but non-light emitting region.

To produce a white emitting device, ideally the hybrid fluorescent/phosphorescent device would comprise a blue fluorescent emitter and proper proportions of a green and red phosphorescent emitter, or other color combinations suitable to make white emission. However, hybrid devices having non-white emission may also be useful by themselves. Hybrid fluorescent/phosphorescent elements having non-white emission may also be combined with additional phosphorescent elements in series in a stacked OLED. For example, white emission may be produced by one or more hybrid blue fluorescent/red phosphorescent elements stacked in series with a green phosphorescent element using p/n junction connectors as disclosed in Tang et al US6936961 B2.

The present invention overcomes the limitations of known devices by providing hybrid fluorescent/phosphorescent OLED devices that produce a fluorescent emission component with high efficiency while simultaneously allowing energetically more favored diffusion of triplet excitons from a singlet emissive region to the phosphorescent emissive regions. In the most desirable embodiments, the fluorescent layer emits blue light while the phosphorescent layer emits either red or green light. In examples where there are more than one phosphorescent layer present, both may emit green light, both may emit red light or one can emit green light and the other red light.

For most efficient transfer of triplet excitons, the present invention further requires that the triplet energy of the fluorescent emitter be not more than 0.2 eV below the triplet energy of the host for the phosphorescent emitter. For example, if the triplet energy of the host for the phosphorescent emitter is 2.2 eV, the triplet energy of the fluorescent

emitter must be 2.0 eV or greater. It is possible for thermal equilibrium to allow significant transfer of triplets from the fluorescent emitter to the phosphorescent host if the triplet energy of the fluorescent emitter is up to 0.2 eV below that of the phosphorescent host. It is preferred that the triplet energy of the fluorescent emitter is not more than 0.1 eV below the triplet energy of the spacer material and of the phosphorescent host material and the triplet energy of the spacer material is not more than 0.1 eV below that of the phosphorescent host material. The most preferred embodiments of the present invention have the triplet energy of the fluorescent emitter greater than or equal to that of the phosphorescent host.

Similarly, according to the present invention the triplet energy of the fluorescent emitter must not be more than 0.2 eV below that of any spacer material disposed between the fluorescent emissive layer and the phosphorescent emissive layer. Such a spacer is necessary in order that singlet excitons on the fluorescent emitter are emitted as light rather than be transferred to the phosphorescent emitter. The mechanism of transfer of singlet excitons does not require molecular contact but involves a thru-space coupling known as Förster transfer (see J. Birks, "Photophysics of Aromatic Molecules", Wiley-Interscience, 1970), the magnitude of which depends inversely on distance to the sixth power. Thus, the spacer material properties and thickness need to be chosen so as to allow Dexter transfer of triplet excitons from the fluorescent emitter to the phosphorescent layer but allow only a small amount of Förster transfer of singlet excitons. This is especially important in hybrid devices where it is necessary to maximize the amount of blue light produced by fluorescence in order to achieve balanced white emission while achieving high overall efficiency.

Another important property of the spacer and host materials is that phosphorescent lifetimes be long (i.e. non-radiative decay rates should be small) in order that the triplet exciton diffusion lengths are long. For example, the triplet exciton diffusion length in $Alq_3$ was estimated to be (14 +/- 9) nm (140 +/- 90) Å) in Baldo et al, Phys. Rev. B, 62, 10958-10966 (2000). Clearly, in order to construct the most efficient hybrid fluorescent/phosphorescent devices with high blue component for desirable CIE coordinates and CRI values, the host and spacer materials, especially the fluorescent host and spacer materials, should be selected to have triplet exciton diffusion lengths that are long in comparison with the Förster transfer radius for the fluorescent emitter to other materials, including the phosphorescent emitter.

In other embodiments of the present invention, a host material doped with a fluorescent emitter are employed in order to reach higher luminous efficiencies but with the added criterion that the triplet energy of the fluorescent host is not more than 0.2 eV greater than that of the fluorescent emitter, is not more than 0.2 eV below that of a spacer material, and not more than 0.2 eV below that of the phosphorescent host material, with the proviso that the triplet energy of the spacer material is not more than 0.2 eV below that of the phosphorescent host material. In preferred embodiments, the triplet energy of the fluorescent host is not more than 0.1 eV above, or even more desirably, equal to or less than that of the fluorescent emitter; is not more than 0.1 eV below, or even more desirably, equal to or greater than that of a spacer material; is not more than 0.1 eV below, or even more desirably, about equal to or greater than that of the phosphorescent host material, with the proviso that the triplet energy of the spacer material is not more than 0.1 eV below, or more desirably, equal to or greater than that of the phosphorescent host material.

For many applications, such as white OLEDs, in order to achieve desirable CIE coordinates and CRI values while achieving maximum efficiency, it is necessary to maximize the efficiency of blue emission provided by a fluorescent emitter in order to have enough blue component in the overall device emission when the longer wavelength components are provided by efficient phosphorescent emissive layers. In addition to preferably employing a fluorescent emitter in combination with a host, it is desirable to select and arrange the various materials and layers in a device in order to have all or nearly all of the electron and hole recombination occur in proximity to the blue fluorescent emitter so that all or nearly all of the singlet excitons are converted into blue light emission. One way to achieve this is to arrange layers and materials such that recombination occurs near the interface of the blue fluorescent layer with a spacer layer interposed between the fluorescent layer and the phosphorescent layer, or near the interface of the fluorescent layer and adjacent charge transporting layer. Host and spacer materials can be dominantly electron transporting or dominantly hole transporting. Recombination will generally occur at or near an interface of a material that is dominantly hole transporting with a material that is dominantly electron transporting, especially if the LUMO of the hole transporting material is at least about 0.2 eV above that of the electron transporting material, and the HOMO of the electron transporting material is at least about 0.2 eV below that of the hole transporting material so as to present energy barriers to the charge carriers crossing the interface independent of recombination.

There are thus several arrangements then of host and spacer materials that would lead to recombination occurring dominantly at or near one of the interfaces of the fluorescent emissive layer:

(a) In a preferred arrangement, the fluorescent emissive layer host, the spacer layer material, and the phosphorescent emissive layer host are each electron-transporting and the fluorescent emissive layer contacts a hole transport material on the anode side while the spacer material and phosphorescent emissive layer are deposited on the cathode side of the fluorescent emissive layer.

(b) In another embodiment, the fluorescent emissive layer host, the spacer layer material, and the phosphorescent emissive layer host are each hole transporting and the fluorescent emissive layer contacts an electron transport

material on the cathode side while the spacer layer and phosphorescent emissive layer are deposited on the anode side of the fluorescent emissive layer.

(c) In another embodiment, the fluorescent emissive layer host is electron transporting while the spacer layer material and the phosphorescent emissive layer host are each hole transporting and deposited on the anode side of the fluorescent emissive layer.

(d) In another embodiment, the fluorescent emissive layer host is hole transporting while the spacer layer material and the phosphorescent emissive layer host are each electron transporting and deposited on the cathode side of the fluorescent emissive layer.

Further extensions of these arrangements are contemplated in which there is a phosphorescent emissive layer and spacer layer on each side of the fluorescent emissive layer in a phosphorescent layer, spacer layer, fluorescent layer, spacer layer, phosphorescent layer arrangement. It is preferred that these layers be in direct contact or sequence with each other without any intermediate layers in between them. It would also be preferred that the fluorescent emissive layer emits primarily blue light while the phosphorescent emissive layers emits primarily red light. Alternatively, the phosphorescent layer could emit primarily green and red light.

Another embodiment would be as in (c) above but having a second phosphorescent emissive layer and spacer layer deposited on the cathode side of the fluorescent emissive layer. In this embodiment, the second phosphorescent layer host material and second spacer material would be electron transporting. Another embodiment would be as in (d) above but having a second phosphorescent emissive layer and spacer layer deposited on the anode side of the fluorescent emissive layer. In this embodiment, the second phosphorescent layer host material and second spacer material would be hole transporting.

It is further contemplated that the phosphorescent emissive layers in the present invention may comprise more than one emitter in order to achieve desired CIE coordinates and CRI values. The phosphorescent emitters may be co-doped in the same region of the emissive layer, or may be separated into different sublayers. The phosphorescent emissive layers may also comprise more than one host. If more than one phosphorescent host material is used, these may be mixed in the same region or separated into different sublayers. For instance, there could be a sublayer comprising a green phosphorescent emitter in one host, followed by a sublayer comprising a red phosphorescent emitter in a second host. In the case where a second phosphorescent host has a lower triplet energy than the first phosphorescent host, it is preferred that the layer having the higher triplet energy host be placed closest to the spacer layer and the fluorescent emissive layer.

In order that the triplet excitons diffuse from the fluorescent emissive layer toward only the spacer and phosphorescent emissive layer, further preferred embodiments of the invention require that any hole or electron transporting material that is in contact with the fluorescent emissive layer on the opposite side of the said fluorescent emissive layer from the spacer layer and phosphorescent layer should have a triplet energy at least 0.2 eV above that of the fluorescent host material. It is further desirable to limit diffusion of triplet excitons past the phosphorescent emissive layer(s) by requiring that any hole or electron transport materials deposited on the side of the phosphorescent emissive layer host opposite from the spacer layer have a triplet energy at least 0.2 eV above that of said phosphorescent emissive layer host.

In order to maximize the blue fluorescent component of the emission, there are further preferred embodiments in which a first hole transporting material is deposited on the anode, followed by a second hole transporting material, followed by a fluorescent emissive layer having electron transporting properties, wherein the second hole transport material has a HOMO (Highest Occupied Molecular Orbital) at least 0.2 eV below that of the first hole transporting material while its LUMO (Lowest Unoccupied Molecular Orbital) is above that of the electron transporting fluorescent emissive layer host. It is preferred that said second hole transport material be disposed between the first hole transport material and the blue fluorescent emissive layer with electron transporting host, but in other embodiments the second hole transport material layer having the lower HOMO level may be placed before the first hole transport material or anywhere within the first hole transport material. In still further embodiments, there may be more than two hole transport material layers and/or there may be hole injection material layers present.

## Triplet Energy

Triplet energy can be measured by any of several means, as discussed for instance in S. L. Murov, I. Carmichael, and G. L. Hug, Handbook of Photochemistry, 2nd ed. (Marcel Dekker, New York, 1993). However, direct measurement can often be difficult to accomplish.

For simplicity and convenience, the triplet state of a compound should be calculated for this invention even though the calculated values for the triplet state energy of a given compound may typically show some deviation from the experimental values. If calculated triplet energy values are unavailable, then experimentally determined values can be used. Because the triplet energies cannot be either calculated or measured accurately in some situations, differences of less than 0.05 should be considered equal for the purposes of this invention.

The calculated triplet state energy for a molelcule is derived from the difference between the ground state energy (E(gs)) of the molecule and the energy of the lowest triplet state (E(ts)) of the molecule, both given in eV. This difference is modified by empirically derived constants whose values were obtained by comparing the result of E(ts)-E (gs) to experimental triplet energies, so that the triplet state energy is given by equation 1:

$$E(t) = 0.84*(E(ts)-E(gs))+0.35 \qquad (eq.\ 1)$$

Values of E(gs) and E(ts) are obtained using the B3LYP method as implemented in the Gaussian 98 (Gaussian, Inc., Pittsburgh, PA) computer program. The basis set for use with the B3LYP method is defined as follows: MIDI! for all atoms for which MIDI! is defined, 6-31G* for all atoms defined in 6-31 G* but not in MIDI!, and either the LACV3P or the LANL2DZ basis set and pseudopotential for atoms not defined in MIDI! or 6-31 G*, with LACV3P being the preferred method. For any remaining atoms, any published basis set and pseudopotential may be used. MIDI!, 6-31 G* and LANL2DZ are used as implemented in the Gaussian98 computer code and LACV3P is used as implemented in the Jaguar 4.1 (Schrodinger, Inc., Portland Oregon) computer code. The energy of each state is computed at the minimum-energy geometry for that state

For polymeric or oligomeric materials, it is sufficient to compute the triplet energy over a monomer or oligomer of sufficient size so that additional units do not substantially change the computed triplet energy.

Fluorescent Light Emitting Layers **109**

One critical feature of the present invention is the selection of blue fluorescent host and emitter combinations suitable for energetically favored transfer of triplet excitons to a phosphorescent host and emitter. Most of the commonly used blue fluorescent emitters that give high quantum yields generally have triplet energies about 2 eV or less. However, some are higher. Preferred fluorescent emitters have a triplet energy of 2.0 eV or greater or most preferably 2.2 eV or greater. For example, the fluorescent emitter Emitter-1 (Difluoro[6-mesityl-*N*-(2(1*H*)-quinolinylidene-κ*N*)-(6-mesityl-2-quinolinaminato-κ*N*1)]boron) has a triplet energy of 2.29 eV by DFT calculation and is particularly preferred for this invention.

Although the term "fluorescent" is commonly used to describe any light emitting material, in this case, it is a material that emits light from a singlet excited state. Although in this invention, fluorescent materials may not be used in the same layer as the phosphorescent material, they may be used together in other (non-inventive) LELs, or in adjacent layers, in adjacent pixels, or any combination. Care must be taken not to select materials that will adversely affect the performance of the phosphorescent materials of this invention. One skilled in the art will understand that concentrations and triplet energies of materials in the same layer as the phosphorescent material or in an adjacent layer must be appropriately set so as to prevent unwanted quenching of the phosphorescence.

As more fully described in U.S. Patent Nos. 4,769,292 and 5,935,721, a light emitting layer (LEL) of the organic EL element includes a luminescent fluorescent or phosphorescent material where electroluminescence is produced as a result of electron-hole pair recombination. The light emitting layer can be comprised of a single material, but more commonly consists of a host material doped with a guest emitting material and can be of any color. The host materials in the light emitting layer can be an electron transporting material, as defined below, a hole transporting material, as defined below, or another material or combination of materials that support hole-electron recombination. Fluorescent emitting materials are typically incorporated at 0.01 to 10 % by weight of the host material.

The host and emitting materials can be small non-polymeric molecules or polymeric materials such as polyfluorenes and polyvinylarylenes (e.g., poly(p-phenylenevinylene), PPV). In the case of polymers, small-molecule emitting materials can be molecularly dispersed into a polymeric host, or the emitting materials can be added by copolymerizing a minor constituent into a host polymer. Host materials may be mixed together in order to improve film formation, electrical properties, light emission efficiency, operating lifetime, or manufacturability. The host may comprise a material that has good hole transporting properties and a material that has good electron transporting properties.

An important relationship for choosing a fluorescent material as a guest emitting material is a comparison of the lowest excited singlet-state energies of the host and the fluorescent material. It is highly desirable that the excited singlet-state energy of the fluorescent material be lower than that of the host material. The excited singlet-state energy is defined as the difference in energy between the emitting singlet state and the ground state.

Host and emitting materials known to be of use include, but are not limited to, those disclosed in US 4,768,292, US 5,141,671, US 5,150,006, US 5,151,629, US 5,405,709, US 5,484,922, US 5,593,788, US 5,645,948, US 5,683,823, US 5,755,999, US 5,928,802, US 5,935,720, US 5,935,721, and US 6,020,078.

Some fluorescent emitting materials include, but are not limited to, derivatives of anthracene, tetracene, xanthene, perylene, rubrene, coumarin, rhodamine, and quinacridone, dicyanomethylenepyran compounds, thiopyran compounds, polymethine compounds, pyrylium and thiapyrylium compounds, fluorene derivatives, fluoranthenes derivatives, periflanthene derivatives, indenoperylene derivatives, bis(azinyl)amine boron compounds, bis(azinyl)methane compounds, and carbostyryl compounds. Illustrative examples of useful materials include, but are not limited to, the following:

| | |
|---|---|
| 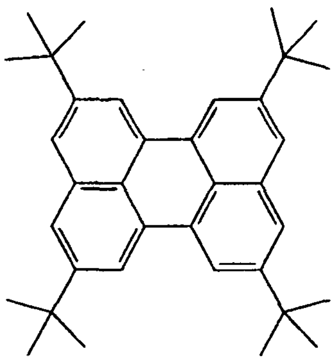 L2 | 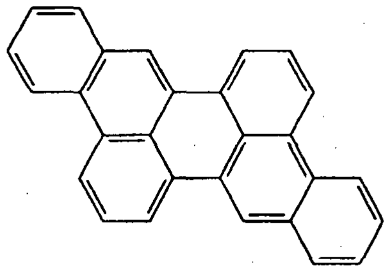 L4 |
| 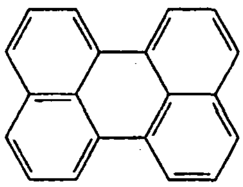 L1 | 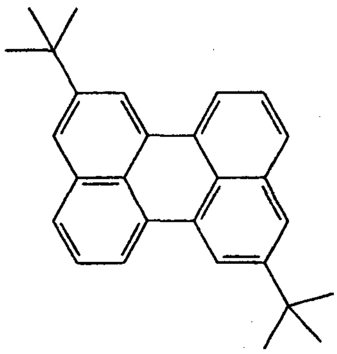 L3 |

(continued)

| | |
|---|---|
| 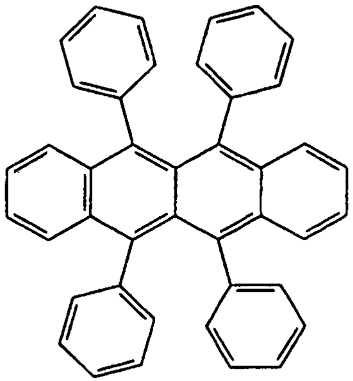<br>L5 | 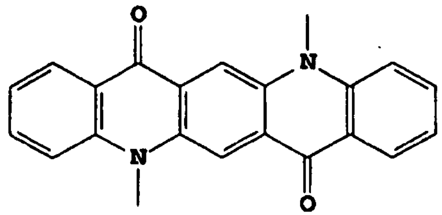<br>L6 |
| 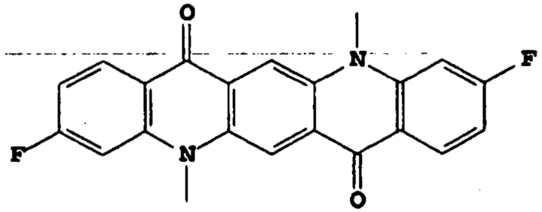<br>L7 | 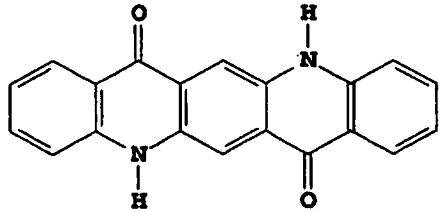<br>L8 |
| 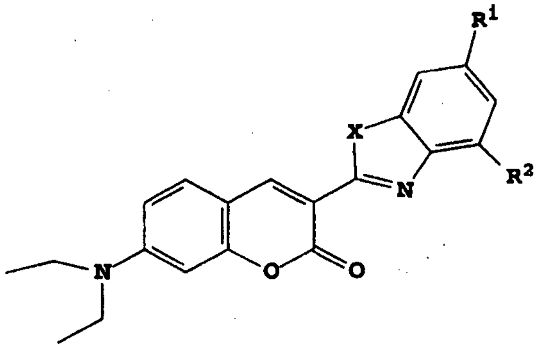 | 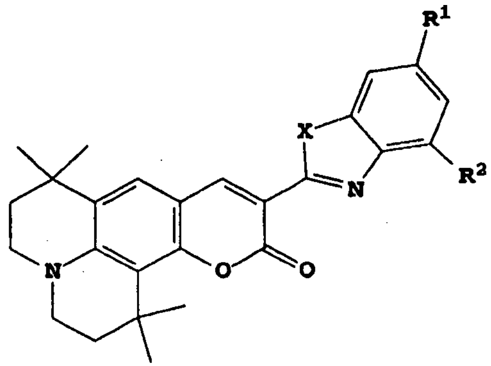 |

| | X | R1 | R2 |
|---|---|---|---|
| L9 | O | H | H |
| L10 | O | H | Methyl |

| | X | R1 | R2 |
|---|---|---|---|
| L23 | O | H | H |
| L24 | O | H | Methyl |

(continued)

| | | | | | | | |
|---|---|---|---|---|---|---|---|
| L11 | O | Methyl | H | L25 | O | Methyl | H |
| L12 | O | Methyl | Methyl | L26 | O | Methyl | Methyl |
| L13 | O | H | t-butyl | L27 | O | H | t-butyl |
| L14 | O | t-butyl | H | L28 | O | t-butyl | H |
| L15 | O | t-butyl | t-butyl | L29 | O | t-butyl | t-butyl |
| L16 | S | H | H | L30 | S | H | H |
| L17 | S | H | Methyl | L31 | S | H | Methyl |
| L18 | S | Methyl | H | L32 | S | Methyl | H |
| L19 | S | Methyl | Methyl | L33 | S | Methyl | Methyl |
| L20 | S | H | t-butyl | L34 | S | H | t-butyl |
| L21 | S | t-butyl | H | L35 | S | t-butyl | H |
| L22 | S | t-butyl | t-butyl | L36 | S | t-butyl | t-butyl |
| 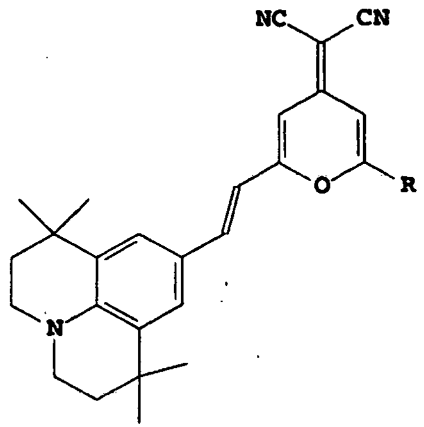 | | | | 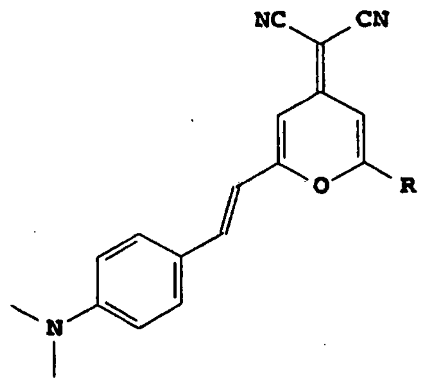 | | | |
| | R | | | | R | | |
| L37 | phenyl | | | L41 | phenyl | | |
| L38 | methyl | | | L42 | methyl | | |
| L39 | t-butyl | | | L43 | t-butyl | | |
| L40 | mesityl | | | L44 | mesityl | | |

(continued)

| | |
|---|---|
| 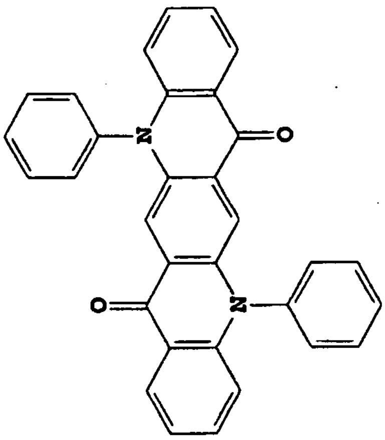 L45 | 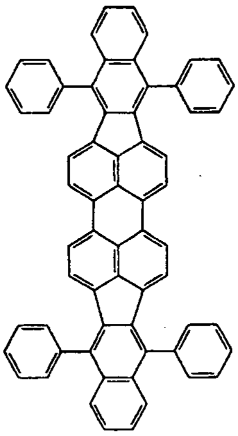 L46 |

(continued)

| | |
|---|---|
| 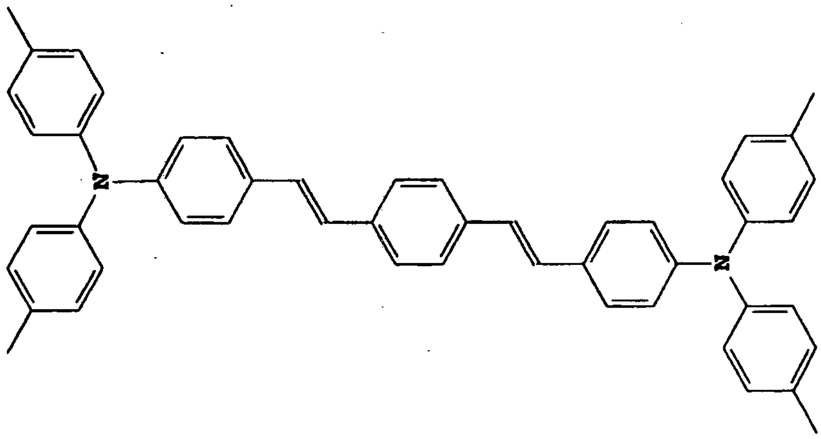 L47 | 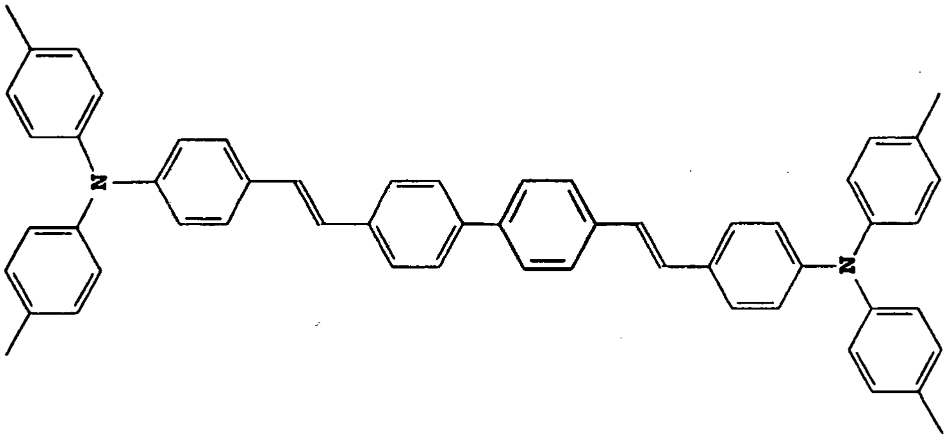 L48 |

(continued)

| | |
|---|---|
| 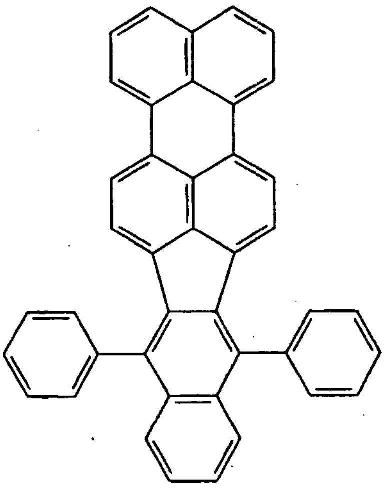 L49 | 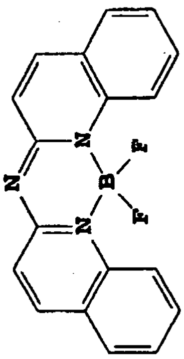 L50 |
| 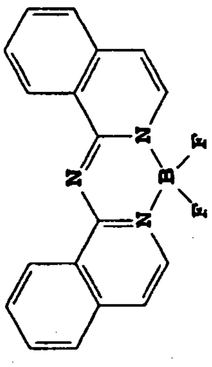 L51 | 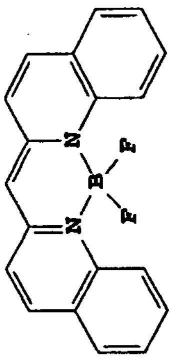 L52 |

Of these, the most preferred blue fluorescent emitters would have a triplet energy of at least 2.2 eV or greater. In particular, bis(azinyl)amine boron compounds and fluoranthene derivatives are very suitable for use as a blue emitter in this invention. Emitter-1 is particularly preferred.

The following table lists the energy levels of some representative structures of fluorescent emitters suitable for this invention. HOMO and LUMO energies were calculated as well known in the art. In this and all subsequent tables, energy levels (triplet energy, LUMO and HOMO) are expressed in units of eV.

**Energy Levels for Specific Fluorescent Emitters**

| Identifier | HOMO Energy | LUMO Energy | Triplet Energy | Structure |
|---|---|---|---|---|
| Emitter-1 | -5.69 | -2.77 | 2.29 | 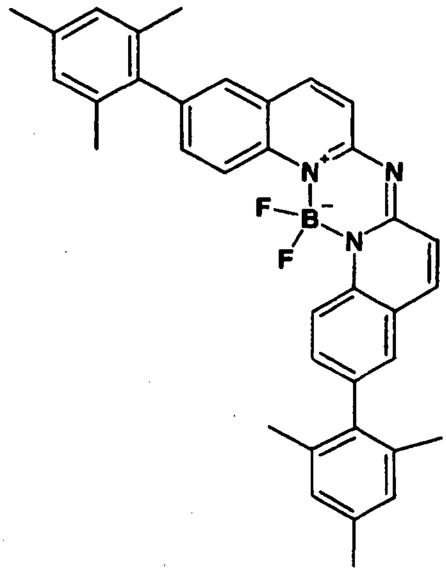 |
| Emitter-2 | -5.09 | -2.23 | 1.98 | 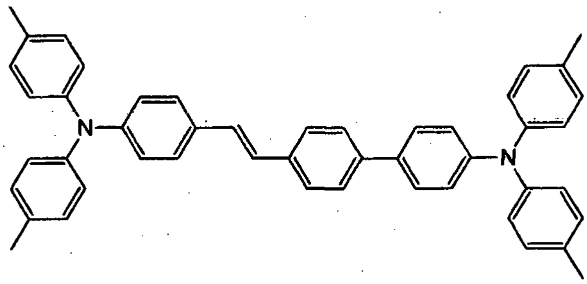 |
| Emitter-3 (L47) | -5.04 | -2.41 | 1.82 | 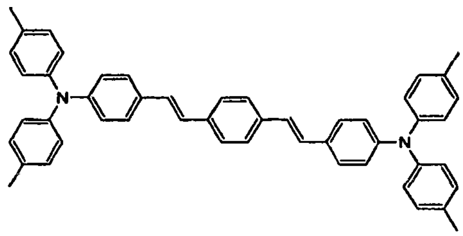 |
| Emitter-4 (BCZVBI) | -5.53 | -2.42 | 1.81 | 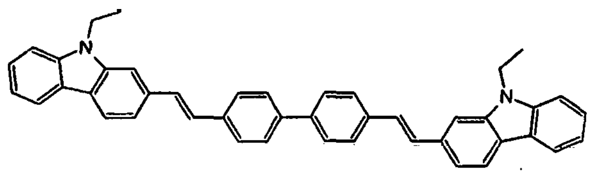 |

(continued)

| Identifier | HOMO Energy | LUMO Energy | Triplet Energy | Structure |
|---|---|---|---|---|
| Emitter-5 (BCZVB) | -5.24 | -2.30 | 2.08 | 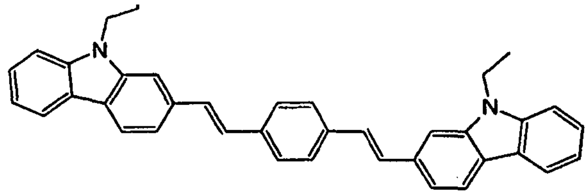 |
| Emitter-6 (TBP) (L2) | -5.24 | -2.54 | 1.67 | 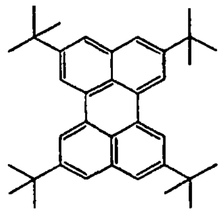 |
| Emitter-7 (DPVBI) | -5.17 | -2.28 | 1.92 | 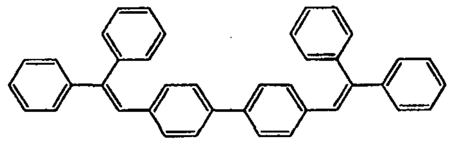 |
| Emitter-8 (L23) | -5.51 | -2.70 | 2.03 | 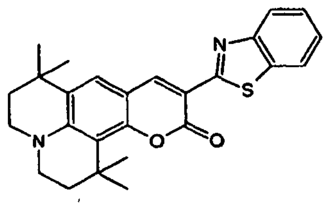 |
| Emitter-9 (L45) | -5.40 | -2.60 | 2.14 | 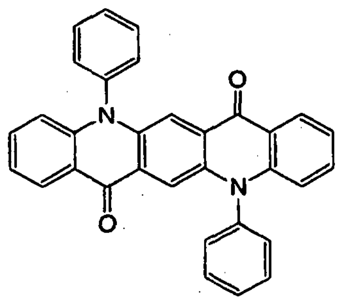 |
| Emitter-10 (L39) | -5.49 | -2.97 | 1.82 | 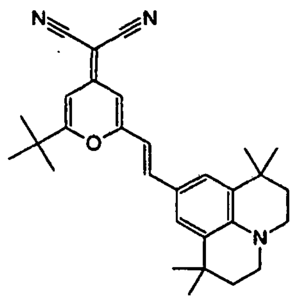 |

(continued)

| Identifier | HOMO Energy | LUMO Energy | Triplet Energy | Structure |
|---|---|---|---|---|
| Emitter-11 (L46) | -5.23 | -3.09 | 1.41 | 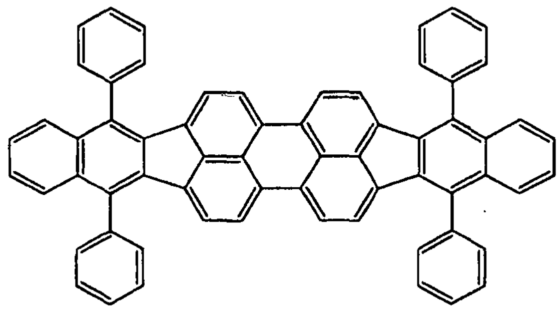 |
| Emitter-12 | -5.41 | -2.60 | 1.90 | 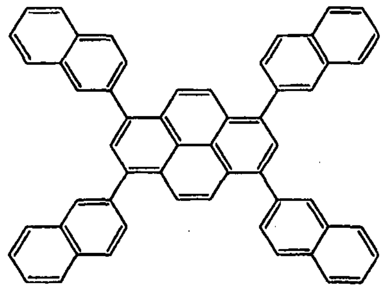 |
| Emitter-13 (perylene) (L1) | -5.38 (-5.38) | -2.69 (-2.64) | 1.67 | 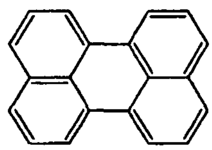 |

It should be noted that some materials can be used either as an emissive material or dopant, but in other formats, used as a host for another emitter. Whether a certain material behaves as either a host or an emitter depends on what other materials may be present in the same or adjacent layers. For example, many anthracene derivatives give fluorescent emission when used alone or in combination with certain types of host materials in a LEL, yet the same material can be a non-emissive host if used with the proper kind of emitter.

Metal complexes of 8-hydroxyquinoline and similar derivatives, also known as metal-chelated oxinoid compounds (formula (MCOH-a), constitute one class of useful host compounds capable of supporting electroluminescence, and are particularly suitable for light emission of wavelengths longer than 500 nm, e.g., green, yellow, orange, and red.

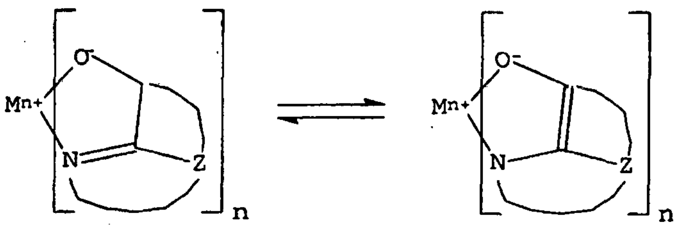

(MCOH-a)

wherein

- M represents a metal;
- n is an integer of from 1 to 4; and
- Z independently in each occurrence represents the atoms completing a nucleus having at least two fused aromatic rings.

From the foregoing it is apparent that the metal can be monovalent, divalent, trivalent, or tetravalent metal. The metal can, for example, be an alkali metal, such as lithium, sodium, or potassium; an alkaline earth metal, such as

magnesium or calcium; a trivalent metal, such aluminum or gallium, or another metal such as zinc or zirconium. Generally any monovalent, divalent, trivalent, or tetravalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is usually maintained at 18 or less.

Illustrative of useful chelated oxinoid compounds are the following:

MCOH-1: Aluminum trisoxine [alias, tris(8-quinolinolato)aluminum(III)]
MCOH-2: Magnesium bisoxine [alias, bis(8-quinolinolato)magnesium(II)]
MCOH-3: Bis[benzo{f}-8-quinolinolato]zinc (II)
MCOH-4: Bis(2-methyl-8-quinolinolato)aluminum(III)-μ-oxo-bis(2-methyl-8-quinolinolato) aluminum(III)
MCOH-5: Indium trisoxine [alias, tris(8-quinolinolato)indium]
MCOH-6: Aluminum tris(5-methyloxine) [alias, tris(5-methyl-8-quinolinolato) aluminum(III)
MCOH-7: Lithium oxine [alias, (8-quinolinolato)lithium(I)]
MCOH-8: Gallium oxine [alias, tris(8-quinolinolato)gallium(III)]
MCOH-9: Zirconium oxine [alias, tetra(8-quinolinolato)zirconium(IV)]

The family of compounds known as the blue aluminum chelates (for example, compounds of formula (MCOH-b) below) as described in US Patent 5,141,671 have triplet energies that are within about 0.2 eV above that of Emitter-1. This combination of emitter and host are particularly advantaged for this invention.

Particularly useful aluminum or gallium complex host materials are represented by Formula (MCOH-b).

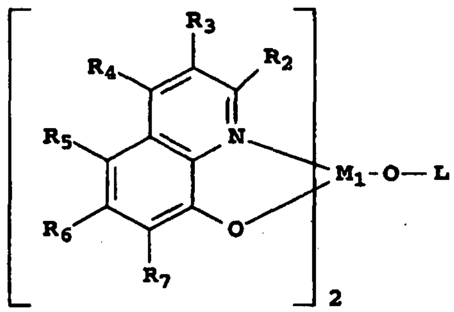

(MCOH-b)

In Formula (MCOH-b), $M_1$ represents Al or Ga. $R_2$ - $R_7$ represent hydrogen or an independently selected substituent. Desirably, $R_2$ represents an electron-donating group, such as a methyl group. Suitably, $R_3$ and $R_4$ each independently represent hydrogen or an electron donating substituent. Preferably, $R_5$, $R_6$, and $R_7$ each independently represent hydrogen or an electron-accepting group. Adjacent substituents, $R_2$ - $R_7$, may combine to form a ring group. L is an aromatic moiety linked to the aluminum by oxygen, which may be substituted with substituent groups such that L has from 6 to 30 carbon atoms. Besides, Host-1, Host-2 and Host-4 (Balq), other illustrative examples of Formula (MCOH-b) materials are listed below.

| | |
|---|---|
| MCOH-10 | 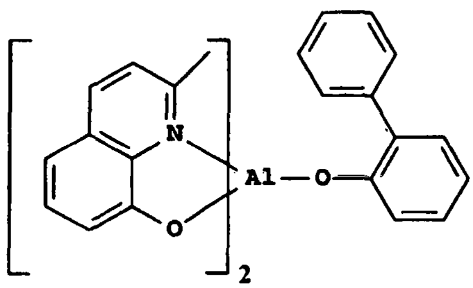 |

(continued)

| | |
|---|---|
| MCOH-11 | 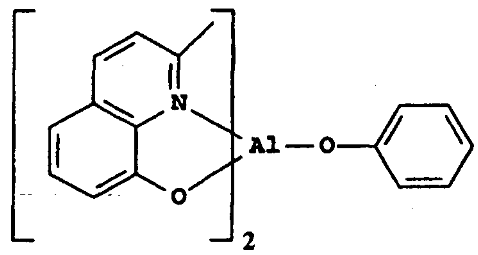 |
| MCOH-12 | 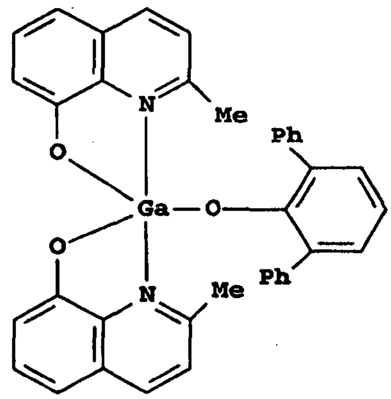 |
| MCOH-13 | 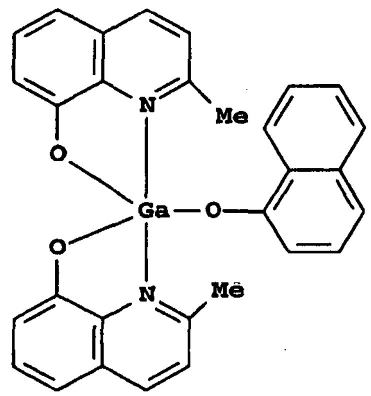 |

Derivatives of 9,10-di-(2-naphthyl)anthracene (formula (DNAH)) constitute one class of potential host materials capable of supporting fluorescent electroluminescence, and are particularly suitable for light emission of wavelengths longer than 400 nm, e.g., blue, green, yellow, orange or red. However, most examples of this class of materials have triplet energies below 2.0 eV which would be incompatible with many typical red phosphorescent emitters or blue fluorescent emitters according to this invention.

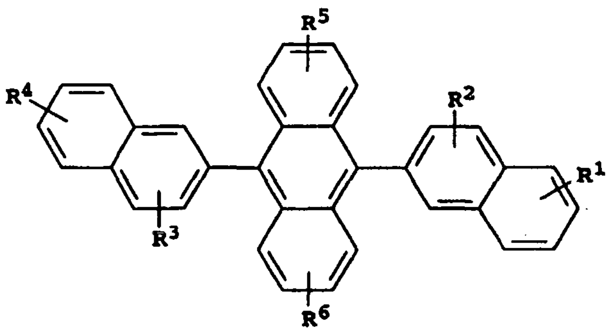 (DNAH)

wherein $R^1$, $R^2$, $R^3$, $R^4$, $R^5$, and $R^6$ represent one or more substituents on each ring where each substituent is individually selected from the following groups:

Group 1: hydrogen, or alkyl of from 1 to 24 carbon atoms;
Group 2: aryl or substituted aryl of from 5 to 20 carbon atoms;
Group 3: carbon atoms from 4 to 24 necessary to complete a fused aromatic ring of anthracenyl; pyrenyl, or perylenyl;
Group 4: heteroaryl or substituted heteroaryl of from 5 to 24 carbon atoms as necessary to complete a fused heteroaromatic ring of furyl, thienyl, pyridyl, quinolinyl or other heterocyclic systems;
Group 5: alkoxylamino, alkylamino, or arylamino of from 1 to 24 carbon atoms; and
Group 6: fluorine, chlorine, bromine or cyano.

Illustrative examples include 9,10-di-(2-naphthyl)anthracene, 2-*t*-butyl-9,10-di-(2-naphthyl)anthracene (Host-5), 9-(1-naphthyl)-10-(2-napthhyl)anthracene and 2-phenyl-9,10-di-(2-napthyl)anthracene. Other anthracene derivatives can be useful as a host in the LEL, including derivatives of 9,10-bis[4-(2,2-diphenylethenyl)phenyl]anthracene.

Benzazole derivatives (formula (BAH)) constitute another class of useful host materials capable of supporting fluorescent electroluminescence, and are particularly suitable for light emission of wavelengths longer than 400 nm, e.g., blue, green, yellow, orange or red:

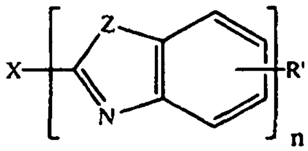

(BAH)

where:

n is an integer of 3 to 8;
Z is O, NR or S; and
R and R' are individually hydrogen; alkyl of from 1 to 24 carbon atoms, for example, propyl, t-butyl, heptyl, and the like; aryl or hetero-atom substituted aryl of from 5 to 20 carbon atoms for example phenyl and naphthyl, furyl, thienyl, pyridyl, quinolinyl and other heterocyclic systems; or halo such as chloro, fluoro; or atoms necessary to complete a fused aromatic ring; and

X is a linkage unit consisting of carbon, alkyl, aryl, substituted alkyl, or substituted aryl, which connects the multiple benzazoles together. X may be either conjugated with the multiple benzazoles or not in conjugation with them. An example of a useful benzazole is 2,2',2"-(1,3,5-phenylene)tris[1-phenyl-1H-benzimidazole] (TPBI).

Styrylarylene derivatives as described in U.S. Patent 5,121,029 and JP 08333569 are also hosts for blue emission. For example, 9,10-bis[4-(2,2-diphenylethenyl)phenyl]anthracene and 4,4'-bis(2,2-diphenylethenyl)-1,1'-biphenyl, (DPVBi) could be hosts for blue emission. However, many examples of this class have triplet energies of less than 2.0 eV and may not be suitable for this invention.

Fluoranthene derivatives as described in WO2005026088, WO2005033051, US App 2006/141287, EP1719748, JP2003238516, JP2005320286, US App 2004/0076853, US6929871, US App 2005/02711899 and US App 2002/022151 are also useful hosts. These materials have a structure according to formula (FAH):

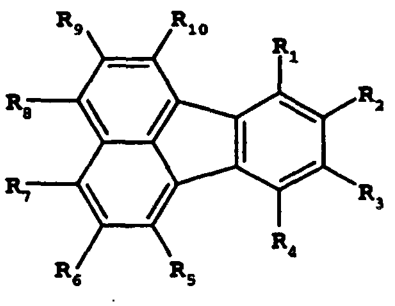

(FAH)

wherein $R_1$-$R_{10}$ represent one or more substituents on each ring where each substituent is individually selected from the following groups:

Group 1: hydrogen, or alkyl of from 1 to 24 carbon atoms;
Group 2: aryl or substituted aryl of from 5 to 20 carbon atoms;
Group 3: carbon atoms from 4 to 24 necessary to complete a fused or annulated aromatic ring such as benzene,

napthyl, anthracenyl; pyrenyl, or perylenyl;

Group 4: heteroaryl or substituted heteroaryl of from 5 to 24 carbon atoms as necessary to complete a fused heteroaromatic ring such as furyl, thienyl, pyridyl, quinolinyl or other heterocyclic systems;

Group 5: alkoxylamino, alkylamino, or arylamino of from 1 to 24 carbon atoms; and

Group 6: fluorine, chlorine, bromine or cyano.

Of these substituents, those of groups 1 and 2 are preferred. For Group 3, benzene and napthyl are preferred. A representative example of this class of materials is BPHFL (Host-3).

Yet another class of useful host materials are fluorene derivatives according to formula (SFH):

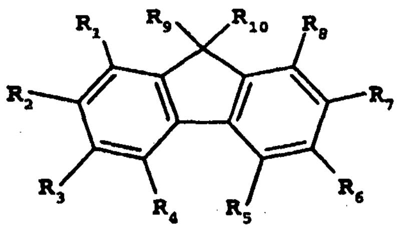

(SFH)

wherein $R_1$-$R_{10}$ represent one or more substituents on each ring where each substituent is individually selected from the following groups:

Group 1: hydrogen, or alkyl of from 1 to 24 carbon atoms;

Group 2: aryl or substituted aryl of from 5 to 20 carbon atoms;

Group 3: carbon atoms from 4 to 24 necessary to complete a fused or annulated aromatic ring such as benzene, napthyl, anthracenyl; pyrenyl, or perylenyl;

Group 4: heteroaryl or substituted heteroaryl of from 5 to 24 carbon atoms as necessary to complete a fused heteroaromatic ring such as furyl, thienyl, pyridyl, quinolinyl or other heterocyclic systems;

Group 5: alkoxylamino, alkylamino, or arylamino of from 1 to 24 carbon atoms; and

Group 6: fluorine, keto, chlorine, bromine or cyano.

Of these substituents, those of groups 1, 2, and 6 are preferred. Most preferred are where $R_9$ and $R_{10}$ are alkyl, phenyl or connected to make a spiroflourene derivative. Representative examples of this class of materials are Host-11, Host-17 and spirofluorenes such as those described in US2006183042.

The following table lists some representative structures of suitable hosts to be used in combination with a particular fluorescent blue-emitting emitter so long as the combination meets the triplet energy relationships of this invention. It should be noted that these same materials can also be used as hosts or co-hosts in combination with a phosphorescent emitter so long as the combination meets the triple energy relationships of this invention.

**Energy Levels of Hosts for Fluorescent Layers**

| Identifier | HOMO Energy | LUMO Energy | Triplet Energy | Structure |
|---|---|---|---|---|
| Host-1 | -5.54 | -2.41 | 2.25 | 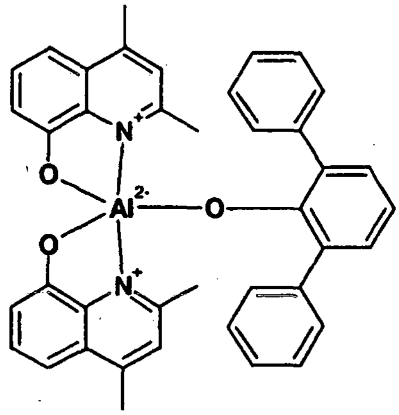 |
| Host-2 | -5.58 | -2.50 | 2.21 | 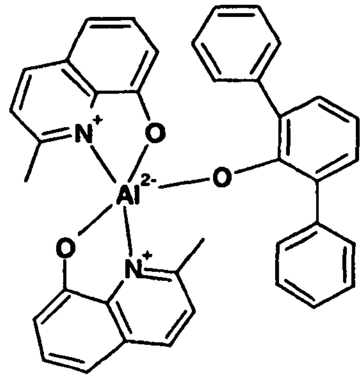 |
| Host-3 (BPHFL) | -5.74 | -2.57 | 2.29 | 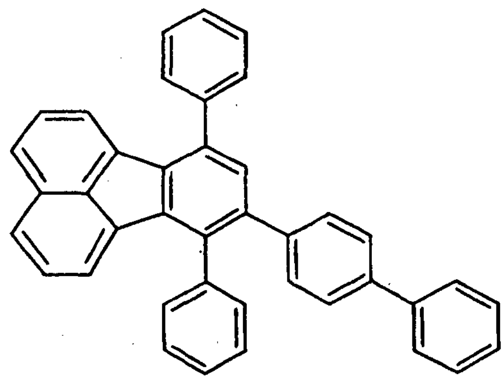 |
| Host-4 (Balq) | -5.50 | -2.53 | 2.25 | 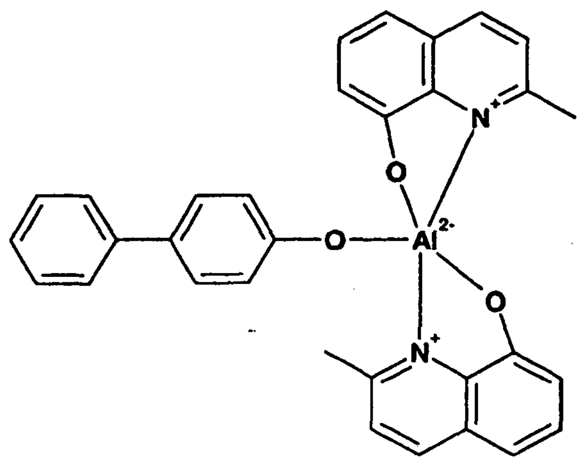 |

(continued)

| Identifier | HOMO Energy | LUMO Energy | Triplet Energy | Structure |
|---|---|---|---|---|
| Host-5 (TBADN) | -5.44 | -2.40 | 1.86 | 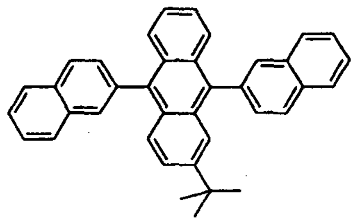 |
| Host-22 (DPVBI) | -5.53 | -2.42 | 1.81 | 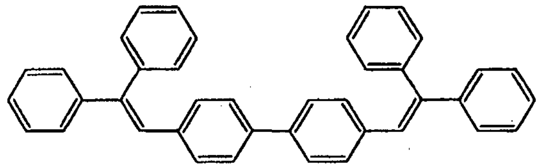 |

Spacer Layer **110**

As described above, the presence of a spacer layer located between the layer containing the fluorescent emitter and the layer containing the phosphorescent layer is crucial for the efficient utilization of both singlet and triplet excitons. The material used in the spacer layer should be selected on the basis of its triplet energy relative to the triplet energies of the materials chosen for the fluorescent and phosphorescent layers. In particular, the triplet energy of the fluorescent host is not more than 0.2 eV below the triplet energy of the spacer material and triplet energy of the spacer material is not more than 0.2 eV below that of the phosphorescent host material. More suitably, the triplet energy of the fluorescent host should be equal or greater to the triplet energy of the spacer material as well as equal or greater than the phosphorescent host material.

The spacer can be the fluorescent emissive material itself, as long as the region inside the fluorescence emitter layer where recombination and singlet emission actually occur is sufficiently far from the phosphorescent layer. However, the spacer layer does not ideally contain any emitters or emissive materials and the spacer layer will be some other suitably selected material meeting the criteria for the triplet energy in relation to the fluorescent emitter and phosphorescent host materials. The spacer layer may contain one or more materials. It is most desirable for the spacer material to be the same as the host for either the fluorescent or phosphorescent or even both. The spacer layer should be thin in thickness, ideally ranging from 1 nm to 10 nm, although thicker layers may be required in some applications.

Preferred classes of materials for the spacer layers are the same classes that are preferred for hosts in the light-emitting layers. Particularly useful classes include the metal-chelated oxinoid host compounds of formula (MCOH-b), the fluoranthene host compounds of formula (FAH) and the tetraaryldiamines of formula (TADA).

Phosphorescent Light Emitting Layers **111**

The light-emitting phosphorescent guest material(s) or emitter is typically present in an amount of from 1 to 20 by weight% of the light-emitting layer, and conveniently from 2 to 8 % by weight of the light-emitting layer. In some embodiments, the phosphorescent complex guest material(s) may be attached to one or more host materials. The host materials may further be polymers. For convenience, the phosphorescent complex guest material may be referred to herein as a phosphorescent material.

Particularly useful phosphorescent materials are described by Formula (PD) below.

| | |
|---|---|
| 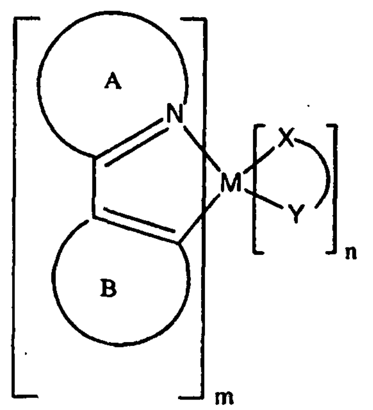 | (PD) |

wherein:

A is a substituted or unsubstituted heterocyclic ring containing at least one N atom;
B is a substituted or unsubstituted aromatic or heteroaromatic ring, or ring containing a vinyl carbon bonded to M;
X-Y is an anionic bidentate ligand;
m is an integer from 1 to 3; and
n in an integer from 0 to 2 such that m + n = 3 for M = Rh or Ir; or
m is an integer from 1 to 2 and n in an integer from 0 to 1 such that m + n = 2 for M = Pt or Pd.

Compounds according to Formula (PD) may be referred to as C,N-cyclometallated complexes to indicate that the central metal atom is contained in a cyclic unit formed by bonding the metal atom to carbon and nitrogen atoms of one or more ligands. Examples of heterocyclic ring A in Formula (PD) include substituted or unsubstituted pyridine, quinoline, isoquinoline, pyrimidine, indole, indazole, thiazole, and oxazole rings. Examples of ring B in Formula (PD) include substituted or unsubstituted phenyl, napthyl, thienyl, benzothienyl, furanyl rings. Ring B in Formula (PD) may also be a N-containing ring such as pyridine, with the proviso that the N-containing ring bonds to M through a C atom as shown in Formula (PD) and not the N atom.

An example of a tris-C,N-cyclometallated complex according to Formula (PD) with m = 3 and n = 0 is tris(2-phenyl-pyridinato-N,C2'-)Iridium(III), shown below in stereodiagrams as facial (*fac*-) or meridional (*mer*-) isomers.

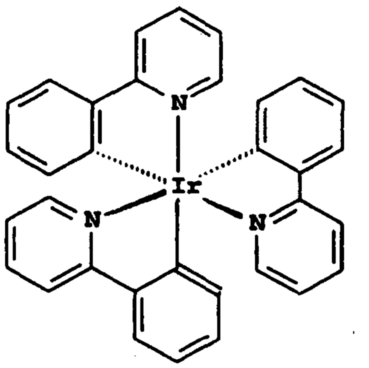

*Fac*

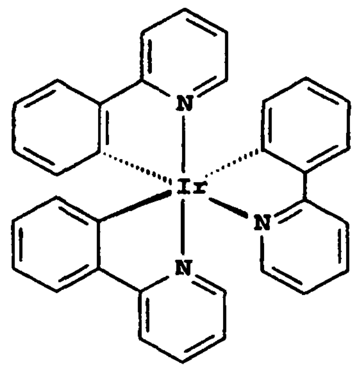

*Mer*

Generally, facial isomers are preferred since they are often found to have higher phosphorescent quantum yields than the meridional isomers. Additional examples of tris-C,N-cyclometallated phosphorescent materials according to Formula (PD) are tris(2-(4'-methylphenyl)pyridinato-N,C$^{2'}$)Iridium(III), tris(3-phenylisoquinolinato-N,C$^{2'}$)Iridium(III), tris (2-phenylquinolinato-N,C$^{2'}$)Iridium(III), tris(1-phenylisoquinolinato-N,C$^{2'}$)Iridium(III), tris(1-(4'-methylphenyl)isoquinolinato-N,C2')Iridium(III), tris(2-(4',6'-difluorophenyl)-pyridinato-N,C$^{2'}$)Iridium(III), tris(2-(5'-phenyl-4',6'-difluorophenyl)-pyridinato-N,C$^{2'}$)Iridium(III), tris(2-(5'-phenyl-phenyl)pyridinato-N,C$^{2'}$)Iridium(III), tris(2-(2'-benzothienyl)pyridinato-N,C$^{3'}$) Iridium(III), tris(2-phenyl-3,3'-dimethyl)indolato-N,C$^{2'}$)Ir(III), tris(1-phenyl-1H-indazolato-N,C$^{2'}$)Ir(III).

Tris-C,N-cyclometallated phosphorescent materials also include compounds according to Formula (PD) wherein the monoanionic bidentate ligand X-Y is another C,N-cyclometallating ligand. Examples include bis(1-phenylisoquinolinato- N,$C^{2'}$)(2-phenylpyridinato-N,$C^{2'}$)Iridium(III), bis(2-phenylpyridinato-N,$C^{2'}$) (1-phenylisoquinolinato-N,$C^{2'}$)Iridium(III), bis(1-phenylisoquinolinato-N,$C^{2'}$)(2-phenyl-5-methyl-pyridinato-N,$C^{2'}$)Iridium(III), bis(1-phenylisoquinolinato-N,$C^{2'}$)(2-phenyl-4-methyl-pyridinato-N,$C^{2'}$)Iridium(III), and bis(1-phenylisoquinolinato-N,$C^{2'}$)(2-phenyl-3-methyl-pyridinato-N,$C^{2'}$)Iridium(III).

Structural formulae of some tris-C,N-cyclometallated Iridium complexes are shown below.

| | |
|---|---|
| IrPD-1 | 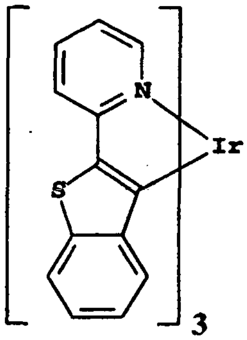 |
| IrPD-2 | 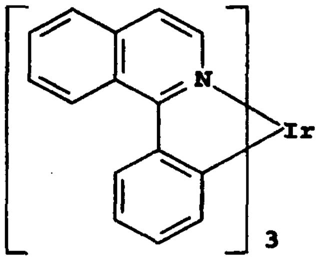 |
| IrPD-3 | 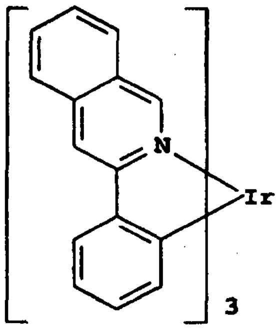 |
| IrPD-4 | 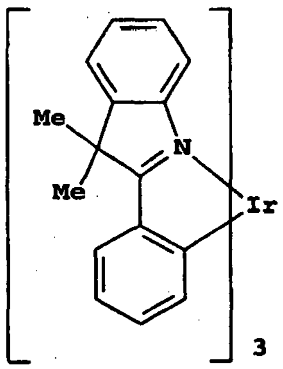 |

(continued)

| | |
|---|---|
| IrPD-5 | 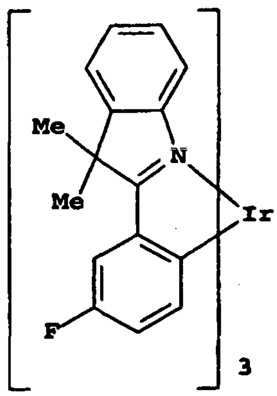 |
| IrPD-6 | 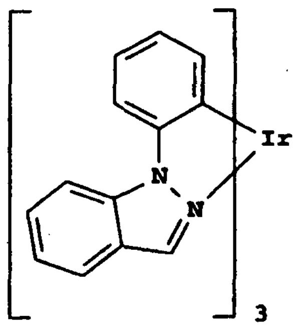 |
| IrPD-7 | 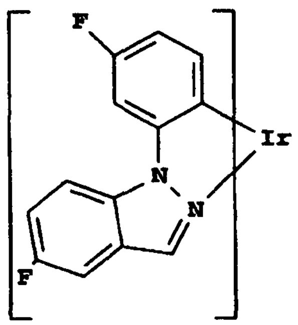 |
| IrPD-8 | 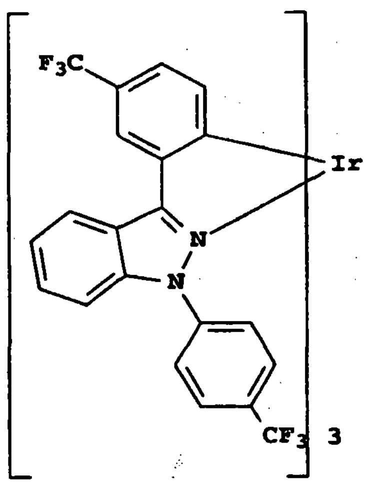 |

(continued)

| | |
|---|---|
| IrPD-9 | 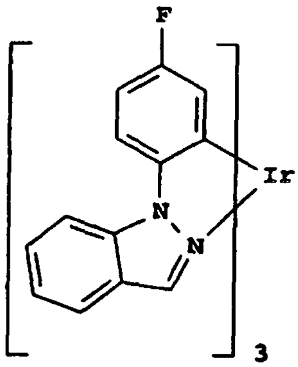 |
| IrPD-10 | 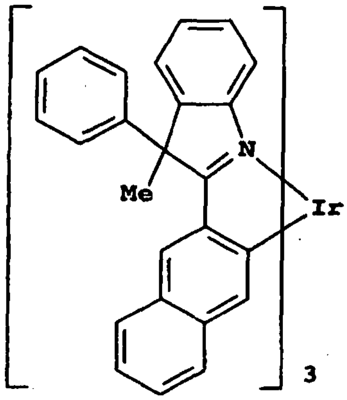 |
| IrPD-11 | 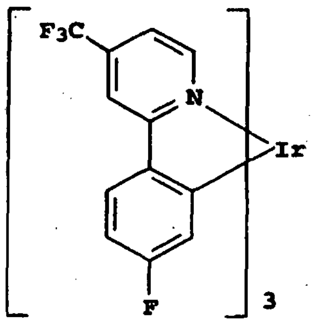 |
| IrPD-12 | 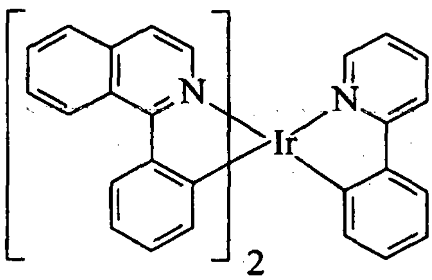 |
| IrPD-13 | 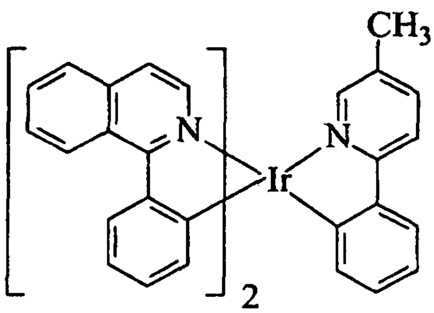 |

(continued)

| | |
|---|---|
| IrPD-14 | 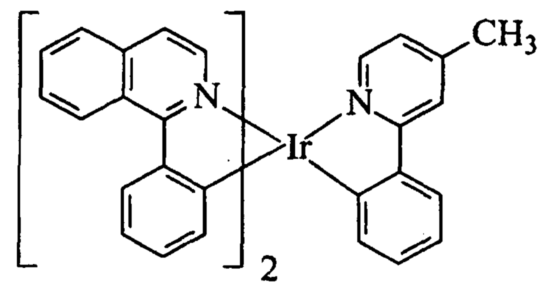 |
| IrPD-15 | 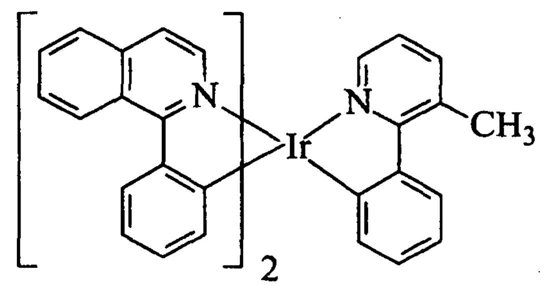 |

Suitable phosphorescent materials according to Formula (PD) may in addition to the C,N-cyclometallating ligand(s) also contain monoanionic bidentate ligand(s) X-Y that are not C,N-cyclometallating. Common examples are beta-diketonates such as acetylacetonate, and Schiff bases such as picolinate. Examples of such mixed ligand complexes according to Formula (PD) include bis(2-phenylpyridinato-N,C$^{2'}$)Iridium(III)(acetylacetonate), bis(2-(2'-benzothienyl)pyridinato-N,C$^{3'}$)Iridium(III)(acetylacetonate), and bis(2-(4',6'-difluorophenyl)-pyridinato-N,C2')Iridium(III)(picolinate).

Other important phosphorescent materials according to Formula (PD) include C,N-cyclometallated Pt(II) complexes such as cis-bis(2-phenylpyridinato-N,C$^{2'}$)platinum(II), cis-bis(2-(2'-thienyl)pyridinato-N,C$^{3'}$) platinum(II), cis-bis (2-(2'-thienyl)quinolinato-N,C$^{5'}$) platinum(II), or (2-(4',6'-difluorophenyl)pyridinato-N,C$^{2'}$) platinum (II) (acetylacetonate).

In addition to bidentate C,N-cyclometallating complexes represented by Formula (PD), many suitable phosphorescent emitters contain multidentate C,N-cyclometallating ligands. Phosphorescent emitters having tridentate ligands suitable for use in the present invention are disclosed in US 6,824,895 B1 and US Ser. No. 10/729,238 (pending) and references therein, incorporated in their entirety herein by reference. Phosphorescent emitters having tetradentate ligands suitable for use in the present invention are described by the following formulae:

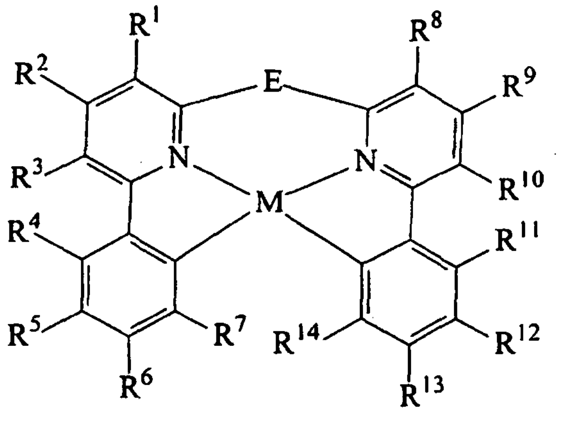

(PDT-a)

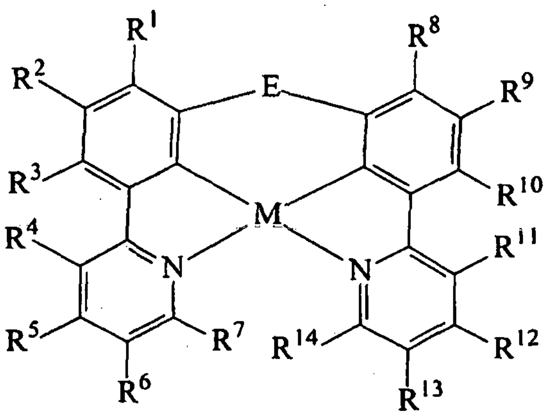

(PDT-b)

wherein:

M is Pt or Pd;

$R^1$-$R^7$ represent hydrogen or independently selected substituents, provided that $R^1$ and $R^2$, $R^2$ and $R^3$, $R^3$ and $R^4$, $R^4$ and $R^5$, $R^5$ and $R^6$, as well as $R^6$ and $R^7$ may join to form a ring group;

$R^8$-$R^{14}$ represent hydrogen or independently selected substituents, provided that $R^8$ and $R^9$, $R^9$ and $R^{10}$, $R^{10}$ and $R^{11}$, $R^{11}$ and $R^{12}$, $R^{12}$ and $R^{13}$, as well as $R^{13}$ and $R^{14}$ may join to form a ring group;

E represents a bridging group selected from the following:

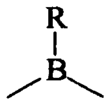 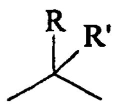 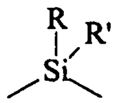

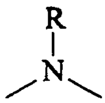 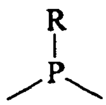 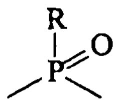

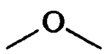 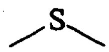 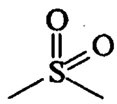 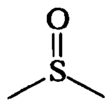

wherein R and R' represent hydrogen or independently selected substituents; provided R and R' may combine to form a ring group.

In one desirable embodiment, the tetradentate C,N-cyclometallated phosphorescent emitter suitable for use in the present invention is represented by the following formula:

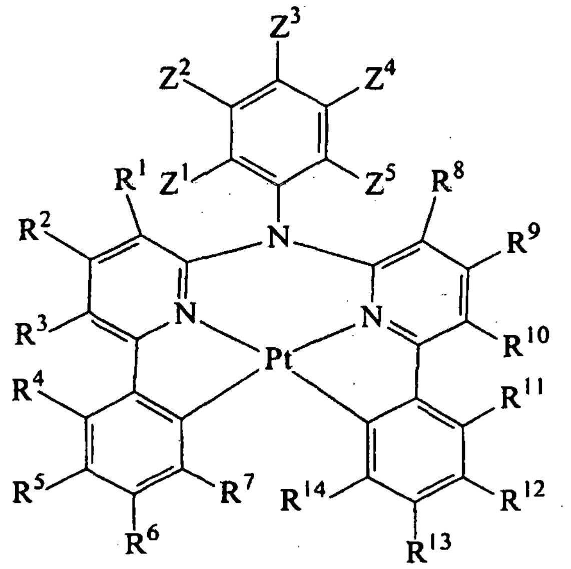

(PDT-c)

wherein,

$R^1$-$R^7$ represent hydrogen or independently selected substituents, provided that $R^1$ and $R^2$, $R^2$ and $R^3$, $R^3$ and $R^4$, $R^4$ and $R^5$, $R^5$ and $R^6$, as well as $R^6$ and $R^7$ may combine to form a ring group;
$R^8$-$R^{14}$ represent hydrogen or independently selected substituents, provided that $R^8$ and $R^9$, $R^9$ and $R^{10}$, $R^{10}$ and $R^{11}$, $R^{11}$ and $R^{12}$, $R^{12}$ and $R^{13}$ as well as $R^{13}$ and $R^{14}$ may combine to form a ring group;
$Z^1$-$Z^5$ represent hydrogen or independently selected substituents, provided that $Z^1$ and $Z^2$, $Z^2$ and $Z^3$, $Z^3$ and $Z^4$, as well as $Z^4$ and $Z^5$ may combine to form a ring group.

Examples of phosphorescent emitters having tetradentate C,N-cyclometallating ligands include the compounds represented below.

| | |
|---|---|
| 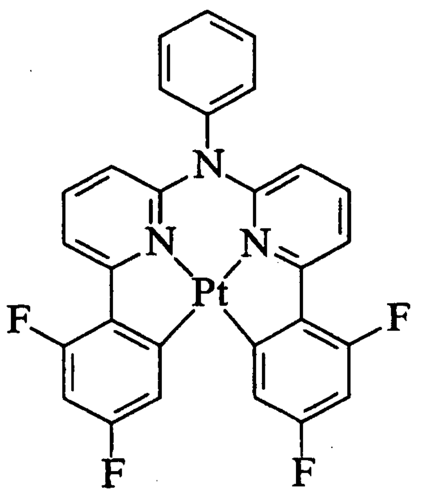 | PtPD-1 |

(continued)

| | |
|---|---|
| 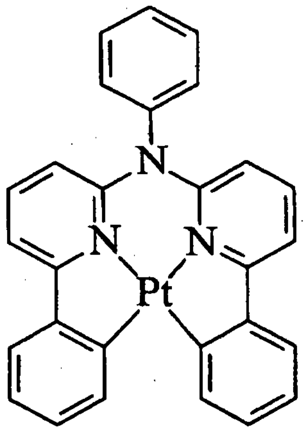 | PtPD-2 |
| 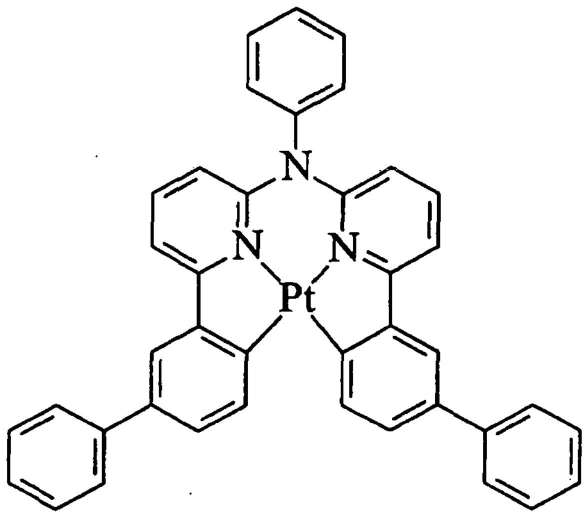 | PtPD-3 |

The emission wavelengths (color) of C,N-cyclometallated phosphorescent materials according to Formulas (PD), (PDT-a), (PDT-b) and (PDT-c) are governed principally by the lowest energy optical transition of the complex and hence by the choice of the C,N-cyclometallating ligand. For example, 2-phenyl-pyridinato-N,C$^{2'}$ complexes are typically green emissive while 1-phenyl-isoquinolinolato-N,C$^{2'}$ complexes are typically red emissive. In the case of complexes having more than one C,N-cyclometallating ligand, the emission will be that of the ligand having the property of longest wavelength emission. Emission wavelengths may be further shifted by the effects of substituent groups on the C,N-cyclometallating ligands. For example, substitution of electron donating groups at appropriate positions on the N-containing ring A or electron withdrawing groups on the C-containing ring B tend to blue-shift the emission relative to the unsubstituted C,N-cyclometallated ligand complex. Selecting a monodentate anionic ligand X,Y in Formula (PD) having more electron withdrawing properties also tends to blue-shift the emission of a C,N-cyclometallated ligand complex. Examples of complexes having both monoanionic bidentate ligands possessing electron-withdrawing properties and electron-withdrawing substituent groups on the C-containing ring B include bis(2-(4',6'-difluorophenyl)-pyridinato-N,C$^{2'}$)iridium(III)(picolinate); bis(2-[4"-trifluoromethyl-5'-phenyl-(4',6'-difluorophenyl)-pyridinato-N,C$^{2'}$)iridium(III)(picolinate); bis(2-(5'-phenyl-4',6'-difluorophenyl)-pyridinato-N,C$^{2'}$)iridium(III)(picolinate); bis(2-(5'-cyano-4',6'-difluorophenyl)-pyridinato-N,C$^{2}$)iridium(III)(picolinate); bis(2-(4',6'-difluorophenyl)-pyridinato-N,C$^{2}$)iridium(III)(tetrakis(1-pyrazolyl)borate); bis[2-(4',6'-difluorophenyl)-pyridinato- N,C$^{2'}$]{2-[(3-trifluoromethyl)-1H-pyrazol-5-yl]pyridinato-N,N'}iridium(III); bis[2-(4',6'-difluorophenyl)-4-methylpyridinato- N,C$^{2'}$]{2-[(3-trifluoromethyl)-1H-pyrazol-5-yl]pyridinato-N,N'}iridium(III); and bis[2-(4',6'-difluorophenyl)-4-methoxypyridinato- N,C$^{2'}$]{2-[(3-trifluoromethyl)-1H-pyrazol-5-yl]pyridinato-N,N'}iridium(III).

The central metal atom in phosphorescent materials according to Formula (PD) may be Rh or Ir for (m + n = 3) and Pd or Pt (m + n = 2). Preferred metal atoms are Ir and Pt since these tend to give higher phosphorescent quantum efficiencies according to the stronger spin-orbit coupling interactions generally obtained with elements in the third transition series.

Other phosphorescent materials that do not involve C,N-cyclometallating ligands are known. Phosphorescent

complexes of Pt(II), Ir(I), and Rh(I) with maleonitriledithiolate have been reported (C.E. Johnson et al, J. Am. Chem. Soc., 105,1795-1802 (1983)). Re(I) tricarbonyl diimine complexes are also known to be highly phosphorescent (M. Wrighton and D.L. Morse, J. Am. Chem. Soc., 96,998-1003 (1974); D.J. Stufkens, Comments Inorg. Chem., 13,359-385 (1992); V.W.W. Yam, Chem. Commun., 2001, 789-796)). Os(II) complexes containing a combination of ligands including cyano ligands and bipyridyl or phenanthroline ligands have also been demonstrated in a polymer OLED (Y. Ma et al, Synthetic Metals, 94, 245-248 (1998)).

Porphyrin complexes such as 2,3,7,8,12,13,17,18-octaethyl-21H, 23H-porphine platinum(II) are also useful phosphorescent materials.

Still other examples of useful phosphorescent materials include coordination complexes of the trivalent lanthanides such as $Tb^{3+}$ and $Eu^{3+}$ (J. Kido et al., Chem Lett., 657 (1990); J Alloys and Compounds, 192, 30-33 (1993); Jpn J Appl Phys, 35, L394-6 (1996) and Appl. Phys. Lett., 65, 2124 (1994)).

Additional information on suitable phosphorescent materials can be found in US 6,303,238 B1, WO 00/57676, WO 00/70655, WO 01/41512 A1, US 2002/0182441 A1, US 2003/0017361 A1, US 2003/ 0072964 A1, US 6,413,656 B1, US 6,687,266 B1, US 2004/0086743 A1, US 2004/0121184 A1, US 2003/0059646 A1, US 2003/0054198 A1, EP 1 239 526 A2, EP 1238 981 A2, EP 1 244 155 A2, US 2002/0100906 A1, US 2003 / 0068526 A1, US 2003/0068535 A1, JP 2003073387A, JP 2003 073388A, US 6,677,060 B2, US 2003/0235712 A1, US 2004/0013905 A1, US 6,733,905 B2, US 6,780,528 B2, US 2003/0040627 A1, JP 2003059667A, JP 2003073665A, US 2002/0121638 A1, EP 1371708A1, US 2003/010877 A1, WO 03/040256 A2, US 2003/0096138 A1, US 2003/0173896 A1, US 6,670645 B2, US 2004/0068132 A1, WO 2004/015025 A1, US 2004/0072018 A1, US 2002/0134984 A1, WO 03/079737 A2, WO 2004/020448 A1, WO 03/091355 A2, US Ser. No. 10/729,402, US Ser. No. 10/729,712, US Ser. No. 10/729,738, US Ser. No. 10/729,238, US 6,824,895 B1, US Ser. No. 10/729,207 (now allowed), and US Ser. No. 10/729,263 (now allowed).

Triplet energies (eV) for suitable phosphorescent materials are shown in the table below:

**Phosphorescent Emitters**

| Identifier | HOMO Energy | LUMO Energy | Triplet Energy | Structure |
|---|---|---|---|---|
| $Ir(piq)_3$ | -5.24 | -2.63 | 2.12 | 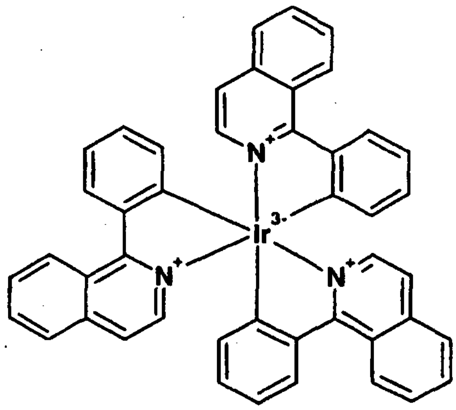 |
| $Ir(ppy)_3$ | -5.27 | -2.10 | 2.54 | 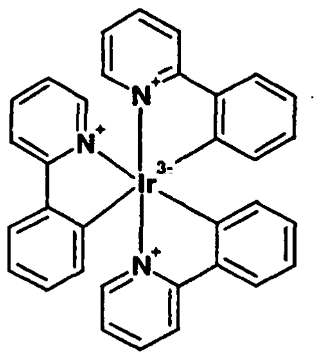 |

(continued)

| Identifier | HOMO Energy | LUMO Energy | Triplet Energy | Structure |
|---|---|---|---|---|
| OEPPT | -5.40 | -2.67 | 2.13 | 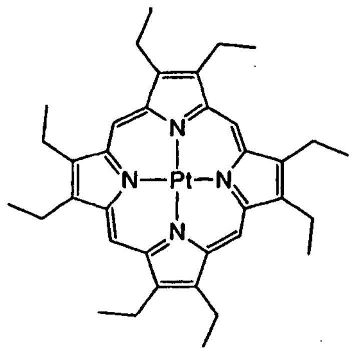 |
| IrBPT | -5.23 | -2.38 | 2.19 | 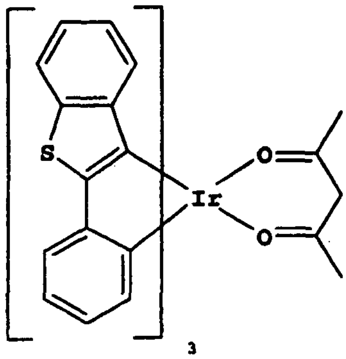 |

Types of suitable triplet host materials may further be categorized according to their charge transport properties. Types thus include hosts that are predominantly electron transporting and those that are predominantly hole transporting. It should be noted that some host materials which may be categorized as transporting dominantly one type of charge carrier, may transport both types of charge carriers in certain device structures, as reported for CBP by C. Adachi, R. Kwong, and S.R. Forrest, Organic Electronics, 2, 37-43 (2001). Another type of host are those having wide energy gaps between the HOMO and LUMO such that they do not readily transport charges of either type and instead rely on charge injection directly into the phosphorescent emitter molecules.
Finally, host materials may comprise a mixture of two or more host materials.
However, a mixture comprising at least one each of an electron transporting and a hole transporting co-host is not particularly useful in the present invention because it allows charge recombination to occur in different regions of the device although it may be possible to avoid this problem by varying concentrations of co-host(s) to confine or restrict the recombination zone to a certain region of the LEL.

A desirable electron transporting host or co-host may be any suitable electron transporting compound, such as benzazole, phenanthroline, 1,3,4-oxadiazole, triazole, triazine, or triarylborane, as long as it has a triplet energy that is higher than that of the phosphorescent emitter to be employed.

A preferred class of benzazoles is described by Jianmin Shi et al. in US 5,645,948 and US 5,766,779. Such compounds are represented by structural formula (BAH):

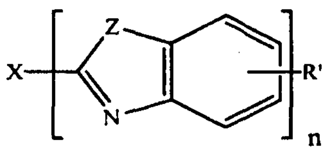 (BAH)

In formula (BAH), n is selected from 2 to 8;

Z is independently O, NR or S;
R and R' are individually hydrogen; alkyl of from 1 to 24 carbon atoms, for example, propyl, t-butyl, heptyl, and the like; aryl or hetero-atom substituted aryl of from 5 to 20 carbon atoms, for example, phenyl and naphthyl, furyl, thienyl, pyridyl, quinolinyl and other heterocyclic systems; or halo such as chloro, fluoro; or atoms necessary to

complete a fused aromatic ring; and

X is a linkage unit consisting of carbon, alkyl, aryl, substituted alkyl, or substituted aryl, which conjugately or unconjugately connects the multiple benzazoles together.

An example of a useful benzazole is 2,2',2"-(1,3,5-phenylene)tris[1-phenyl-1H-benzimidazole] (TPBI) represented as shown below:

| | |
|---|---|
| TPBI (Host-9) | 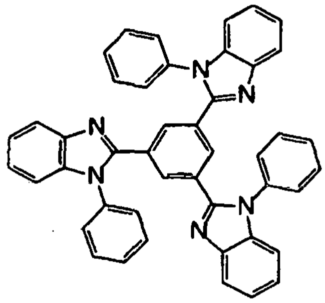 |

Another class of the electron transporting materials suitable for use as a host or co-host includes various substituted phenanthrolines as represented by formula (PH):

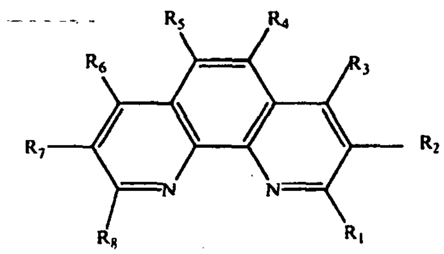

(PH)

In formula (PH), $R_1$-$R_8$ are independently hydrogen, alkyl group, aryl or substituted aryl group, and at least one of $R_1$-$R_8$ is aryl group or substituted aryl group.

Examples of particularly suitable materials of this class are 2,9-dimethyl-4,7-diphenyl-1,10-phenanthroline (BCP) and 4,7-diphenyl-1,10-phenanthroline (Bphen).

| | |
|---|---|
| BCP | 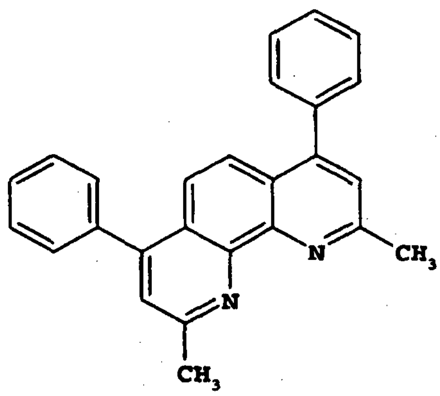 |

(continued)

| | |
|---|---|
| Bphen (Host-12) | 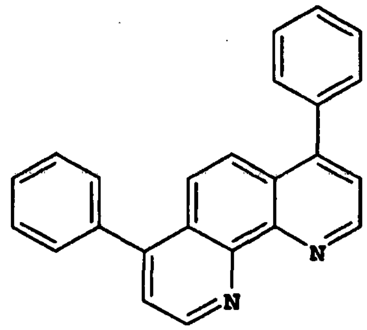 |

The triarylboranes that function as the electron transporting host or co-host in the present invention may be selected from compounds having the chemical formula (TBH):

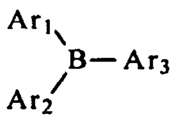

(TBH-a)

wherein

Ar$_1$ to Ar$_3$ are independently an aromatic hydrocarbocyclic group or an aromatic heterocyclic group which may have a substituent. It is preferable that compounds having the above structure are selected from formula (TBH-b):

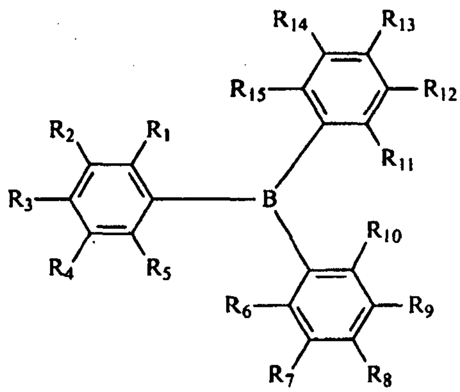

(TBH-b)

wherein R$_1$-R$_{15}$ are independently hydrogen, fluoro, cyano, trifluoromethyl, sulfonyl, alkyl, aryl or substituted aryl group.

Specific representative embodiments of the triarylboranes include:

| | |
|---|---|
| TBH-1 | 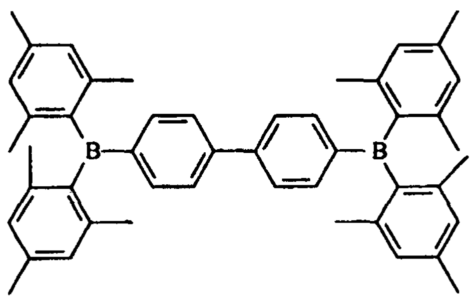 |

(continued)

| | |
|---|---|
| TBH-2 | 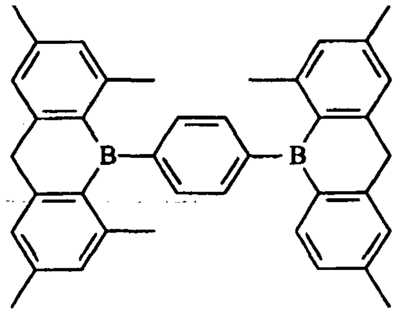 |
| TBH-3 | 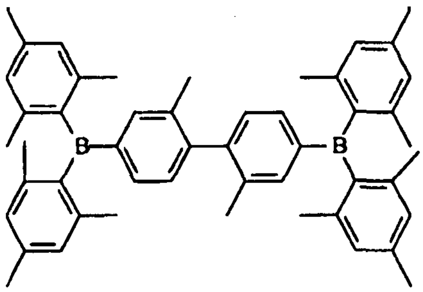 |

The electron transporting host or co-host in the present invention may be selected from substituted 1,3,4-oxadiazoles. Illustrative of the useful substituted oxadiazoles are the following:

| | |
|---|---|
| ODH-1 | 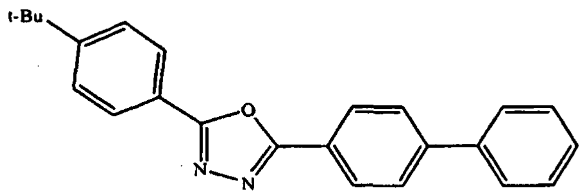 |
| ODH-2 | 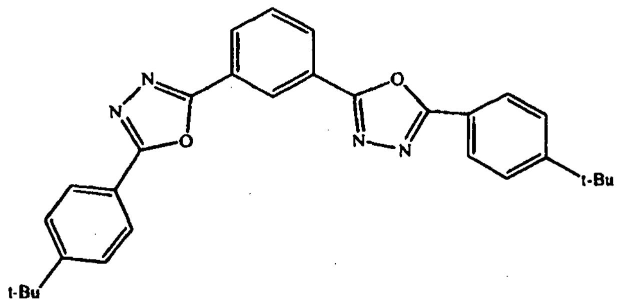 |

The electron transporting host or co-host in the present invention also may be selected from substituted 1,2,4-triazoles. An example of a useful triazole is 3-phenyl-4-(1-naphtyl)-5-phenyl-1,2,4-triazole:

| | |
|---|---|
| PNPT-1 | 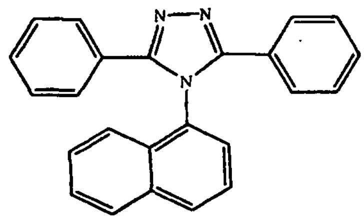 |

The electron transporting host or co-host in the present invention also may be selected from substituted 1,3,5-triazines. Examples of suitable materials are:

2,4,6-tris(diphenylamino)-1,3,5-triazine;
2,4,6-tricarbazolo-1,3,5-triazine;
2,4,6-tris(N-phenyl-2-naphthylamino)- 1,3,5-triazine;
2,4,6-tris(N-phenyl-1-naphthylamino)- 1,3,5-triazine;
4,4',6,6'-tetraphenyl-2,2'-bi-1,3,5-triazine;
2,4,6-tris([1,1':3',1"-terphenyl]-5'-yl)-1,3,5-triazine.

A desirable hole transporting host or co-host may be any suitable hole transporting compound, such as a triarylamine or a carbazole, as long it has a triplet energy higher than that of the phosphorescent emitter to be employed.

A suitable class of hole transporting compounds for use as a host or co-host for the phosphorescent emitter of the present invention are aromatic tertiary amines, by which it is understood to be compounds containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al. in US 3,180,730. Other suitable triarylamines substituted with one or more vinyl radicals and/or comprising at least one active hydrogen containing group are disclosed by Brantley et al. in US 3,567,450 and US 3,658,520.

A more preferred class of aromatic tertiary amines are those which include at least two aromatic tertiary amine moieties as described in US 4,720,432 and US 5,061,569. Such compounds include those represented by structural formula (ATA-a):

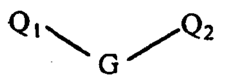
(ATA-a)

wherein $Q_1$ and $Q_2$ are independently selected aromatic tertiary amine moieties, and G is a linking group such as an arylene, cycloalkylene, or alkylene group of a carbon to carbon bond. In one embodiment, at least one of $Q_1$ or $Q_2$ contains a polycyclic fused ring structure, e.g., a naphthalene. When G is an aryl group, it is conveniently a phenylene, biphenylene, or naphthalene moiety.

A useful class of triarylamines satisfying structural formula (ATA-a) and containing two triarylamine moieties is represented by structural formula (ATA-b):

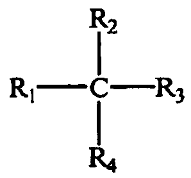
(ATA-b)

wherein

$R_1$ and $R_2$ each independently represents a hydrogen atom, an aryl group, or an alkyl group; or $R_1$ and $R_2$ together represent the atoms completing a cycloalkyl group; and
$R_3$ and $R_4$ each independently represents an aryl group, which is in turn substituted with a diaryl substituted amino group, as indicated by structural formula (ATA-c):

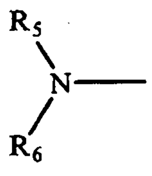
(ATA-c)

wherein $R_5$ and $R_6$ are independently selected aryl groups. In one embodiment, at least one of $R_5$ or $R_6$ contains a polycyclic fused ring structure, e.g., a naphthalene.

Another class of aromatic tertiary amines is the tetraaryldiamines. Desirable tetraaryldiamines include two diarylamino groups, such as indicated by formula (ATA-c), linked through an arylene group. Useful tetraaryldiamines include those represented by formula (TADA):

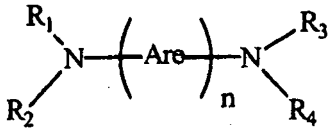

(TADA)

wherein each Are is an independently selected arylene group, such as a phenylene or anthracene moiety,
n is selected from 1 to 4, and
$R_1$-$R_4$ are independently selected aryl groups.

In a typical embodiment, at least one of $R_1$-$R_4$ is a polycyclic fused ring structure, e.g., a naphthalene.

The various alkyl, alkylene, aryl, and arylene moieties of the foregoing structural formulas (ATA-a to -c), and (TADA) can each in turn be substituted. Typical substituents include alkyl groups, alkoxy groups, aryl groups, aryloxy groups, and halogen such as fluoride, chloride, and bromide. The various alkyl and alkylene moieties typically contain from 1 to 6 carbon atoms. The cycloalkyl moieties can contain from 3 to 10 carbon atoms, but typically contain five, six, or seven ring carbon atoms, such as cyclopentyl, cyclohexyl, and cycloheptyl ring structures. The aryl and arylene moieties are usually phenyl and phenylene moieties.

Representative examples of the useful compounds include the following:

4,4'-Bis[N-(1-naphthyl)-N-phenytamino]biphenyl (NPB; Host-7);
4,4'-Bis[N-(1-naphthyl)-N-(2-naphthyl)amino]biphenyl (TNB);
4,4'-Bis[N-(3-methylphenyl)-N-phenylamino]biphenyl (TPD);
4,4'-Bis-diphenylamino-terphenyl;
2,6,2',6'-tetramethyl-N,N,N',N'-tetraphenyl-benzidine.

In one suitable embodiment the hole transporting host or co-host comprises a material of formula (ATA-d):

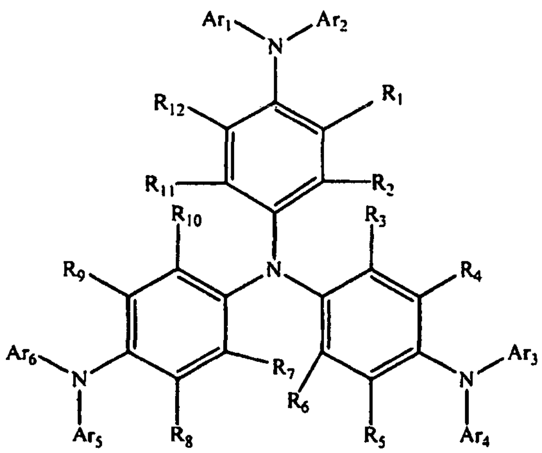

(ATA-d)

In formula (ATA-d), $Ar_1$-$Ar_6$ independently represent aromatic groups, for example, phenyl groups or tolyl groups;

$R_1$-$R_{12}$ independently represent hydrogen or independently selected substituent, for example an alkyl group containing from 1 to 4 carbon atoms, an aryl group, a substituted aryl group.

Examples of the suitable materials include, but are not limited to: 4,4',4"-tris[(3-methylphenyl)phenylamino] triphenylamine (MTDATA); 4,4',4"-tris(N,N-diphenyl-amino) triphenylamine (TDATA); N,N-bis[2,5-dimethyl-4-[(3-methylphenyl)phenylamino]phenyl]-2,5-dimethyl-N'-(3-methylphenyl)-N'-phenyl-1,4-benzenediamine.

In one desirable embodiment the hole transporting host or co-host comprises a material of formula (ATA-e):

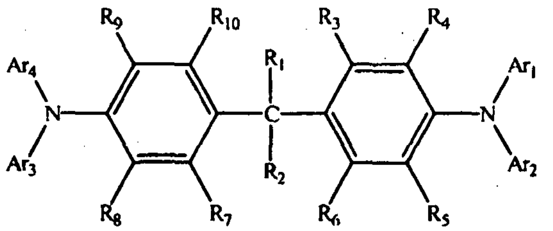

(ATA-e)

In formula (ATA-e), $R_1$ and $R_2$ represent substituents, provided that $R_1$ and $R_2$ can join to form a ring. For example, $R_1$ and $R_2$ can be methyl groups or join to form a cyclohexyl ring;
$Ar_1$-$Ar_4$ represent independently selected aromatic groups, for example phenyl groups or tolyl groups;
$R_3$-$R_{10}$ independently represent hydrogen, alkyl, substituted alkyl, aryl, substituted aryl group.

Examples of suitable materials include, but are not limited to:

1,1-Bis(4-(N,N-di-*p*-tolylamino)phenyl)cyclohexane (TAPC);
1,1-Bis(4-(N,N-di-*p*-tolylamino)phenyl)cyclopentane;
4,4'-(9H-fluoren-9-ylidene)bis[N,N-bis(4-methylphenyl)-benzenamine;
1,1-Bis(4-(N,N-di-*p*-tolylamino)phenyl)-4-phenylcyclohexane;
1,1-Bis(4-(N,N-di-*p*-tolylamino)phenyl)-4-methylcyclohexane;
1,1-Bis(4-(N,N-di-*p*-tolylamino)phenyl)-3-phenylpropane;
Bis[4-(N,N-diethylamino)-2-methylphenyl](4-methylpenyl)methane;
Bis[4-(N,N-diethylamino)-2-methylphenyl](4-methylphenyl)ethane;
4-(4-Diethylaminophenyl)triphenylmethane;
4,4'-Bis(4-diethylaminophenyl)diphenylmethane.

A useful class of triarylamines suitable for use as the hole transporting host or co-host includes carbazole derivatives such as those represented by formula (CAH-a):

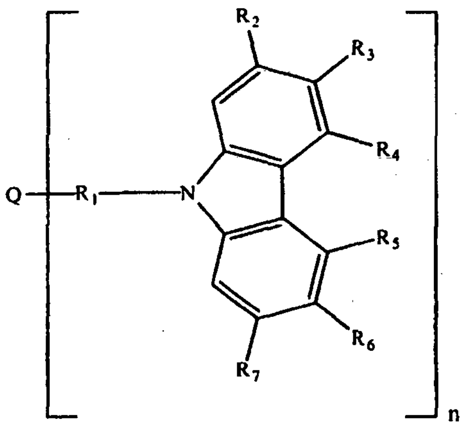

(CAH-a)

In formula (CAH), Q independently represents nitrogen, carbon, an aryl group, or substituted aryl group, preferably a phenyl group;
$R_1$ is preferably an aryl or substituted aryl group, and more preferably a phenyl group, substituted phenyl, biphenyl, substituted biphenyl group;
$R_2$ through $R_7$ are independently hydrogen, alkyl, phenyl or substituted phenyl group, aryl amine, carbazole, or substituted carbazole; and n is selected from 1 to 4.

Another useful class of carbazoles satisfying structural formula (CAH-a) is represented by formula (CAH-b):

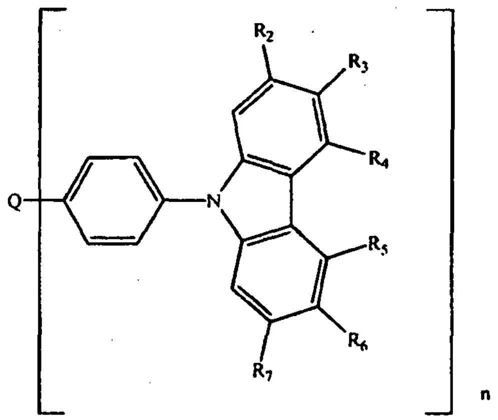

(CAH-b)

wherein n is an integer from 1 to 4;
Q is nitrogen, carbon, an aryl, or substituted aryl;
$R_2$ through $R_7$ are independently hydrogen, an alkyl group, phenyl or substituted phenyl, an aryl amine, a carbazole and substituted carbazole.

Illustrative of useful substituted carbazoles are the following:

4-(9H-carbazol-9-yl)-N,N-bis[4-(9H-carbazol-9-yl)phenyl]-benzenamine (TCTA);
4-(3-phenyl-9H-carbazol-9-yl)-N,N-bis[4(3-phenyl-9H- carbazol-9-yl)phenyl]-benzenamine;
9,9'-[5'-[4-(9H-carbazol-9-yl)phenyl][1,1':3',1"-terphenyl]-4,4"-diyl]bis-9H-carbazole.

In one suitable embodiment the hole transporting host or co-host comprises a material of formula (CAH-c):

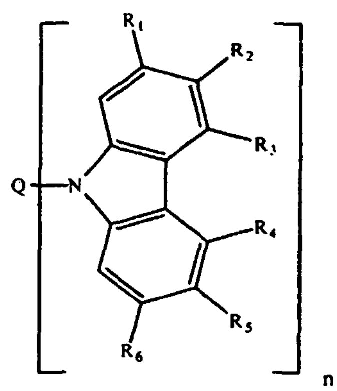

(CAH-c)

In formula (CAH-c), n is selected from 1 to 4;
Q independently represents phenyl group, substituted phenyl group, biphenyl, substituted biphenyl group, aryl, or substituted aryl group;
$R_1$ through $R_6$ are independently hydrogen, alkyl, phenyl or substituted phenyl, aryl amine, carbazole, or substituted carbazole.

Examples of suitable materials are the following:

9,9'-(2,2'-dimethyl[1,1'-biphenyl]-4,4'-diyl)bis-9H-carbazole (CDBP);
9,9'-[1,1'-biphenyl]-4,4'-diylbis-9H-carbazole (CBP; Host-8);
9,9'-(1,3-phenylene)bis-9H-carbazole (MCP; Host-10);
9,9'-(1,4-phenylene)bis-9H-carbazole;
9,9',9"-(1,3,5-benzenetriyl)tris-9H-carbazole;
9,9'-(1,4-phenylene)bis[N,N,N',N'-tetraphenyl-9H-carbazole-3,6-diamine;
9-[4-(9H-carbazol-9-yl)phenyl]-N,N-diphenyl-9H-carbazol-3-amine;
9,9'-(1,4-phenylene)bis[N,N-diphenyl-9H-carbazol-3-amine;

9-[4-(9H-carbazol-9-yl)phenyl]-N,N,N',N'-tetraphenyl- 9H-carbazole-3,6-diamine.

Recently, it was disclosed that some carbazole derivatives may be useful as electron-transporting host materials (WO2006/115700a2).

Thompson *et al.* disclosed in US 2004/0209115A1 and US 2004/0209116A1 a group of wide energy gap hosts having triplet energies suitable for blue phosphorescent OLEDs. Such compounds include those represented by structural formula (WEGH):

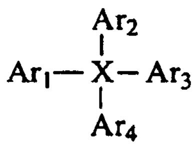

(WEGH)

wherein:

A is Si or Pb; Ar1, Ar2, Ar3 and Ar4 are each an aromatic group independently selected from phenyl and high triplet energy heterocyclic groups such as pyridine, pyrazole, thiophene, etc. The approach taken here to maximize the HOMO-LUMO gaps in these materials is to electronically isolate each aromatic unit, avoiding any conjugating substituents.

Illustrative examples of this type of hosts include:

| | |
|---|---|
| 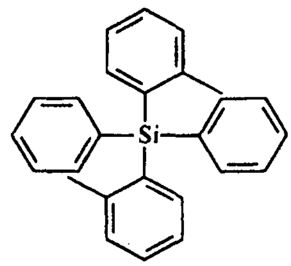 | WEGH-1 |
| 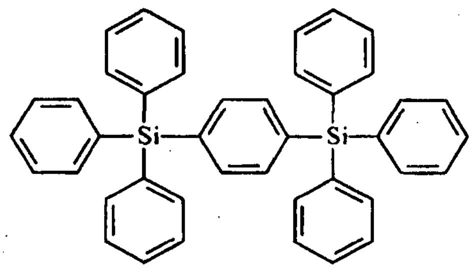 | WEGH-2 |
| 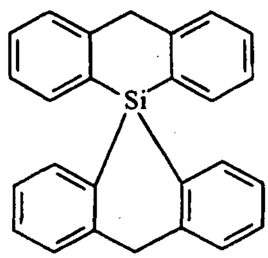 | WEGH-3 |

These "wide energy gap" materials shown above have very deep HOMOs and high LUMOs. Thus, the HOMO and LUMO of the emissive emitter are within the HOMO and LUMO for the host. In this case, the emitter acts as the primary charge carrier for both electrons and holes, as well as the site for the trapping of excitons. The "wide energy gap" host material functions as a non-charge carrying material in the system. Such a combination may lead to high operation voltage of the device, as the concentration of the charge-carrying emitter is typically below 10% in the emissive layer.

Increasing the charge carrying abilities of the "wide energy gap" host materials can be realized by incorporating substituents with electron-withdrawing or electron-donating properties. Electron transporting "wide energy gap" hosts having electron-withdrawing groups are disclosed in Thompson *et al.* cited above. Specific examples are shown below:

| | |
|---|---|
| 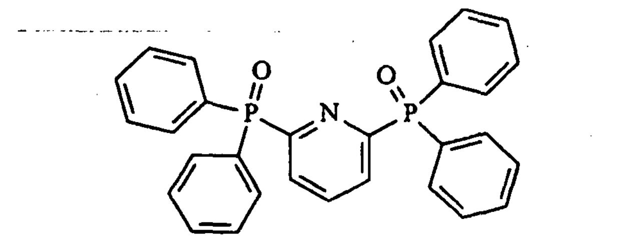 | WEGH-4 |
| 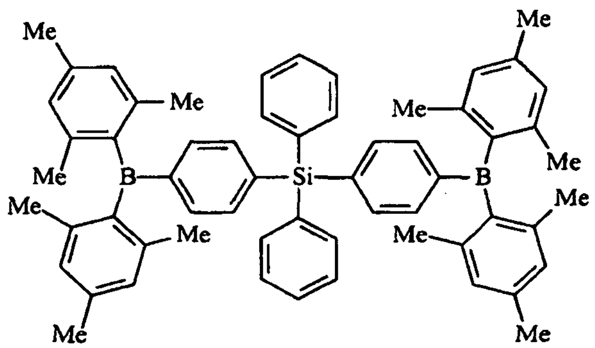 | WEGH-5 |
| 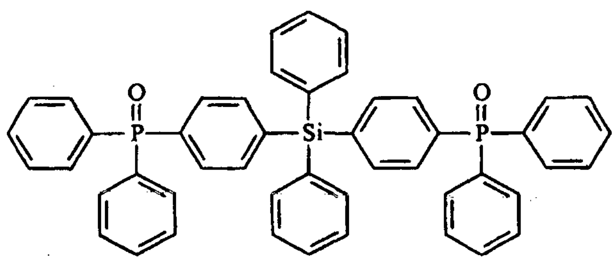 | WEGH-6 |

Another suitable class of compounds for use as a host or co-host for the phosphorescent emitter of the present invention are benzoperylene derivatives as described in US7175922, US Apps 20050106415 and 2004076853 and JP2002359081. These materials are according to formula (BP):

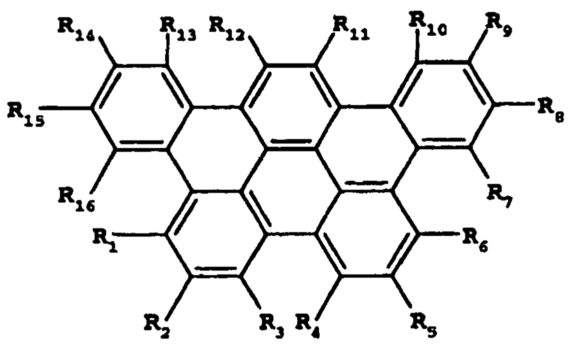

(BP)

where $R_1$-$R_{16}$ each independently represents hydrogen, halo, alkyl (straight, branched or cyclic). aryl (unsubstituted or substituted), aryloxy, alkyloxy or amino groups with the proviso that neighboring groups may form additional annulated rings. A specific example of this class is host-17.

The host may comprise at least one electron-transporting co-host and at least one hole-transporting co-host although this arrangement is often not suitable for the purposes of this invention. The optimum concentration of the hole transporting co-host(s) in the present invention may be determined by experimentation and may be within the range 10 to 60 weight % of the total of the hole- and electron transporting co-host materials in the light emitting layer, and is often

found to be in the range 15 to 30 wt. %. The optimum concentration of the electron transporting co-host in the present invention may be determined by experimentation and may be within the range from 40 to 90 weight %, and is often found to be in the range from 70 to 85 weight %. It is further noted that electron-transporting molecules and hole-transporting molecules may be covalently joined together to from a single host molecule having both electron-transporting and hole-transporting properties.

The following table lists some representative structures of suitable hosts to be used in combination with a particular phosphorescent emitter so long as the combination meets the triplet energy relationships of this invention. It should be noted that these same materials can also be used as hosts or co-hosts in combination with a fluorescent emitter so long as the combination meets the triple energy relationships of this invention.

**Hosts for Phosphorescent Emitters**

| Identifier | HOMO Energy | LUMO Energy | Triplet Energy | Structure |
|---|---|---|---|---|
| Host-6 (TCTA) | -5.43 | -1.88 | 2.85 | 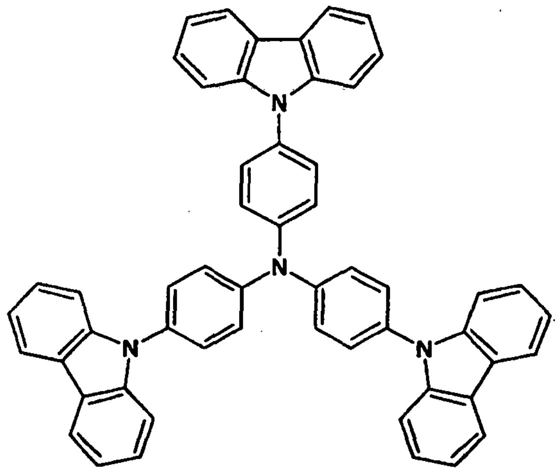 |
| Host-7 (NPB) | -5.19 | -2.06 | 2.50 | 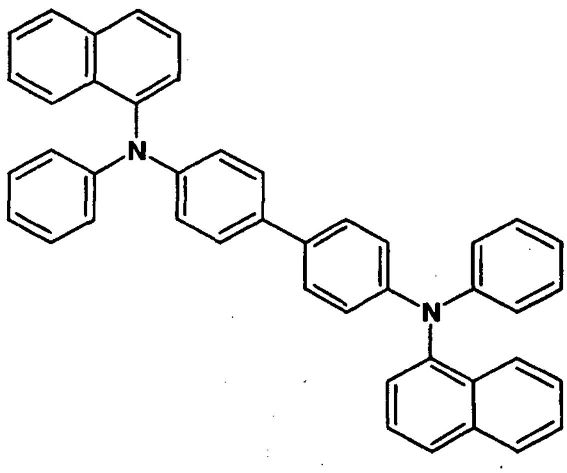 |
| Host-8 (CBP) | -5.58 | -2.13 | 2.67 | 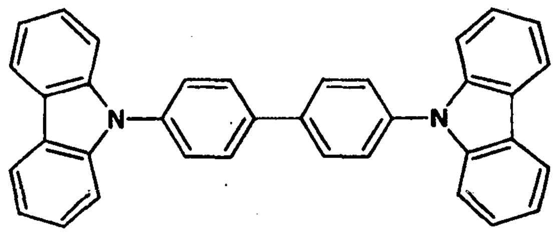 |

(continued)

| Identifier | HOMO Energy | LUMO Energy | Triplet Energy | Structure |
|---|---|---|---|---|
| Host-9 (TPBI) | -5.79 | -2.09 | 2.69 | 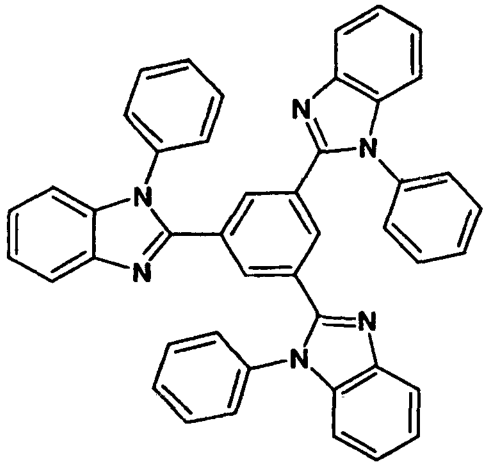 |
| Host-10 (MCP) | -5.68 | -1.75 | 3.15 | 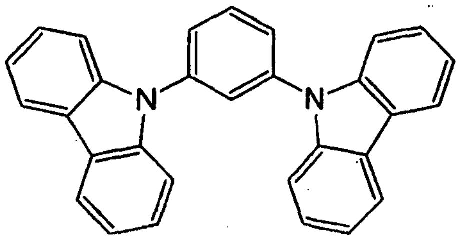 |
| Host-11 | -5.88 | -2.54 | 2.95 | 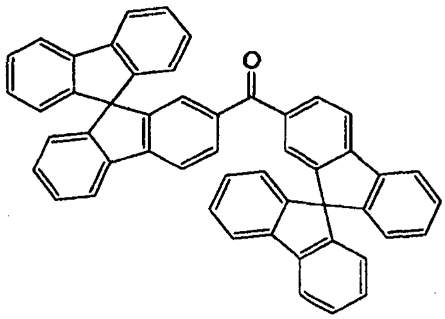 |
| Host-12 (BPhen) | -6.03 | -2.29 | 2.64 | 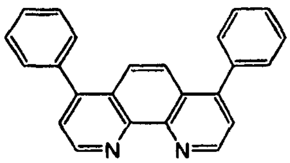 |
| Host-13 | -5.63 | -2.42 | 2.57 | 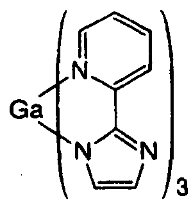 |

(continued)

| Identifier | HOMO Energy | LUMO Energy | Triplet Energy | Structure |
|---|---|---|---|---|
| Host-14 | -5.69 | -2.69 | 2.43 | 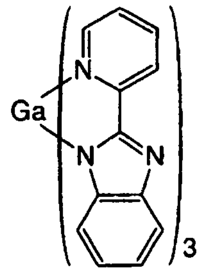 |
| Host-15 | -5.15 | -1.30 | 2.95 | 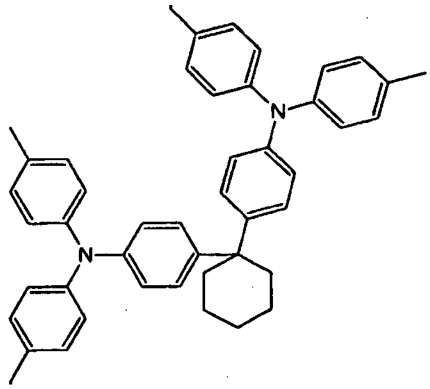 |
| Host-16 (mtdata) | -4.93 | -1.91 | 2.65 | 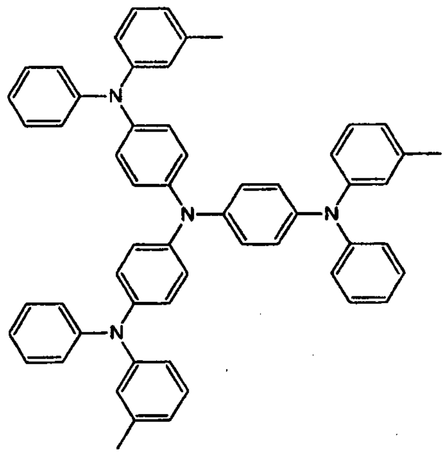 |
| Host-17 | -5.63 | -2.39 | 2.47 | 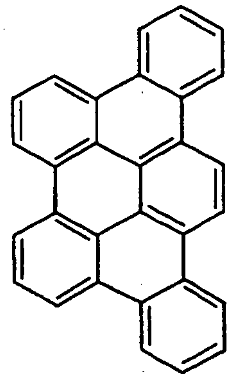 |

(continued)

| Identifier | HOMO Energy | LUMO Energy | Triplet Energy | Structure |
|---|---|---|---|---|
| Host-18 (ALQ) | -5.36 | -2.51 | 2.11 | 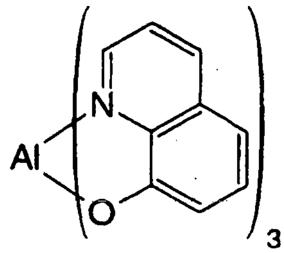 |
| Host-19 (rubrene) | -5.17 | -2.85 | 1.24 | 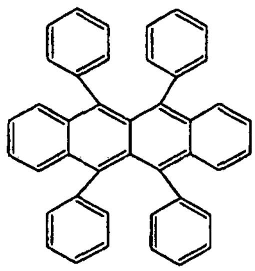 |
| Host-20 | -5.55 | -2.26 | 2.47 | 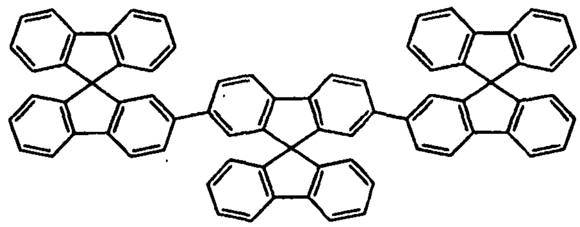 |
| Host-21 (ADN) | -5.49 | -2.45 | 1.84 | 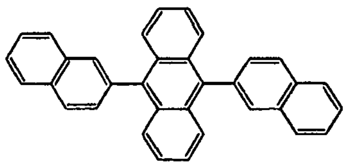 |
| Host-21 (BCP) | -5.91 | -2.16 | 2.61 | 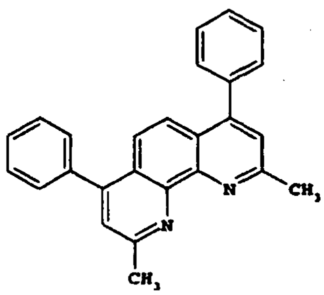 |

General Device Architecture

The present invention can be employed in many OLED device configurations using small molecule materials, oligomeric materials, polymeric materials, or combinations thereof. These include very simple structures comprising a single anode and cathode to more complex devices, such as passive matrix displays comprised of orthogonal arrays of anodes and cathodes to form pixels, and active-matrix displays where each pixel is controlled independently, for example, with thin film transistors (TFTs).

There are numerous configurations of the organic layers wherein the present invention can be successfully practiced. The essential requirements of an OLED are an anode, a cathode, and an organic light emitting layer located between the anode and cathode. Additional layers may be employed as more fully described hereafter.

A schematic of a typical structure (illustrated by device 1-5) according to the present invention and especially useful for a small molecule device is shown in FIG. 1. OLED **100** in FIG. 1 includes anode **103,** HTL **107,** an exciton

blocking layer **108,** a fluorescent LEL **109,** a spacer layer **110,** a phosphorescent LEL **111,** ETL **112** and cathode **113.** OLED **100** can be operated by applying an electric potential produced by a voltage/current source 150 between the pair of the electrodes, anode **103** and cathode **113.**

Shown in FIGS. 2 is an additional embodiment (according to device 5-1) of an OLED prepared in accordance with the present invention. OLED **200** in FIG. 2 has two adjacent blue fluorescent LELs with two red phosphorescent LELs on either size with a separate green phosphorescent LEL located between on of the red LEL and the cathode, with the indicated spacer layers, ETL, HTL and HILs.

These layers are described in detail below. Note that the substrate 101 may alternatively be located adjacent to the cathode **113,** or the substrate **101** may actually constitute the anode **103** or cathode **113.** The organic layers between the anode **103** and cathode **113** are conveniently referred to as the organic EL element. Also, the total combined thickness of the organic layers is desirably less than 500 nm.

The anode **103** and cathode **113** of the OLED are connected to a voltage/current source **150** through electrical conductors **160.** The OLED is operated by applying a potential between the anode **103** and cathode **113** such that the anode **103** is at a more positive potential than the cathode **113.** Holes are injected into the organic EL element from the anode **103** and electrons are injected into the organic EL element at the cathode **113.** Enhanced device stability can sometimes be achieved when the OLED is operated in an AC mode where, for some time period in the AC cycle, the potential bias is reversed and no current flows. An example of an AC driven OLED is described in US 5,552,678.

Substrate **101**

The OLED device of this invention is typically provided over a supporting substrate **101** where either the cathode **113** or anode **103** can be in contact with the substrate. The electrode in contact with the substrate **101** is conveniently referred to as the bottom electrode. Conventionally, the bottom electrode is the anode **103,** but this invention is not limited to that configuration. The substrate **101** can either be light transmissive or opaque, depending on the intended direction of light emission. The light transmissive property is desirable for viewing the EL emission through the substrate **101.** Transparent glass or plastic is commonly employed in such cases. The substrate **101** can be a complex structure comprising multiple layers of materials. This is typically the case for active matrix substrates wherein TFTs are provided below the OLED layers. It is still necessary that the substrate **101,** at least in the emissive pixelated areas, be comprised of largely transparent materials such as glass or polymers. For applications where the EL emission is viewed through the top electrode, the transmissive characteristic of the bottom support is immaterial, and therefore the substrate can be light transmissive, light absorbing or light reflective. Substrates for use in this case include, but are not limited to, glass, plastic, semiconductor materials such as silicon, ceramics, and circuit board materials. Again, the substrate **101** can be a complex structure comprising multiple layers of materials such as found in active matrix TFT designs. It is necessary to provide in these device configurations a light-transparent top electrode.

Anode **103**

When the desired electroluminescent light emission (EL) is viewed through the anode, the anode **103** should be transparent or substantially transparent to the emission of interest. Common transparent anode materials used in this invention are indium-tin oxide (ITO), indium-zinc oxide (IZO) and tin oxide, but other metal oxides can work including, but not limited to, aluminum- or indium-doped zinc oxide, magnesium-indium oxide, and nickel-tungsten oxide. In addition to these oxides, metal nitrides, such as gallium nitride, and metal selenides, such as zinc selenide, and metal sulfides, such as zinc sulfide, can be used as the anode **103.** For applications where EL emission is viewed only through the cathode **113,** the transmissive characteristics of the anode **103** are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials are commonly deposited by any suitable means such as evaporation, sputtering, chemical vapor deposition, or electrochemical means. Anodes can be patterned using well-known photolithographic processes. Optionally, anodes may be polished prior to application of other layers to reduce surface roughness so as to minimize short circuits or enhance reflectivity.

Cathode **113**

When light emission is viewed solely through the anode **103,** the cathode **113** used in this invention can be comprised of nearly any conductive material. Desirable materials have good film-forming properties to ensure good contact with the underlying organic layer, promote electron injection at low voltage, and have good stability. Useful cathode materials often contain a low work function metal (< 4.0 eV) or metal alloy. One useful cathode material is comprised of a Mg:Ag alloy wherein the percentage of silver is in the range of 1 to 20 %, as described in U.S. Patent

No. 4,885,221. Another suitable class of cathode materials includes bilayers comprising the cathode and a thin electron injecting layer (EIL) in contact with an organic layer (e.g., an electron transporting layer (ETL)), the cathode being capped with a thicker layer of a conductive metal. Here, the EIL preferably includes a low work function metal or metal salt, and if so, the thicker capping layer does not need to have a low work function. One such cathode is comprised of a thin layer of LiF followed by a thicker layer of A1 as described in U.S. Patent No. 5,677,572. An ETL material doped with an alkali metal, for example, Li-doped Alq, is another example of a useful EIL. Other useful cathode material sets include, but are not limited to, those disclosed in U.S. Patent Nos. 5,059,861, 5,059,862, and 6,140,763.

When light emission is viewed through the cathode, the cathode **113** must be transparent or nearly transparent. For such applications, metals must be thin or one must use transparent conductive oxides, or a combination of these materials. Optically transparent cathodes have been described in more detail in US 4,885,211, US 5,247,190, JP 3,234,963, US 5,703,436, US 5,608,287, US 5,837,391, US 5,677,572, US 5,776,622, US 5,776,623, US 5,714,838, US 5,969,474, US 5,739,545, US 5,981,306, US 6,137,223, US 6,140,763, US 6,172,459, EP 1 076 368, US 6,278,236, and US 6,284,3936. Cathode materials are typically deposited by any suitable method such as evaporation, sputtering, or chemical vapor deposition. When needed, patterning can be achieved through many well known methods including, but not limited to, through-mask deposition, integral shadow masking as described in US 5,276,380 and EP 0 732 868, laser ablation, and selective chemical vapor deposition.

Hole Injecting Layer (HIL) **105**

A hole injecting layer **105** may be provided between anode **103** and hole transporting layer **107.** The hole injecting layer can serve to improve the film formation property of subsequent organic layers and to facilitate injection of holes into the hole transporting layer **107.** Suitable materials for use in the hole injecting layer **105** include, but are not limited to, porphyrinic compounds as described in US 4,720,432, plasma-deposited fluorocarbon polymers as described in US 6,208,075, and some aromatic amines, for example, MTDATA (4,4',4"-tris[(3-methylphenyl)phenylamino] triphenylamine). Alternative hole injecting materials reportedly useful in organic EL devices are described in EP 0 891 121 A1 and EP 1 029 909 A1. A hole injection layer is conveniently used in the present invention, and is desirably a plasma-deposited fluorocarbon polymer.

The thickness of a hole injection layer containing a plasma-deposited fluorocarbon polymer can be in the range of 0.2 nm to 15 nm and suitably in the range of 0.3 to 1.5 nm.

Hole Transporting Layer (HTL) **107**

In addition to the emissive layer, it is usually advantageous to have a hole transporting layer **107** deposited between the anode and the emissive layer. A hole transporting material deposited in said hole transporting layer between the anode and the light emitting layer may be the same or different from a hole transporting compound used as a co-host or in exciton blocking layer according to the invention. The hole transporting layer may optionally include a hole injection layer. The hole transporting layer may include more than one hole transporting compound, deposited as a blend or divided into separate layers.

The hole transporting layer of the organic EL device contains at least one hole transporting compound such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al. in US 3,180,730. Other suitable triarylamines substituted with one or more vinyl radicals and/or comprising at least one active hydrogen containing group are disclosed by Brantley et al. in US 3,567,450 and US 3,658,520.

A more preferred class of aromatic tertiary amines is those which include at least two aromatic tertiary amine moieties as described in US 4,720,432 and US 5,061,569. Such compounds include those represented by structural formula (ATA-a):

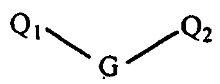

(ATA-a)

wherein

$Q_1$ and $Q_2$ are independently selected aromatic tertiary amine moieties, and G is a linking group such as an arylene, cycloalkylene, or alkylene group of a carbon to carbon bond. In one embodiment, at least one of $Q_1$ or $Q_2$ contains a polycyclic fused ring structure, e.g., a naphthalene. When G is an aryl group, it is conveniently a phenylene,

biphenylene, or naphthalene moiety.

A useful class of triarylamines satisfying structural formula (ATA-a) and containing two triarylamine moieties is represented by structural formula (ATA-b):

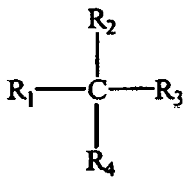

(ATA-b)

wherein

$R_1$ and $R_2$ each independently represents a hydrogen atom, an aryl group, or an alkyl group or $R_1$ and $R_2$ together represent the atoms completing a cycloalkyl group; and
$R_3$ and $R_4$ each independently represents an aryl group, which is in turn substituted with a diaryl substituted amino group, as indicated by structural formula (ATA-c):

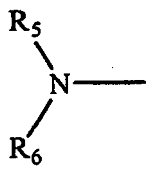

(ATA-c)

wherein

$R_5$ and $R_6$ are independently selected aryl groups. In one embodiment, at least one of $R_5$ or $R_6$ contains a polycyclic fused ring structure, e.g., a naphthalene.

Another class of aromatic tertiary amines is the tetraaryldiamines. Desirable tetraaryldiamines include two diarylamino groups, such as indicated by formula (ATA-c), linked through an arylene goup. Useful tetraaryldiamines include those represented by formula (TADA):

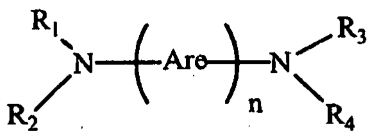

(TADA)

wherein

each Are is an independently selected arylene group, such as a phenylene or anthracene moiety,
n is an integer of from 1 to 4, and
$R_1$, $R_2$, $R_3$, and $R_4$ are independently selected aryl groups.

In a typical embodiment, at least one of $R_1$, $R_2$, $R_3$, and $R_4$ is a polycyclic fused ring structure, e.g., a naphthalene.

The various alkyl, alkylene, aryl, and arylene moieties of the foregoing structural formulae ATA-a to -c and TADA can each in turn be substituted. Typical substituents include alkyl groups, alkoxy groups, aryl groups, aryloxy groups, and halide such as fluoride, chloride, and bromide. The various alkyl and alkylene moieties typically contain from 1 to 6 carbon atoms. The cycloalkyl moieties can contain from 3 to 10 carbon atoms, but typically contain five, six, or seven ring carbon atoms, such as cyclopentyl, cyclohexyl, and cycloheptyl ring structures. The aryl and arylene moieties are usually phenyl and phenylene moieties.

The hole transporting layer can be formed of a single tertiary amine compound or a mixture of such compounds. Specifically, one may employ a triarylamine, such as a triarylamine satisfying the formula (ADA-b), in combination with a tetraaryldiamine, such as indicated by formula (TADA). Illustrative of useful aromatic tertiary amines are the following:

1,1-Bis(4-di-*p*-tolylaminophenyl)cyclohexane (TAPC);
1,1-Bis(4-di-*p*-tolylaminophenyl)-4-phenylcyclohexane;
N,N,N,N'-tetraphenyl-4,4"'-diamino-1,1':4,1":4",1 "'-quaterphenyl;
Bis(4-dimethylamino-2-methylphenyl)phenylmethane;
1,4-bis[2-[4-[N,N-di(p-tolyl)amino]phenyl]vinyl]benzene (BDTAPVB);
N,N,N',N'-Tetra-*p*-tolyl-4,4'-diaminobiphenyl;
N,N,N',N'-Tetraphenyl-4,4'-diaminobiphenyl;
N,N,N',N'-tetra-1-naphthyl-4,4"diaminobiphenyl;
N,N,N',N'-tetra-2-naphthyl-4,4'-diaminobiphenyl;
N-Phenylcarbazole;
4,4'-Bis[N-(1-naphthyl)-N-phenylamino]biphenyl (NPB);
4,4'-Bis[N-(3-methylphenyl)-N-phenylamino]biphenyl (TPD);
4,4'-Bis[N-(1-naphthyl)-N-(2-naphthyl)amino]biphenyl (TNB);
4,4'-Bis[N-(1-naphthyl)-N-phenylamino]p-terphenyl;
4,4'-Bis[N-(2-naphthyl)-N-phenylamino]biphenyl;
4,4'-Bis[N-(3-acenaphthenyl)-N-phenylamino]biphenyl;
1,5-Bis[N-(1-naphthyl)-N-phenylamino]naphthalene;
4,4'-Bis[N-(9-anthryl)-N-phenylamino]biphenyl;
4,4'-Bis[N-(1-anthryl)-N-phenylamino]-*p*-terphenyl;
4,4'-Bis[N-(2-phenanthryl)-N-phenylamino]biphenyl;
4,4'-Bis[N-(8-fluoranthenyl)-N-phenylamino]biphenyl;
4,4'-Bis[N-(2-pyrenyl)-N-phenylamino]biphenyl;
4,4'-Bis[N-(2-naphthacenyl)-N-phenylamino]biphenyl;
4,4'-Bis[N-(2-perylenyl)-N-phenylamino]biphenyl;
4,4'-Bis[N-(1-coronenyl)-N-phenylamino]biphenyl;
2,6-Bis(di-*p*-tolylamino)naphthalene;
2,6-Bis[di-(1-naphthyl)amino]naphthalene;
2,6-Bis[N-(1-naphthyl)-N-(2-naphthyl)amino]naphthalene;
N,N,N',N'-Tetra(2-naphthyl)-4,4"-diamino-*p*-terphenyl;
4,4'-Bis{N-phenyl-N-[4-(1-naphthyl)-phenyl]amino}biphenyl;
2,6-Bis[N,N-di(2-naphthyl)amino]fluorine;
4,4',4"-tris[(3-methylphenyl)phenylamino]triphenylamine(MTDATA);
N,N-bis[2,5-dimethyl-4-[(3-methylphenyl)phenylamino]phenyl]-2,5-dimethyl-N'-(3-methylphenyl)-N'-phenyl-1,4-benzenediamine;
4-(9H-carbazol-9-yl)-N,N-bis[4-(9H-carbazol-9-yl)phenyl]-benzenamine (TCTA);
4-(3-phenyl-9H-carbazol-9-yl)-N,N-bis[4(3-phenyl-9H- carbazol-9-yl)phenyl]-benzenamine;
9,9'-(2,2'-dimethyl[1,1'-biphenyl]-4,4'-diyl)bis-9H-carbazole (CDBP);
9,9'-[1,1'-biphenyl]-4,4'-diylbis-9H-carbazole (CBP);
9,9'-(1,3-phenylene)bis-9H-carbazole (mCP);
9-[4-(9H-carbazol-9-yl)phenyl]-N,N-diphenyl-9H-carbazol-3-amine;
9,9'-(1,4-phenylene)bis[N,N-diphenyl-9H-carbazol-3-amine;
9-[4-(9H-carbazol-9-yl)phenyl]-N,N,N',N'-tetraphenyl- 9H-carbazole-3,6-diamine.

Another class of useful hole transporting materials includes polycyclic aromatic compounds as described in EP 1 009 041. Tertiary aromatic amines with more than two amine groups may be used including oligomeric materials. In addition, polymeric hole transporting materials can be used such as poly(N-vinylcarbazole) (PVK), polythiophenes, polypyrrole, polyaniline, and copolymers such as poly(3,4-ethylenedioxythiophene) / poly(4-styrenesulfonate) also called PEDOT/PSS.
It is also possible for the hole transporting layer to comprise two or more sublayers of differing compositions, the composition of each sublayer being as described above.
The thickness of the hole transporting layer can be between 10 and 500 nm and suitably between 50 and 300 nm.

Exciton Blocking Layer (EBL) **108**

As described, for example in US Apps 20060134460 and US20020008233, an exciton blocking layer **108** is useful in an OLED device employing a phosphorescent emitter. When located adjacent to a fluorescent or phosphorescent light emitting layer on the anode side, it helps to help confine triplet excitons to the light emitting layer. In order that the exciton blocking layer be capable of confining triplet excitons, the material or materials of this layer should have triplet

energies that exceed that of the light emitter. Otherwise, if the triplet energy level of any material in the layer adjacent the light emitting layer is lower than that of the light emitter, often that material will quench excited states in the light emitting layer, decreasing device luminous efficiency. In some cases it is also desirable that the exciton blocking layer also help to confine electron-hole recombination events to the light emitting layer by blocking the escape of electrons from the light emitting layer into the exciton blocking layer.

The exciton blocking layer can be between 1 and 500 nm thick and suitably between 10 and 300 nm thick. Thicknesses in this range are relatively easy to control in manufacturing. The exciton blocking layer may include more than one compound, deposited as a blend or divided into separate layers.

In addition to having high triplet energy, the exciton blocking layer should be capable of transporting holes to a light emitting layer. Thus, materials that have good hole transporting properties also generally have good exciton blocking properties. A hole transporting material used in exciton blocking layer between the anode and the light emitting layer may be the same or different from a hole transporting compound used as a co-host in a light emitting layer.

Suitable exciton blocking materials are those according to formulas (ATA-a to -c) and (TADA) as described for use as hole transporting materials as well as compounds according to formula (ATA-d) useful for hosts or co-hosts in a phosphorescent light emitting layer. A specific example of an excellent material for this purpose is 4,4',4"-tris(carbazolyl)-triphenylamine (TCTA).

Light Emitting Layers (LEL)

The fluorescent **109** and phosphorescent **111** light emitting layers of the invention have been described in detail previously.

The thickness of a light emitting layer can be between 5 and 500 nm and suitably between 10 and 200 nm.

Hole Blocking Layer (HBL) **158**

In addition to suitable hosts and transporting materials, an OLED device according to the invention may also include at least one hole blocking layer **158** placed between the electron transporting layer **112** and a light emitting layer 109 or 111 to help confine the excitons and recombination events to the light emitting layer comprising co-hosts and a phosphorescent emitter. In this case, there should be an energy barrier for hole migration from co-hosts into the hole blocking layer, while electrons should pass readily from the hole blocking layer into the light emitting layer comprising co-host materials and a phosphorescent emitter. The first requirement entails that the ionization potential of the hole blocking layer **158** be larger than that of the light emitting layer **109** or **111,** desirably by 0.2 eV or more. The second requirement entails that the electron affinity of the hole blocking layer **158** not greatly exceed that of the light emitting layer **109** or **111,** and desirably be either less than that of light emitting layer or not exceed that of the light emitting layer by more than about 0.2 eV.

When used with an electron transporting layer whose characteristic luminescence is green, such as an Alq-containing electron transporting layer as described below, the requirements concerning the energies of the highest occupied molecular orbital (HOMO) and lowest unoccupied molecular orbital (LUMO) of the material of the hole blocking layer frequently result in a characteristic luminescence of the hole blocking layer at shorter wavelengths than that of the electron transporting layer, such as blue, violet, or ultraviolet luminescence. Thus, it is desirable that the characteristic luminescence of the material of a hole blocking layer be blue, violet, or ultraviolet. It is further desirable that the triplet energy of the hole blocking material be greater than that of the phosphorescent material. Suitable hole blocking materials are described in WO 00/70655A2, WO 01/41512 and WO 01/93642 A1. Three examples of useful hole blocking materials are Bphen, BCP and bis(2-methyl-8-quinolinolato)(4-phenylphenolato)aluminum(III) (BAlq). The characteristic luminescence of BCP is in the ultraviolet, and that of BAlq is blue. Metal complexes other than BAlq are also known to block holes and excitons as described in US 20030068528. In addition, US 20030175553 A1 describes the use of *fac*-tris(1-phenylpyrazolato-N,$C^{2'}$)iridium(III) (Irppz) for this purpose.

When a hole blocking layer is used, its thickness can be between 2 and 100 nm and suitably between 5 and 10 nm.

Electron Transporting Layer (ETL) **112**

Similarly, it is usually advantageous to have an electron transporting layer **112** deposited between the cathode and the emissive layer. The electron transporting material deposited in said electron transporting layer between the cathode and the light emitting layer may be the same or different from an electron transporting co-host material. The electron transporting layer may include more than one electron transporting compound, deposited as a blend or divided into separate layers.

Preferred thin film-forming materials for use in constructing the electron transporting layer of the organic EL devices of this invention are metal-chelated oxinoid compounds, including chelates of oxine itself (also commonly referred

to as 8-quinolinol or 8-hydroxyquinoline). Such compounds help to inject and transport electrons, exhibiting high levels of performance, and are readily fabricated in the form of thin films. Exemplary of contemplated oxinoid compounds are those satisfying structural formula (MCOH-a) below:

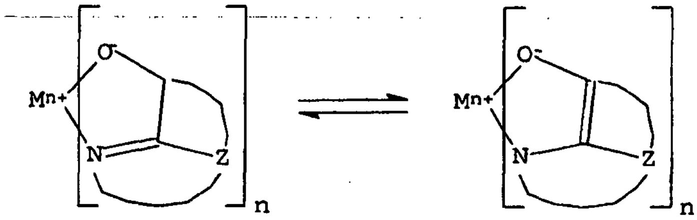

(MCOH-a)

wherein

M represents a metal;
n is an integer of from 1 to 4; and
Z independently in each occurrence represents the atoms completing a nucleus having at least two fused aromatic rings.

From the foregoing it is apparent that the metal can be monovalent, divalent, trivalent, or tetravalent metal. The metal can, for example, be an alkali metal, such as lithium, sodium, or potassium; an alkaline earth metal, such as magnesium or calcium; an earth metal, such aluminum or gallium, or a transition metal such as zinc or zirconium. Generally any monovalent, divalent, trivalent, or tetravalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is usually maintained at 18 or less.

Illustrative of useful chelated oxinoid compounds are the following:

MCOH-1: Aluminum trisoxine [alias, tris(8-quinolinolato)aluminum(III)];
MCOH-2: Magnesium bisoxine [alias, bis(8-quinolinolato)magnesium(II)];
MCOH-3: Bis[benzo{f}-8-quinolinolato]zinc (II);
MCOH-4: Bis(2-methyl-8-quinolinolato)aluminum(III)-μ-oxo-bis(2-methyl-8-quinolinolato) aluminum(III);
MCOH-5: Indium trisoxine [alias, tris(8-quinolinolato)indium];
MCOH-6: Aluminum tris(5-methyloxine) [alias, tris(5-methyl-8-quinolinolato) aluminum(III)];
MCOH-7: Lithium oxine [alias, (8-quinolinolato)lithium(I)];
MCOH-8: Gallium oxine [alias, tris(8-quinolinolato)gallium(III)];
MCOH-9: Zirconium oxine [alias, tetra(8-quinolinolato)zirconium(IV)].

Other electron transporting materials suitable for use in the electron transporting layer are the aluminum complexes described by formula (MCOH-b) above, which are also the compounds employed as electron transporting co-hosts in the present invention.

Other electron transporting materials suitable for use in the electron transporting layer include various butadiene derivatives as disclosed in US 4,356,429 and various heterocyclic optical brighteners as described in US 4,539,507.

Benzazoles satisfying structural formula (BAH) are also useful electron transporting materials:

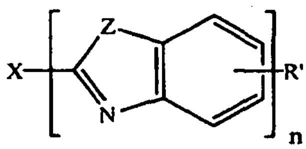

(BAH)

wherein

n is an integer of 3 to 8;
Z is O, NR or S; and
R and R’ are individually hydrogen; alkyl of from 1 to 24 carbon atoms, for example, propyl, t-butyl, heptyl, and the

like; aryl or hetero-atom substituted aryl of from 5 to 20 carbon atoms for example phenyl and naphthyl, furyl, thienyl, pyridyl, quinolinyl and other heterocyclic systems; or halo such as chloro, fluoro; or atoms necessary to complete a fused aromatic ring; and

X is a linkage unit consisting of carbon, alkyl, aryl, substituted alkyl, or substituted aryl, which conjugately or unconjugately connects the multiple benzazoles together. An example of a useful benzazole is 2, 2', 2"-(1,3,5-phenylene) tris[1-phenyl-1H-benzimidazole] (TPBI) disclosed in Shi et al. in US 5,766,779.

Other electron transporting materials suitable for use in the electron transporting layer may be selected from triazines, triazoles, imidazoles, oxazoles, thiazoles and their derivatives, polybenzobisazoles, pyridine- and quinoline-based materials, cyano-containing polymers and perfluorinated materials.

The electron transporting layer or a portion of the electron transporting layer adjacent the cathode may further be doped with an alkali metal to reduce electron injection barriers and hence lower the drive voltage of the device. Suitable alkali metals for this purpose include lithium and cesium.

If both a hole blocking and an electron transporting layers are used in OLED device, electrons should pass readily from the electron transporting layer into the hole blocking layer. Therefore, the electron affinity of the electron transporting layer should not greatly exceed that of the hole blocking layer. Preferably, the electron affinity of the electron transporting layer should be less than that of the hole blocking layer or not exceed it by more than about 0.2 eV.

If an electron transporting layer is used, its thickness may be between 2 and 100 nm and preferably between 5 and 50 nm.

<u>Other Useful Organic Layers and Device Architecture</u>

In some instances, layers **109** or **111** can optionally be collapsed with an adjacent layer into a single layer that serves the function of supporting both light emission and electron transportation. Layers **109** or **111** and **108** or **158** may also be collapsed into a single layer that functions to block holes or excitons, and supports electron transport. It also known in the art that emitting materials may be included in the hole transporting layer **107.** In that case, the hole transporting material may serve as a host. Multiple materials may be added to one or more layers in order to create a white emitting OLED, for example, by combining blue- and yellow emitting materials, cyan- and red emitting materials, or red-, green-, and blue emitting materials. White emitting devices are described, for example, in EP 1 187 235, US 20020025419, EP 1 182 244, US 5,683,823, US 5,503,910, US 5,405,709, and US 5,283,182 and can be equipped with a suitable filter arrangement to produce a color emission.

This invention may be used in so-called stacked device architecture, for example, as taught in US 5,703,436 and US 6,337,492. Similar tandem structures are taught in US 7,126,267 B2. The hybrid light emitting unit of the invention may be stacked with another hybrid unit of the invention or may be stacked with a light emitting unit not of the invention. For example, a highly efficient and useful stacked OLED device is prepared by using a blue fluorescent layer plus a red phosphorescent layer in a hybrid unit according to the invention stacked with a green phosphorescent unit to make a white light emitting device.

<u>Deposition of Organic Layers</u>

The organic materials mentioned above are suitably deposited by any means suitable for the form of the organic materials. In the case of small molecules, they are conveniently deposited through sublimation or evaporation, but can be deposited by other means such as coating from a solvent together with an optional binder to improve film formation. If the material is a polymer, solvent deposition is usually preferred. The material to be deposited by sublimation or evaporation can be vaporized from a sublimator "boat" often comprised of a tantalum material, e.g., as described in US 6,237,529, or can be first coated onto a donor sheet and then sublimed in closer proximity to the substrate. Layers with a mixture of materials can utilize separate sublimator boats or the materials can be pre-mixed and coated from a single boat or donor sheet. Patterned deposition can be achieved using shadow masks, integral shadow masks (US 5,294,870), spatially-defined thermal dye transfer from a donor sheet (US 5,688,551, US 5,851,709 and US 6,066,357) or an inkjet method (US 6,066,357).

<u>Encapsulation</u>

Most OLED devices are sensitive to moisture or oxygen, or both, so they are commonly sealed in an inert atmosphere such as nitrogen or argon, along with a desiccant such as alumina, bauxite, calcium sulfate, clays, silica gel, zeolites, alkaline metal oxides, alkaline earth metal oxides, sulfates, or metal halides and perchlorates. Methods for encapsulation and desiccation include, but are not limited to, those described in U.S. Patent No. 6,226,890. In addition, barrier layers such as $SiO_x$, Teflon, and alternating inorganic/polymeric layers are known in the art for encapsulation.

Any of these methods of sealing or encapsulation and desiccation can be used with the EL devices constructed according to the present invention.

Optical Optimization

OLED devices of this invention can employ various well-known optical effects in order to enhance their emissive properties if desired. This includes optimizing layer thicknesses to yield maximum light transmission, providing dielectric mirror structures, replacing reflective electrodes with light-absorbing electrodes, providing anti-glare or anti-reflection coatings over the display, providing a polarizing medium over the display, or providing colored, neutral density, or color-conversion filters over the display. Filters, polarizers, and anti-glare or anti-reflection coatings may be specifically provided over the EL device or as part of the EL device.

Embodiments of the invention may provide advantageous features such as higher luminous yield, low drive voltage, and higher power efficiency as well as to improve other features such as color, ease of manufacture, and operational stability. In one desirable embodiment the EL device is part of a display device. Embodiments of the invention can also provide an area lighting device. In one suitable embodiment, the EL device includes a means for emitting white light, which may include complimentary emitters, a white emitter, or a filtering means.

In accordance with this disclosure, white light is that light that is perceived by a user as having a white color, or light that has an emission spectrum sufficient to be used in combination with color filters to produce a practical full color display. For low power consumption, it is often advantageous for the chromaticity of the white light-emitting OLED to be close to CIE D65, i.e., CIE x = 0.31 and CIE y = 0.33. This is particularly the case for so-called RGBW displays having red, green, blue, and white pixels. Although CIEx, CIEy coordinates of 0.31, 0.33 are ideal in some circumstances, the actual coordinates can vary significantly and still be very useful.

Unless otherwise specifically stated, use of the term "substituted" or "substituent" means any group or atom other than hydrogen. Unless otherwise provided, when a group (including a compound or complex) containing a substitutable hydrogen is referred to, it is also intended to encompass not only the unsubstituted form, but also form further substituted derivatives with any substituent group or groups as herein mentioned, so long as the substituent does not destroy properties necessary for utility. Suitably, a substituent group may be halogen or may be bonded to the remainder of the molecule by an atom of carbon, silicon, oxygen, nitrogen, phosphorous, sulfur, selenium, or boron. The substituent may be, for example, halogen, such as chloro, bromo or fluoro; nitro; hydroxyl; cyano; carboxyl; or groups which may be further substituted, such as alkyl, including straight or branched chain or cyclic alkyl, such as methyl, trifluoromethyl, ethyl, t-butyl, 3-(2,4-di-t-pentylphenoxy) propyl, and tetradecyl; alkenyl, such as ethylene, 2-butene; alkoxy, such as methoxy, ethoxy, propoxy, butoxy, 2-methoxyethoxy, sec-butoxy, hexyloxy, 2-ethylhexyloxy, tetradecyloxy, 2-(2,4-di-t-pentylphenoxy)ethoxy, and 2-dodecyloxyethoxy; aryl such as phenyl, 4-t-butylphenyl, 2,4,6-trimethylphenyl, naphthyl; aryloxy, such as phenoxy, 2-methylphenoxy, alpha- or beta-naphthyloxy, and 4-tolyloxy; carbonamido, such as acetamido, benzamido, butyramido, tetradecanamido, alpha-(2,4-di-t-pentyl-phenoxy)acetamido, alpha-(2,4-di-t-pentylphenoxy)butyramido, alpha-(3-pentadecylphenoxy)-hexanamido, alpha-(4-hydroxy-3-t-butylphenoxy)-tetradecanamido, 2-oxo-pyrrolidin-1-yl, 2-oxo-5-tetradecylpyrrolin- -yl, N-methyltetradecanamido, N-succinimido, N-phthalimido, 2,5-dioxo-1-oxazolidinyl, 3-dodecyl-2,5-dioxo-1-imidazolyl, and N-acetyl-N-dodecylamino, ethoxycarbonylamino, phenoxycarbonylamino, benzyloxycarbonylamino, hexadecyloxycarbonylamino, 2,4-di-t-butylphenoxycarbonylamino, phenylcarbonylamino, 2,5-(di-t-pentylphenyl)carbonylamino, p-dodecyl-phenylcarbonylamino, p-tolylcarbonylamino, N-methylureido, N,N-dimethylureido, N-methyl-N-dodecylureido, N-hexadecylureido, N,N-dioctadecylureido, N,N-dioctyl-N'-ethylureido, N-phenylureido, N,N-diphenylureido, N-phenyl-N-p-tolylureido, N-(m-hexadecylphenyl)ureido, N,N-(2,5-di-t-pentylphenyl)-N'-ethylureido, and t-butylcarbonamido; sulfonamido, such as methylsulfonamido, benzenesulfonamido, p-tolylsulfonamido, p-dodecylbenzenesulfonamido, N-methyltetradecylsulfonamido, N,N-dipropyl-sulfamoylamino, and hexadecylsulfonamido; sulfamoyl, such as N-methylsulfamoyl, N-ethylsulfamoyl, N,N-dipropylsulfamoyl, N-hexadecylsulfamoyl, N,N-dimethylsulfamoyl, N-[3-(dodecyloxy)propyl]sulfamoyl, N-[4-(2,4-di-t-pentylphenoxy)butyl]sulfamoyl, N-methyl-N-tetradecylsulfamoyl, and N-dodecylsulfamoyl; carbamoyl, such as N-methylcarbamoyl, N,N-dibutylcarbamoyl, N-octadecylcarbamoyl, N-[4-(2,4-di-t-pentylphenoxy)butyl]carbamoyl, N-methyl-N-tetradecylcarbamoyl, and N,N-dioctylcarbamoyl; acyl, such as acetyl, (2,4-di-t-amylphenoxy)acetyl, phenoxycarbonyl, p-dodecyloxyphenoxycarbonyl methoxycarbonyl, butoxycarbonyl, tetradecyloxycarbonyl, ethoxycarbonyl, benzyloxycarbonyl, 3-pentadecyloxycarbonyl, and dodecyloxycarbonyl; sulfonyl, such as methoxysulfonyl, octyloxysulfonyl, tetradecyloxysulfonyl, 2-ethylhexyloxysulfonyl, phenoxysulfonyl, 2,4-di-t-pentylphenoxysulfonyl, methylsulfonyl, octylsulfonyl, 2-ethylhexylsulfonyl, dodecylsulfonyl, hexadecylsulfonyl, phenylsulfonyl, 4-nonylphenylsulfonyl, and p-tolylsulfonyl; sulfonyloxy, such as dodecylsulfonyloxy, and hexadecylsulfonyloxy; sulfinyl, such as methylsulfinyl, octylsulfinyl, 2-ethylhexylsulfinyl, dodecylsulfinyl, hexadecylsulfinyl, phenylsulfinyl, 4-nonylphenylsulfinyl, and p-tolylsulfinyl; thio, such as ethylthio, octylthio, benzylthio, tetradecylthio, 2-(2,4-di-t-pentylphenoxy)ethylthio, phenylthio, 2-butoxy-5-t-octylphenylthio, and p-tolylthio; acyloxy, such as acetyloxy, benzoyloxy, octadecanoyloxy, p-dodecylamidobenzoyloxy, N-phenylcarbamoyloxy, N-ethylcarbamoyloxy, and cyclohexylcarbonyloxy; amine, such as phenylanilino, 2-chloroanilino, diethylamine, dodecylamine; imino, such as

1 (N-phenylimido)ethyl, N-succinimido or 3-benzylhydantoinyl; phosphate, such as dimethylphosphate and ethylbutylphosphate; phosphite, such as diethyl and dihexylphosphite; a heterocyclic group, a heterocyclic oxy group or a heterocyclic thio group, each of which may be substituted and which contain a 3 to 7 membered heterocyclic ring composed of carbon atoms and at least one hetero atom selected from the group consisting of oxygen, nitrogen, sulfur, phosphorous, or boron. such as 2-furyl, 2-thienyl, 2-benzimidazolyloxy or 2-benzothiazolyl; quaternary ammonium, such as triethylammonium; quaternary phosphonium, such as triphenylphosphonium; and silyloxy, such as trimethylsilyloxy.

If desired, the substituents may themselves be further substituted one or more times with the described substituent groups. The particular substituents used may be selected by those skilled in the art to attain the desired desirable properties for a specific application and can include, for example, electron-withdrawing groups, electron-donating groups, and steric groups. When a molecule may have two or more substituents, the substituents may be joined together to form a ring such as a fused ring unless otherwise provided. Generally, the above groups and substituents thereof may include those having up to 48 carbon atoms, typically 1 to 36 carbon atoms and usually less than 24 carbon atoms, but greater numbers are possible depending on the particular substituents selected.

It is well within the skill of the art to determine whether a particular group is electron donating or electron accepting. The most common measure of electron donating and accepting properties is in terms of Hammett $\sigma$ values. Hydrogen has a Hammett $\sigma$ value of zero, while electron donating groups have negative Hammett $\sigma$ values and electron accepting groups have positive Hammett $\sigma$ values. Lange's handbook of Chemistry, 12th Ed., McGraw Hill, 1979, Table 3-12, pp. 3-134 to 3-138, here incorporated by reference, lists Hammett $\sigma$ values for a large number of commonly encountered groups. Hammett $\sigma$ values are assigned based on phenyl ring substitution, but they provide a practical guide for qualitatively selecting electron donating and accepting groups.

Suitable electron donating groups may be selected from -R', -OR', and -NR'(R") where R' is a hydrocarbon containing up to 6 carbon atoms and R" is hydrogen or R'. Specific examples of electron donating groups include methyl, ethyl, phenyl, methoxy, ethoxy, phenoxy, $-N(CH_3)_2$, $-N(CH_2CH_3)_2$, $-NHCH_3$, - $N(C_6H_5)_2$, $-N(CH_3)(C_6H_5)$, and $-NHC_6H_5$.

Suitable electron accepting groups may be selected from the group consisting of cyano, $\alpha$-haloalkyl, $\alpha$-haloalkoxy, amido, sulfonyl, carbonyl, carbonyloxy and oxycarbonyl substituents containing up to 10 carbon atoms. Specific examples include -CN, -F, $-CF_3$, $-OCF_3$, $-CONHC_6H_5$, $-SO_2C_6H_5$, - $COC_6H_5$, $-CO_2C_6H_5$, and $-OCOC_6H_5$.

The invention and its advantages can be better appreciated by the following examples of device structures that provide high luminous efficiency.

<u>Explanative Device Examples 1-1 to 1-4</u>

Devices 1-1 to 1-4 are not inventive nor comparable but are designed to illustrate the principles of this invention in a simple format. An explanative EL device (Device 1-1) was constructed in the following manner:

1. A glass substrate, coated with an approximately 25 nm layer of indium-tin oxide (ITO) as the anode, was sequentially ultrasonicated in a commercial detergent, rinsed in deionized water and exposed to an oxygen plasma for about 1 minute.
2. Over the ITO a 1 nm fluorocarbon ($CF_x$) hole injecting layer (HIL) was deposited by plasma-assisted deposition of $CHF_3$ as described in US6208075.
3. Next, a hole transporting layer (HTL) of *N,N*'-di-1-naphthyl-*N,N*'-diphenyl-4,4'-diaminobiphenyl (NPB) was vacuum deposited to a thickness of 95 nm.
4. A 20 nm light emitting layer consisting of a mixture of Host-1 as the host, and Emitter-1 as a blue fluorescent emitter present at concentration of 1 wt. % relative to the host was then vacuum deposited onto the HTL.
5. A spacer layer consisting of 2-phenyl-9,10-di-(2-napthyl)anthracene (PDNA) was vacuum deposited to a thickness of 30 nm.
6. An electron transporting layer (ETL) of 4,7-diphenyl-1,10-phenanthroline (Bphen) having a thickness of 10 nm was vacuum deposited over the spacer layer.
7. 0.5 nm of lithium fluoride was vacuum deposited onto the ETL, followed by a 100 nm layer of aluminum, to form a bilayer cathode.

The above sequence completed the deposition of the EL device. Therefore, Device 1-1 had the following structure of layers: ITO | NPB (95nm) | Host-1+1% Emitter-1 (20nm) | PDNA (30nm) | Bphen (10nm) | LiF:A1. The device, together with a desiccant, was then hermetically packaged in a dry glove box for protection against ambient environment.

For Device 1-1, the luminance yield was 2.71 cd/A at 1mA/$cm^2$, with CIE (x,y) of (0.142, 0.124) and EQE (external quantum efficiency) of 2.59%.

Explanative devices 1-2 to 1-4 were prepared in the same manner as Device 1-1 using the following materials and thicknesses:

Device 1-2: ITO | NPB (95nm) | TCTA (10nm) Host-1+1% Emitter-1 (20nm) | Bphen (40nm) | LiF:A1. At 1mA/$cm^2$, the luminance yield was 5.24 cd/A with CIE (x,y) of (0.139, 0.120) and EQE of 5.11%.

Device 1-3: ITO | NPB (85nm) | TCTA (5nm) | Host-2+1% Emitter-1 (20nm) | Bphen (40nm) | LiF:A1. At 1mA/$cm^2$, the luminance yield was 7.10 cd/A with CIE (x,y) of (0.144, 0.130) and EQE of 6.41%.

Device 1-4: ITO | NPB (85nm) | TCTA (10nm) | Host-2+1% Emitter-1 (5nm) | Host-2 (50nm) | Bphen (50nm) | LiF: A1. At 1mA/$cm^2$, the luminance yield was 6.88 cd/A with CIE (x,y) of (0.143, 0.130) and EQE of 6.24%.

Device 1-1 shows that Host-1 sensitizes Emitter-1. Device 1-2 shows that the device efficiency is nearly doubled by interposing between the first hole transport layer and the emissive layer a second hole transport material having a lower HOMO level (-5.43 vs -5.19) than the first hole transport material and having a LUMO above that of the emissive layer host (-1.88 vs -2.41).

Devices 1-3 and 1-4 show further variations on the device structure similar to device 1-2 but using Host-2. The EQE obtained with device 1-3 is among the highest known for deep blue fluorescent OLEDs. Device 1-4 having an undoped layer of Host-2 disposed between the doped layer of Host-2 and the electron transporting layer of Bphen showed emission only from the Emitter- and not the Host-2, suggesting that the recombination occurred at or near the interface of the second hole transport layer (TCTA) and emissive layer of Host-2 with Emitter-1.

<u>Inventive Device Examples 1-5. 1-6 and 1-9 and Comparative Devices 1-7 and 1-8</u>

Hybrid fluorescent/phosphorescent devices according to the invention are provided in the following devices 1-5 and 1-6 wherein a phosphorescent emissive layer according to the invention is inserted into device structures similar to that of device 1-4 using the following materials and thicknesses:

Device 1-5: ITO | NPB (75nm) | TCTA (10nm) | Host-2+1% Emitter-1 (2.5nm) | Host-2 (5nm) | Host-2+8% $Ir(1-piq)_3$ (20nm) | Bphen (22.5nm) | LiF:A1.

Device 1-6: ITO | NPB (75nm) | TCTA (10nm) | Host-1+1% Emitter-1 (5nm) | Host-2 (5nm) | Host-2+8% $Ir(1-piq)_3$ (20nm) | Bphen (20nm) | LiF:A1.

The EL spectrum of the Example 1-5 device exhibited the spectrum of both Emitter-1 and the red phosphorescent $Ir(piq)_3$ emitter. The minimum in emission intensity in the region between the emission peaks of the two emitters was found to be at 568 nm. At 1 mA/$cm^2$, the luminous efficiency was 11 cd/A with CIE (x,y) of (0.264, 0.179). The EQE for the blue (fluorescent) and red (phosphorescent) components of the EL were estimated by computing the EQE for the portion of the wavelengths less than 568 nm and for the portion greater than 568 nm, respectively. The results at several current densities for 1-5 and 1-6 are shown in Tables 1 and 2.

**Table 1. Blue (<568 nm) and red (>568 nm) external quantum efficiencies as a function of current density in the hybrid device 1-5.**

| Current density (mA/cm2) | Blue EQE (% p/e) | Red EQE (% p/e) | Total EQE (% p/e) |
|---|---|---|---|
| 0.01 | 5.9 | 7.8 | 13.6 |
| 0.1 | 5.7 | 6.8 | 12.5 |
| 1 | 5.5 | 5.7 | 11.2 |
| 10 | 4.9 | 3.7 | 8.6 |

**Table 2. Blue (<568 nm) and red (>568 nm) external quantum efficiencies as a function of current density in the hybrid device 1-6:**

| Current density (mA/cm2) | Blue EQE (% p/e) | Red EQE (% p/e) | Total EQE (% p/e) |
|---|---|---|---|
| 0.01 | 6.0 | 7.3 | 13.3 |
| 0.1 | 5.6 | 6.3 | 11.9 |
| 1 | 5.1 | 5.6 | 10.7 |
| 10 | 4.5 | 4.3 | 8.7 |

Device 1-7: ITO | NPB (95nm) | TCTA (10nm) | Host-2+1% Emitter-1 1 (2.5m) | Host-2+8% Ir(1-piq)$_3$ (20nm) | Bphen (40nm) | LiF:Al.

This comparative device is similar to device 1-5, except the spacer layer was omitted and the thickness of the first hole transport layer and the electron transport layer were varied. At 1 mA/cm$^2$, the luminous efficiency was 11 cd/A with CIE (x,y) of (0.404, 0.278). The EQE for the blue (fluorescent) and red (phosphorescent) components of the EL were estimated by computing the EQE for the portion of the spectrum less than 568 nm and for the portion greater than 568 nm, respectively. The results at several current densities are shown in Table 3.

**Table 3. Blue (<568 nm) and red (>568 nm) external quantum efficiencies as a function of current density in the hybrid device 1-7.**

| Current density (mA/cm$^2$) | Blue EQE (% p/e) | Red EQE (% p/e) | Total EQE (% p/e) |
|---|---|---|---|
| 0.01 | 0.4 | 11.5 | 11.8 |
| 0.1 | 0.4 | 11.1 | 11.5 |
| 1 | 0.5 | 10.6 | 11.1 |
| 10 | 0.6 | 9.3 | 9.9 |

Without being limited by any particular theory, this comparative example shows that with lack of sufficient spacer between the blue fluorescent emissive layer and the red phosphorescent layer, mainly red but very little blue emission is observed.

Device 1-8: ITO | NPB (75nm) | TCTA (10nm) | Host-2+5% Emitter-2 (2.5nm) | Host-2 (5nm) | Host-2+8% Ir(1-piq)$_3$ (20nm) | Bphen (22.5nm) | LiF:Al.

This comparative device is similar to device 1-5, except the blue fluorescent Emitter-1 was substituted by Emitter-2 having triplet energy more than 0.2 eV below that of Host-2. A concentration of 5% was used for Emitter-2, a more typical level required for best performance with this type of emitter. At 1 mA/cm$^2$, the luminous efficiency was 6.99 cd/A with CIE (x,y) of (0.168, 0.198). The EQE for the blue (fluorescent) and red (phosphorescent) components of the EL were estimated by computing the EQE for the portion of the spectrum less than 568 nm and for the portion greater than 568 nm, respectively. The results at several current densities are shown in Table 4.

**Table 4. Blue (<568 nm) and red (>568 nm) external quantum efficiencies as a function of current density in the comparartive hybrid device 1-8.**

| Current density (mA/cm2) | Blue EQE (% p/e) | Red EQE (% p/e) | Total EQE (% p/e) |
|---|---|---|---|
| 0.01 | 3.9 | 1.0 | 4.9 |
| 0.1 | 4.2 | 0.8 | 4.9 |
| 1 | 4.3 | 0.7 | 5.0 |
| 10 | 3.7 | 0.6 | 4.2 |

This comparative example employing the blue fluorescent emitter having a low triplet energy results in blue emission, but very little emission from the red phosphorescent emitter. Without being limited by any particular theory, this observation is consistent with the triplet excitons produced by the recombination being deeply trapped by the fluorescent emitter having a triplet energy more than 0.2 eV below that of its host.

Device Examples 2-1 through 2-3:

An EL device (Device 2-1) satisfying the requirements of the invention was constructed in the following manner:

1. A glass substrate, coated with an approximately 25 nm layer of indium-tin oxide (ITO) as the anode, was sequentially ultrasonicated in a commercial detergent, rinsed in deionized water and exposed to an oxygen plasma for about 1 minute.
2. Over the ITO a 1 nm fluorocarbon ($CF_x$) hole injecting layer (HIL) was deposited by plasma-assisted deposition of $CHF_3$ as described in US6208075.
3. Next, a hole transporting layer (HTL) of *N,N'*-di-1-naphthyl-*N,N'*-diphenyl-4,4'-diaminobiphenyl (NPB) was vacuum deposited to a thickness of 75 nm.

4. An exciton/electron blocking layer (EBL) of 4,4',4"-tris(carbazolyl)-triphenylamine (TCTA) was vacuum deposited to a thickness of 10 nm.
5. A 10 nm light emitting layer (LEL 1) consisting of a mixture of Host-3 as the host, and Emitter-1 as a blue fluorescent emitter present at concentration of 1 wt. % relative to the host was then vacuum deposited onto the exciton blocking layer.
6. A spacer layer of undoped Host-3 having a thickness of 8 nm was vacuum deposited over the LEL.
7. Next, a 10 nm light emitting layer (LEL 2) consisting of a mixture of Host-2 as the host, and $Ir(piq)_3$ as a red phosphorescent emitter present at concentration of 8 wt. % was vacuum deposited onto the buffer layer.
8. An electron transporting layer (ETL) of 4,7-diphenyl-1,10-phenanthroline (Bphen) having a thickness of 32 nm was vacuum deposited over the LEL 2.
9. 0.5 nm of lithium fluoride was vacuum deposited onto the EIL, followed by a 100 nm layer of aluminum, to form a bilayer cathode.

The above sequence completed the deposition of the EL device. Therefore, Device 2-1 had the following structure of layers: ITO | $CF_x$ (1 nm) | NPB (75 nm) | TCTA (10 nm) | Host-3+1% Emitter-1 (10 nm) | Host-3 (8 nm) | Host-2+8 % $Ir(piq)_3$ (10 nm) | Bphen (32 nm) | LiF:Al. The device, together with a desiccant, was then hermetically packaged in a dry glove box for protection against ambient environment.

A comparative EL device (Device 2-2) not satisfying the requirements of the invention was fabricated in an identical manner to Device 2-1 except that the exciton/electron blocking layer of TCTA, the spacer layer and LEL 2 were not included in the device structure. The ETL layer consisting of Bphen was vacuum deposited to a thickness of 50 nm. Thus, Device 2-2 had the following structure of layers: ITO | $CF_x$ (1 nm) | NPB (85 nm) | Host-3+1% Emitter-1 (10 nm) | Bphen (50 nm) | LiF:Al.

A comparative EL device (Device 2-3) not satisfying the requirements of the invention was fabricated in an identical manner to Device 2-1 except that the spacer layer and LEL 2 were omitted. The Device 2-3 had the following structure of layers: ITO | $CF_x$ (1 nm) | NPB (75 nm) | TCTA (10 nm) | Host-3+1% Emitter-1 (10 nm) | Bphen (50 nm) | LiF:Al.

The devices thus formed were tested for efficiency and color at an operating current density of 1 $mA/cm^2$ and the results are reported in Table 6 in the form of luminous yield (cd/A), voltage (V), power efficiency (1m/W), external quantum efficiency (%), and CIE (Commission Internationale de l'Eclairage) coordinates.

**Table 6. Evaluation results for Devices 2-1 through 2-3.**

| Device | Example | Voltage, V | Luminous yield, cd/a | Power efficiency, 1m/W | EQE, % | CIEx; CIEy |
|---|---|---|---|---|---|---|
| 2-1 | invention | 4.3 | 10.4 | 7.6 | 9.7 | 0.247; 0.194 |
| 2-2 | comparison | 3.3 | 4.6 | 4.4 | 3.2 | 0.155; 0.178 |
| 2-3 | comparison | 3.7 | 6.1 | 5.2 | 5.5 | 0.139; 0.136 |

The EL spectrum of the Example 2-1 device exhibited the spectrum of both Emitter-1 and the red phosphorescent $Ir(piq)_3$ emitter. The minimum in emission intensity in the region between the emission peaks of the two emitters was found to be at 568 nm. The EQE for the blue (fluorescent) and red (phosphorescent) components of the EL were estimated by computing the EQE for the portion of the wavelengths less than 568 nm and for the portion greater than 568 nm, respectively. The results at several current densities for device 2-1 are shown in Table 7.

**Table 7. Blue (<568 nm) and red (>568 nm) external quantum efficiencies as a function of current density in the hybrid device 2-1.**

| Current density (mA/cm2) | Blue EQE (% p/e) | Red EQE (% p/e) | Total EQE (% p/e) |
|---|---|---|---|
| 0.01 | 3.8 | 4.1 | 7.9 |
| 0.1 | 4.4 | 4.3 | 8.7 |
| 1 | 5.4 | 4.3 | 9.7 |
| 10 | 5.6 | 2.8 | 8.4 |

Table 8 shows external quantum efficiencies observed from devices 2-1 through 2-3. **Table 8. EQE for devices 2-1 through 2-3 at 1 mA/cm$^2$**

| Device | Example | Total EQE (% p/e) | Blue EQE (<568 nm) | Red EQE (>568nm) |
|---|---|---|---|---|
| 2-1 | invention | 9.7 | 5.4 | 4.3 |
| 2-2 | comparison | 3.2 | 3.0 | 0.2 |
| 2-3 | comparison | 5.5 | 5.3 | 0.1 |

As can be seen from Table 8, inventive device 2-1 demonstrates both blue and red emission. Comparative device 2-3 shows blue emission with EQE of 5.3 % in the blue range of the spectrum. Inventive device 2-1 includes an additional light emitting layer (LEL 2) with red phosphorescent emitter compared to the structure of 2-3. Obtained data show that device 2-1 exhibits 5.4 % EQE of blue emission and 4.3 % of red emission. Thus, devices 2-1 and 2-3 have nearly identical quantum efficiency of the blue component of electroluminescence. The data indicates that the addition of the red layer in device 2-1 did not diminish the blue emission of that device relative to device 2-3. This clearly demonstrates the efficient use of triplet excitons as red emission without affecting utilization of the singlet excitons for blue emission for a device of the invention.

<u>Device Examples 3-1 through 3-2:</u>

An EL device (Device 3-1) satisfying the requirements of the invention was constructed in the following manner:

1. A glass substrate, coated with an approximately 25 nm layer of indium-tin oxide (ITO) as the anode, was sequentially ultrasonicated in a commercial detergent, rinsed in deionized water and exposed to an oxygen plasma for about 1 minute.
2. Over the ITO a 1 nm fluorocarbon ($CF_x$) hole injecting layer (HIL) was deposited by plasma-assisted deposition of $CHF_3$ as described in US6208075.
3. Next, a hole transporting layer (HTL) of NPB was vacuum deposited to a thickness of 75 nm.
4. An exciton/electron blocking layer (EBL) of TCTA was vacuum deposited to a thickness of 10 nm.
8. A 5 nm light emitting layer (LEL 1) consisting of a mixture of Host -2 as the host, and Emitter-1 as a blue fluorescent emitter present at concentration of 1.5 wt. % was then vacuum deposited onto the exciton blocking layer.
9. A spacer layer of undoped Host-3 having a thickness of 5 nm was vacuum deposited over the LEL.
10. Next, a 10 nm light emitting layer (LEL 2) consisting of a mixture of Host-3 as the host and $Ir(piq)_3$ as a red phosphorescent emitter present at concentration of 8 wt. % was vacuum deposited onto the buffer layer.
8. An ETL of Bphen having a thickness of 45 nm was vacuum deposited over the LEL 2.
9. 0.5 nm of lithium fluoride was vacuum deposited onto the EIL, followed by a 100 nm layer of aluminum, to form a bilayer cathode.

The above sequence completed the deposition of the EL device. Therefore, Device 3-1 had the following structure of layers: ITO | $CF_x$ (1 nm) | NPB (75 nm) | TCTA (10 nm) | Host-2 +1.5% Emitter-1 (5 nm) |Host-3 (5 mn) | Host-3 + 8% $Ir(piq)_3$ (10 nm) | Bphen (45 nm) | LiF:Al. The device, together with a desiccant, was then hermetically packaged in a dry glove box for protection against ambient environment.

An EL Device 3-2 satisfying the requirement of invention was fabricated in an identical manner to Device 3-1 except that the ETL was a 35 nm layer of Host-3 followed by 10 nm layer of Bphen. Thus, device 3-2 had the following structure of the layers: ITO | $CF_x$ (1nm) | NPB (75 nm) | TCTA (10 nm) | Host-2 +1.5% Emitter-1 (5 nm) | Host-3 (5 nm) | Host-3 + 8% $Ir(piq)_3$ (10 nm) | Host-3 (35 nm) | Bphen (10 nm) | LiF|Al.

The devices thus formed were tested for efficiency and color at an operating current density of 1 mA/cm$^2$ and the results are reported in Table 9 in the form of luminous yield (cd/A), voltage (V), power efficiency (1m/W), external quantum efficiency (%), and CIE (Commission Internationale de l'Eclairage) coordinates.

**Table 9. Evaluation results for Devices 3-1 through 3-2.**

| Device | Example | Voltage, V | Luminous yield, cd/a | Power efficiency, 1m/W | EQE, % | CIEx; CIEy |
|---|---|---|---|---|---|---|
| 3-1 | invention | 3.5 | 9.1 | 8.2 | 9.5 | 0.328; 0.212 |
| 3-2 | invention | 3.3 | 8.8 | 8.4 | 9.3 | 0.317; 0.204 |

The EL spectra of the Examples 3-1 and 3-2 exhibited the spectra of both Emitter-1 and the red phosphorescent $Ir(piq)_3$ emitter. The minimum in emission intensity in the region between the emission peaks of the two emitters was found to be at 568 nm. The EQE for the blue (fluorescent) and red (phosphorescent) components of the EL were estimated by computing the EQE for the portion of the wavelengths less than 568 nm and for the portion greater than 568 nm, respectively. The results at several current densities for devices 3-1 and 3-2 are shown in Tables 10 and 11, respectively.

**Table 10. Blue (<568 nm) and red (>568 nm) external quantum efficiencies as a function of current density in the hybrid device 3-1.**

| Current density (mA/cm2) | Blue EQE (% p/e) | Red EQE (% p/e) | Total EQE (% p/e) |
|---|---|---|---|
| 0.01 | 3.8 | 8.5 | 12.2 |
| 0.1 | 3.5 | 7.2 | 10.7 |
| 1 | 3.4 | 6.1 | 9.5 |
| 10 | 3.1 | 4.9 | 8.0 |

**Table 11. Blue (<568 nm) and red (>568 nm) external quantum efficiencies as a function of current density in the hybrid device 3-2.**

| Current density (mA/cm2) | Blue EQE (% p/e) | Red EQE (% p/e) | Total EQE (% p/e) |
|---|---|---|---|
| 0.01 | 3.2 | 7.4 | 10.6 |
| 0.1 | 3.5 | 7.3 | 10.8 |
| 1 | 3.4 | 5.8 | 9.3 |
| 10 | 3.2 | 4.0 | 7.2 |

<u>Device Examples 4-1 through 4-4:</u>

An EL device (Device 4-1) satisfying the requirements of the invention was constructed in the following manner:

1. A glass substrate, coated with an approximately 25 nm layer of indium-tin oxide (ITO) as the anode, was sequentially ultrasonicated in a commercial detergent, rinsed in deionized water and exposed to an oxygen plasma for about 1 minute.
2. Over the ITO a 1 nm fluorocarbon ($CF_x$) hole injecting layer (HIL) was deposited by plasma-assisted deposition of $CHF_3$ as described in US6208075.
3. Next, an n-type doped ETL of Bphen doped with 1.5 wt % metal lithium was deposited to a thickness of 30 nm followed by a 30 nm layer of undoped Bphen, to form a bilayer ETL.
4. Then, a buffer layer of Host-3 was vacuum deposited to a thickness of 10 nm.
5. A 10 nm light emitting layer (LEL 1) consisting of a mixture of Host-3 as the host, and $Ir(piq)_3$ as a red phosphorescent emitter present at concentration of 4 wt. % was then vacuum deposited onto the buffer layer.
6. A spacer layer of undoped Host-3 was vacuum deposited to a thickness of 5 nm.
7. A 5 nm light emitting layer (LEL 2) consisting of a mixture of Host-3 as the host and Emitter-1 as a blue fluorescent emitter present at concentration of 1.5 wt. % was then vacuum deposited onto the buffer layer.
8. An exciton/electron blocking layer (EBL) of TCTA was vacuum deposited to a thickness of 10 nm.
9. Next, a 45 nm hole transporting layer (HTL) of NPB was vacuum deposited onto the EBL.
10. Another hole injecting layer (HIL2) of Dipyrazino[2,3-f:2',3'-h]quinoxalinehexacarbonitrile (DQHC) was vacuum deposited to a thickness of 10 nm.
11. 100 nm of aluminum was vacuum deposited onto the HIL2, to form a cathode.

The above sequence completed the deposition of the EL device. Device 3-1 had the following structure: ITO | $CF_x$ (1 nm) | Bphen+1.5% Li (30 nm) | Bphen(30 nm) | Host-3(10 nm) | Host-3+4% $Ir(piq)_3$ (10 nm) | Host-3 (5 nm) | Host-3+1.5% Emitter-1 | (5mn) | TCTA (10 nm) | NPB (45 nm) | DQHC (10 nm) | Al (100 nm). The device, together with a desiccant, was then hermetically packaged in a dry glove box for protection against ambient environment.

An EL device (Device 4-2) not satisfying the requirements of the invention was fabricated in an identical manner to Device 4-1 except that the red phosphorescent emitter $Ir(piq)_3$ was not included in the LEL 1. Thus, device 4-2 has

the following structure: ITO | $CF_x$ (1 nm) | Bphen+1.5% Li (30 nm) | Bphen (30 nm) | Host-3 (10 nm) | Host-3 (10 nm) | Host-3 (5 nm) | Host-3+1.5% Emitter-1 (5nm) | TCTA (10 nm) | NPB (45 nm) | DQHC (10 nm) | A1 (100 nm).

An EL device (Device 4-3) satisfying the requirements of the invention was fabricated in an identical manner to Device 4-1 except that Host-2 was used as a host for blue fluorescent emitter in place of Host-3 in LEL 2. Thus, Device 4-3 had the following structure of layers: ITO | $CF_x$ (1 nm) | Bphen+1.5% Li (30 nm) | Bphen (30 nm) | Host-3 (10 nm) | Host-3+4% $Ir(piq)_3$ (10 nm) | Host-3 (5 nm) | Host-2+1.5% Emitter-1 (5nm) | TCTA (10 nm) | NPB (45 nm) | DQHC (10 nm) | A1 (100 nm).

An EL device (Device 4-4) not satisfying the requirements of the invention was fabricated in an identical manner to Device 4-1 except that Host-2 was used as a host for blue fluorescent emitter in place of Host-3 in LEL 2, and $Ir(piq)_3$ was not included in the LEL 1. Device 4-4 had the following structure of layers: ITO | $CF_x$ (1 nm) | Bphen+1.5% Li (30 nm) | Bphen(30 nm) Host-3 (10 nm) | Host-3 (10 nm) | Host-3 (5 nm) | Host-2 +1.5% Emitter-1 (5nm) | TCTA (10 nm) | NPB (45 nm) | DQHC (10 nm) | A1 (100 nm).

The devices thus formed were tested for efficiency and color at an operating current density of 1 $mA/cm^2$ and the results are reported in Table 12 in the form of luminous yield (cd/A), voltage (V), power efficiency (1m/W), and CIE (Commission Internationale de l'Eclairage) coordinates.

**Table 12. Evaluation results for Devices 4-1 through 4-4.**

| Device | Example | Voltage, V | Luminous yield, cd/a | Power efficiency, 1m/W | EQE, % | CIEx; CIEy |
|---|---|---|---|---|---|---|
| 4-1 | invention | 4.8 | 8.0 | 5.2 | 8.5 | 0.307; 0.189 |
| 4-2 | comparison | 4.5 | 3.6 | 2.5 | 3.3 | 0.143; 0.127 |
| 4-3 | invention | 4.9 | 8.6 | 5.5 | 9.3 | 0.346; 0.202 |
| 4-4 | comparison | 3.3 | 3.6 | 3.4 | 3.4 | 0.143; 0.121 |

**Table 13. EQE for devices 4-1 through 4-4 at 1 $mA/cm^2$**

| Device | Example | Total EQE (% p/e) | Blue EQE (<568 nm) | Red EQE (>568nm) |
|---|---|---|---|---|
| 4-1 | invention | 8.5 | 3.3 | 5.2 |
| 4-2 | comparison | 3.3 | 3.2 | 0.1 |
| 4-3 | invention | 9.3 | 3.0 | 6.4 |
| 4-4 | comparison | 3.4 | 3.4 | 0.0 |

Devices 4-1 through 4-4 are inverted bottom-emitting OLEDs. As can be seen from Table 13, inventive devices 4-1 demonstrates both blue and red emission. Comparative device 4-2 shows only blue emission with EQE of 3.2 % in the blue range of the spectrum. Thus, devices 4-1 and 4-2 have nearly identical quantum efficiency of the blue component of electroluminescence. The data indicates that the addition of the phosphorescent emitter into the red layer in device 4-1 did not diminish the blue emission of that device relative to device 4-2. Inventive device 4-3 and comparative device 4-4 show very similar efficiency of the blue component of electroluminescence as well. This clearly demonstrates the efficient use of triplet excitons as red emission without affecting utilization of the singlet excitons for blue emission for a device of the invention.

<u>Device Examples 5-1 through 5-4:</u>

An EL device (Device 5-1) satisfying the requirements of the invention was constructed in the following manner:

1. A glass substrate, coated with an approximately 25 nm layer of indium-tin oxide (ITO) as the anode, was sequentially ultrasonicated in a commercial detergent, rinsed in deionized water and exposed to an oxygen plasma for about 1 minute.
2. Over the ITO a 1 nm fluorocarbon ($CF_x$) hole injecting layer (HIL 1) was deposited by plasma-assisted deposition of $CHF_3$ as described in US6208075.
3. Another hole injecting layer (HIL 2) of Dipyrazino[2,3-f:2',3'-h]quinoxalinehexacarbonitrile (DQHC) was vacuum deposited to a thickness of 10 nm.
4. Next, a hole transporting layer (HTL) of NPB was vacuum deposited to a thickness of 75 nm.

5. A 15 nm light emitting layer (LEL 1) consisting of a mixture of NPB and 6 wt. % $Ir(piq)_3$ was deposited next onto the HTL.
6. A spacer layer of undoped NPB was deposited to a thickness of 5 nm.
7. Next, a blue light emitting layer (LEL 2) consisting of a mixture of TCTA as host and 1.5 wt.% Emitter-1 was vacuum deposited to a thickness of 10 nm.
8. A 5 nm blue light emitting layer (LEL 3) consisting of a mixture of Host-2 as the host, and Emitter-1 as a blue fluorescent emitter present at concentration of 1.5 wt. % relative to the host was then vacuum deposited onto the LEL1 layer.
9. A spacer layer of undoped Host-2 having a thickness of 5 nm was vacuum deposited over the LEL 3.
10. A 10 nm light emitting layer (LEL 4) consisting of a mixture of Host-2 as the host, and $Ir(piq)_3$ as a red phosphorescent emitter present at concentration of 8 wt. % was then vacuum deposited onto the buffer layer.
11. A buffer layer of undoped Host-2 having a thickness of 10 nm was vacuum deposited over the LEL 4.
12. Next, an n-type doped ETL of Bphen doped with 1.5 wt % metal lithium was deposited to a thickness of 30 nm followed by 10 nm layer of DQHC to form a "p-n" junction at their contact interface.
13. Next, a HTL of NPB was vacuum deposited to a thickness of 30 nm.
14. A 25 nm light-emitting layer (LEL 5) of CBP with $Ir(ppy)_3$ as a phosphorescent emitter present at 6 wt. % was then deposited onto the HTL.
15. A hole blocking layer ofundoped Bphen having a thickness of 10 nm was then evaporated.
16. An ETL of Bphen doped with 1.5 wt % metal lithium was deposited to a thickness of 30 nm followed by deposition of 100 nm of aluminum cathode.

The above sequence completed the deposition of the EL device. Device 5-1 had the following structure: ITO | $CF_x$ | DQHC (10nm) | NPB (75 nm) | NPB+6% $Ir(piq)_3$(15 nm) | NPB(5 nm) | TCTA+1.5% Emitter-1 (10nm) | Host-2+1.5% Emitter-1 (5 nm) | Host-2 (5nm) | Host-2+8%$Ir(piq)_3$ (10nm) | Host-2 (10 nm) | Bphen+1.5% Li (30 nm) | DQHC (10 nm) | NPB (30nm) | CBP+6%$(Irppy)_3$ (25nm) | Bphen (10 nm) | Bphen+1.5%Li (30 nm) | A1 (100 nm).

The device, together with a desiccant, was then hermetically packaged in a dry glove box for protection against ambient environment.

An EL device (Device 5-2) satisfying the requirements of the invention was fabricated in an identical manner to Device 5-1 except that the LEL1 was omitted from device structure. Device 5-2 has the following structure of the layer: ITO | $CF_x$ | DQHC (10nm) | NPB (75 nm) | TCTA+1.5% Emitter-1 (10nm) | Host-2+1.5% Emitter-1 (5 nm) | Host-2 (5nm) | Host-2 + 8% $Ir(piq)_3$ (10nm) | Host-2 (10 nm | Bphen +1.5% Li (30 nm) | DQHC (10 nm) | NPB (30nm) | CBP+ 6% $(Irppy)_3$ (25nm) | Bphen (10 nm) | Bphen+1.5%Li (30 nm) | A1 (100 nm)

The devices thus formed were tested for efficiency and color at an operating current density of 1 $mA/cm^2$ and the results are reported in Table 14 in the form of luminous yield (cd/A), voltage (V), power efficiency (1m/W), external quantum efficiency (%), and CIE (Commission Internationale de l'Eclairage) coordinates.

**Table 14. Evaluation results for Devices 5-1 through 5-2.**

| Device | Example | Voltage, V | Luminous yield, cd/a | Power efficiency, 1m/W | EQE, % | CIEx; CIEy |
|---|---|---|---|---|---|---|
| 5-1 | invention | 9.0 | 19.8 | 6.9 | 9.3 | 0.292; 0.423 |
| 5-2 | invention | 8.8 | 20.9 | 7.5 | 9.1 | 0.312; 0.459 |

White emission in OLEDs devices can be achieved in devices with non-repeat stack architecture. Devices 5-1 and 5-2 include a hybrid blue-red emitting EL units and a green emitting phosphorescent stack. The hybrid blue-red stack of device 5-1 includes 2 blue emitting layers (LEL 2 and LEL 3) placed adjacent to each other and 2 red light emitting layers (LEL 1 and LEL 4) placed to each side of the blue LELs. Device 5-2 has simpler architecture of the hybrid stack; however, it also includes double blue light emitting layers.

<u>Device Examples 6-1 through 6-3:</u>

An EL device (Device 6-1) satisfying the requirements of the invention was constructed in the following manner:

1. A glass substrate, coated with an approximately 25 nm layer of indium-tin oxide (ITO) as the anode, was sequentially ultrasonicated in a commercial detergent, rinsed in deionized water and exposed to an oxygen plasma for about 1 minute.
2. Over the ITO a 1 nm fluorocarbon ($CF_x$) hole injecting layer (HIL 1) was deposited by plasma-assisted deposition of $CHF_3$ as described in US6208075.

3. Another hole injecting layer (HIL 2) of DQHC was vacuum deposited to a thickness of 10 nm.
4. Next, a hole transporting layer (HTL) of NPB was vacuum deposited to a thickness of 75 nm.
5. Next, a blue light emitting layer (LEL 1) consisting of a mixture of TCTA as host and 1 wt.% Emitter-1 was vacuum deposited to a thickness of 10 nm.
6. A 5 nm blue light emitting layer (LEL 2) consisting of a mixture of Host-2 as the host, and Emitter-1 as a blue fluorescent emitter present at concentration of 1 wt. % relative to the host was then vacuum deposited onto the LEL1 layer.
7. A spacer layer of undoped Host-2 having a thickness of 5 nm was vacuum deposited over the LEL 2.
8. A 10 nm light emitting layer (LEL 3) consisting of a mixture of Host-2 as the host, and $Ir(piq)_3$ as a red phosphorescent emitter present at concentration of 8 wt. % was then vacuum deposited onto the buffer layer.
9. A buffer layer of undoped Host-2 having a thickness of 10 nm was vacuum deposited over the LEL 3
10. Next, an n-type doped ETL of Bphen doped with 1 wt % metal lithium was deposited to a thickness of 30 nm followed by 10 nm layer of DQHC to form a "p-n" junction at their contact interface.
11. Next, a HTL of NPB was vacuum deposited to a thickness of 30 nm.
12. An exciton/electron blocking layer of TCTA having a thickness of 10 nm was then evaporated.
13. A 25 nm light emitting layer (LEL 4) consisting of a mixture of TPBI as the electron transporting co-host, TCTA as the hole transporting co-host present at a concentration of 30 wt. % of the total of the co-host materials in the LEL 4, and $Ir(ppy)_3$ as a phosphorescent emitter at a concentration of 6 wt. % relative to the total of the co-host materials was then deposited onto the exciton blocking layer.
14. A buffer layer of undoped TPBI having a thickness of 10 nm was then evaporated.
15. An ETL of Bphen doped with 1 wt % metal lithium was deposited to a thickness of 30 nm followed by deposition of 100 nm of aluminum cathode.

The above sequence completed the deposition of the EL device. Therefore, Device 6-1 has the following structure of layers: ITO | $CF_x$ | DQHC (10nm) | NPB (75 nm) | TCTA+1% Emitter-1 (10nm) | Host-2+1% Emitter-1 (5 nm) | Host-2 (5nm) | Host-2 +8% $Ir(piq)_3$ (10nm) | Host-2 (10 nm) | Bphen+1% Li (30 nm) | DQHC (10 nm) | NPB (30nm) | TPBI+30% TCTA+6% $Ir(ppy)_3$ (25nm) | TPBI (10 nm) | Bphen+1 %Li (30 nm) | A1 (100 nm).

An EL device (Device 6-2) satisfying the requirements of the invention was fabricated in an identical manner to Device 6-1 except that layers 10 through 14 were not deposited. Thus, Device 6-2 has the following structure: ITO | $CF_x$ | DQHC (10nm) | NPB (75 nm) | TCTA+1% Emitter-1 (10nm) | Host-2 +1% Emitter-1 (5 nm) | Host-2 (5nm) | Host-2 +8% $Ir(piq)_3$(10nm) | Host-2 (10 nm) | Bphen+1% Li (30 nm) | Al.

A comparative EL Device 6-3 not satisfying the requirements of the invention was fabricated in an identical manner to Device 6-2 except that the LEL 3 was not deposited. Device 6-3 has the following structure of layers: ITO $CF_x$ | DQHC (10nm) | NPB (75 nm) | TCTA+1% Emitter-1 (10nm) | Host-2+1% Emitter-1 (5 nm) | Host-2 (10 nm) | Bphen +1% Li (40 nm) | Al. The device exhibits blue efficiency only.

The devices thus formed were tested for efficiency and color at an operating current density of 1 $mA/cm^2$ and the results are reported in Table 15 in the form of luminous yield (cd/A), voltage (V), power efficiency (1m/W), external quantum efficiency (%), and CIE (Commission Internationale de l'Eclairage) coordinates.

**Table 15. Evaluation results for Devices 6-1 through 6-3.**

| Device | Example | Voltage, V | Luminous yield, cd/a | Power efficiency, 1m/W | EQE, % | CIEx; CIEy |
|---|---|---|---|---|---|---|
| 6-1 | invention | 8.0 | 49.9 | 19.6 | 18.6 | 0.262; 0.448 |
| 6-2 | invention | 4.2 | 9.4 | 7.0 | 8.7 | 0.273; 0.205 |
| 6-3 | comparison | 3.6 | 5.2 | 4.5 | 4.0 | 0.148; 0.164 |

<u>Device Examples 7-1 through 7-3:</u>

An EL device (Device 7-1 satisfying the requirements of the invention was constructed in the following manner:

1. A glass substrate, coated with an approximately 25 nm layer of indium-tin oxide (ITO) as the anode, was sequentially ultrasonicated in a commercial detergent, rinsed in deionized water and exposed to an oxygen plasma for about 1 minute.
2. Over the ITO a 1 nm fluorocarbon ($CF_x$) hole injecting layer (HIL) was deposited by plasma-assisted deposition of $CHF_3$ as described in US6208075.
3. Next, a hole transporting layer (HTL) of N,N'-di-1-naphthyl-N,N'-diphenyl-4,4'-diaminobiphenyl (NPB) was vacuum

deposited to a thickness of 75 nm.

4. An exciton/electron blocking layer (EBL) of 4,4',4"-tris(carbazolyl)-triphenylamine (TCTA) was vacuum deposited to a thickness of 10 nm.

11. A 10 nm light emitting layer (LEL 1) consisting of a mixture of Host-20 as the host, and Emitter-1 as a blue fluorescent emitter present at concentration of 1.5 wt. % relative to the host was then vacuum deposited onto the exciton blocking layer.

12. A spacer layer of undoped Host-2 having a thickness of 2.5 nm was vacuum deposited over the LEL 1.

13. Next, a 10 nm light emitting layer (LEL 2) consisting of a mixture of Host-2 as the host, and $Ir(piq)_3$ as a red phosphorescent emitter present at concentration of 8wt.% was vacuum deposited onto the buffer layer.

8. An electron transporting layer (ETL) of 4,7-diphenyl-1,10-phenanthroline (Bphen) having a thickness of 40 nm was vacuum deposited over the LEL 2.

9. 0.5 nm of lithium fluoride was vacuum deposited onto the EIL, followed by a 100 nm layer of aluminum, to form a bilayer cathode.

The above sequence completed the deposition of the EL device. Therefore, Device 7-1 had the following structure of layers: ITO | $CF_x$ (1 nm) | NPB (75 nm) | TCTA (10 nm) | Host-20+1.5% Emitter-1 (10 nm) | Host-2 (2.5 nm) | Host-2 + 8 % $Ir(piq)_3$ (10 nm) | Bphen (40 nm) | LiF:Al. The device, together with a desiccant, was then hermetically packaged in a dry glove box for protection against ambient environment.

An inventive device (Device 7-2) satisfying the requirements of the invention was constructed in an identical manner to Device 7-1 except that the blue LEL1 was vacuum deposited to a thickness of 5 nm. The spacer layer consisting of Host-2 was vacuum deposited to a thickness of 5 nm. Hence, Device 7-2 had the following structure of layers: ITO | $CF_x$ (1 nm) | NPB (75 nm) | TCTA (10 nm) | Host-20+1.5% Emitter-1 (5 nm) | Host-2 (5 nm) | Host-2 + 8 % $Ir(piq)_3$ (10 nm) | Bphen (40 nm) | LiF:Al.

A comparative EL device (Device 7-3) not satisfying the requirements of the invention was fabricated in an identical manner to Device 7-1 except that the red phosphorescent emitter was omitted from the LEL 2. The spacer layer consisting of Host-2 was vacuum deposited to a thickness of 5 nm. Thus, Device 7-3 had the following structure of layers: ITO | $CF_x$ (1 nm) | NPB (75 nm) | TCTA (10 nm) | Host-20 +1.5% Emitter-1 (10 nm) | Host-2 (5 nm) | Host-2 (10 nm) | Bphen (40 nm) | LiF:Al

The devices thus formed were tested for efficiency and color at an operating current density of 1 $mA/cm^2$ and the results are reported in Table 16 in the form of luminous yield (cd/A), voltage (V), power efficiency (1m/W), external quantum efficiency (%), and CIE (Commission Internationale de l'Eclairage) coordinates.

**Table 16. Evaluation results for Devices 7-1 through 7-3.**

| Device | Example | Voltage, V | Luminous yield, cd/a | Power efficiency, 1m/W | EQE, % | CIEx; CIEy |
|---|---|---|---|---|---|---|
| 7-1 | invention | 3.7 | 8.2 | 7.0 | 8.4 | 0.246; 0.170 |
| 7-2 | invention | 3.6 | 9.3 | 8.1 | 9.7 | 0.251; 0.168 |
| 7-3 | comparison | 4.1 | 7.1 | 5.4 | 4.8 | 0.157; 0.192 |

The EL spectra of the inventive examples exhibited the spectrum of both Emitter-1 and the red phosphorescent $Ir(piq)_3$ emitter. The minimum in emission intensity in the region between the emission peaks of the two emitters was found to be at 568 nm. The EQE for the blue (fluorescent) and red (phosphorescent) components of the EL were estimated by computing the EQE for the portion of the wavelengths less than 568 nm and for the portion greater than 568 nm, respectively. Table 16 shows external quantum efficiencies observed from devices 7-1 through 7-3.

**Table 17. EQE for Devices 7-1 through 7-2 at 1 $mA/cm^2$**

| Device | Example | Total EQE (% p/e) | Blue EQE (<568 nm) | Red EQE (>568nm) |
|---|---|---|---|---|
| 7-1 | invention | 8.4 | 4.6 | 3.8 |
| 7-2 | invention | 9.7 | 5.2 | 4.6 |
| 7-3 | comparison | 4.8 | 4.6 | 0.2 |

As can be seen from Table 17, inventive device 7-1 demonstrates both blue and red emission. Comparative device 7-3 shows blue emission with EQE of 4.6 % in the blue range of the spectrum. Inventive device 7-1 includes a phosphorescent emitter in light emitting layer (LEL 2) compared to the structure of 7-3. Obtained data show that device

7-1 exhibits 4.6 % EQE of blue emission and 3.8 % of red emission. Thus, devices 7-1 and 7-3 have nearly identical quantum efficiency of the blue component of electroluminescence. This clearly demonstrates the efficient use of triplet excitons as red emission without affecting utilization of the singlet excitons for blue emission for a device of the invention. The obtained spectral data (FIG. 3) show that a green phosphorescent unit may be combined with a blue fluorescent plus red phosphorescent hybrid unit in a stacked OLED architecture with increased blue emission.

**PARTS LIST**

| | |
|---|---|
| **101** | Substrate |
| **103** | Anode |
| **105.1** | Hole Injection Layer 1 |
| **105.2** | Hole Injection Layer 1 |
| **107** | Hole Transport Layer |
| **108** | Exciton Blocking Layer |
| **109** | Fluorescent Light Emitting Layer (LEL) |
| **109.1** | Blue Fluorescent Light Emitting Layer 1 |
| **109.2** | Blue Fluorescent Light Emitting Layer 2 |
| **110** | Spacer Layer |
| **111** | Phosphorescent Light Emitting Layer (LEL) |
| **111.1** | Red Phosphorescent Light Emitting Layer 1 |
| **111.2** | Red Phosphorescent Light Emitting Layer 2 |
| **111.3** | Green Phosphorescent Light Emitting Layer |
| **112** | Electron Transporting Layer |
| **113** | Cathode |
| **150** | Voltage / Current Source |
| **160** | Electrical Connectors |

**Claims**

**1.** An OLED device comprising:

a. a fluorescent light emitting layer comprising at least one blue fluorescent emitter and a host material;
b. a phosphorescent light emitting layer comprising at least one emitter and one host material; and
c. a spacer layer interposed between the fluorescent LEL and the phosphorescent LEL

**characterized in that**, the triplet energy of the fluorescent emitter is greater than or not more than 0.2 eV below the triplet energy of both the spacer material and the phosphorescent host material; and
wherein the triplet energy of the spacer material is greater than or not more than 0.2 eV below that of the phosphorescent host material.

**2.** The OLED device of claim 1 wherein the fluorescent light emitting layer includes a host material and a fluorescent emitter which has a triplet energy that is equal or greater than the spacer material and the phosphorescent host material.

**3.** The OLED device of claim 2 wherein the spacer material is the same as the host material in the fluorescent layer.

**4.** The OLED device of claim 2 wherein the spacer material is the same as the host material in the phosphorescent layer.

**5.** The OLED device of claim 1 wherein the spacer material is chosen from the following:

a) complexes represented by Formula (MCOH-b)

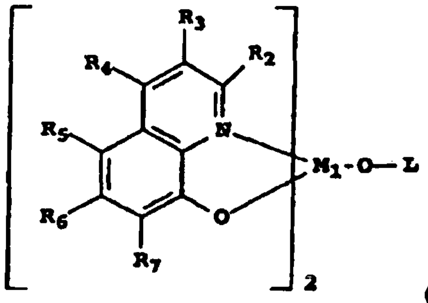

(MCOH-b)

wherein:

$M_1$ represents Al or Ga; and
$R_2$ - $R_7$ represent hydrogen or an independently selected substituent; and
L is an aromatic moiety linked to the aluminum by oxygen, which may be substituted with substituent groups such that L has from 6 to 30 carbon atoms;

b) compounds represented by formula (TADA):

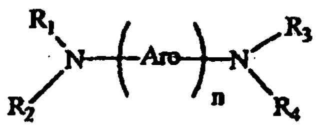

(TADA)

wherein:

Are is an independently selected arylene group; and
n is selected from 1 to 4; and
$R_1$-$R_4$ are independently selected aryl groups; or c) compounds represented by formula (FAH):

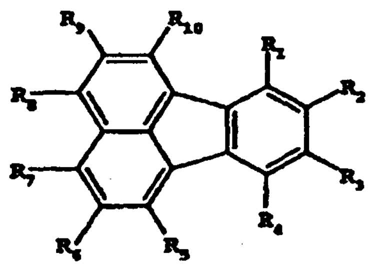

(FAH)

wherein

$R_1$-$R_{10}$ represent one or more substituents on each ring where each substituent is individually selected from the following groups:

Group 1: hydrogen, or alkyl of from 1 to 24 carbon atoms;
Group 2: aryl or substituted aryl of from 5 to 20 carbon atoms;
Group 3: carbon atoms from 4 to 24 necessary to complete a fused or annulated aromatic ring;
Group 4: heteroaryl or substituted heteroaryl of from 5 to 24 carbon atoms as necessary to complete a fused heteroaromatic ring;
Group 5: alkoxylamino, alkylamino, or arylamino of from 1 to 24 carbon atoms; and
Group 6: fluorine, chlorine, bromine or cyano.

**6.** The OLED device of claim 1 wherein the fluorescent light emitter has a triplet energy of 22 eV or greater.

7. An OLED device of claim 1 comprising a light emitting unit consisting of a first phosphorescent emissive layer, which is closest to the anode, a first spacer layer, a fluorescent emissive layer, a second spacer layer, and a second phosphorescent emissive layer, which is closest to the cathode, arrangement.

8. An OLED device of claim 7 wherein the host of the first phosphorescent layer and the material of the first spacer layer are each a hole transporting material and the host of the second phosphorescent layer and the material of the second spacer layer are each an electron transporting material.

9. An OLED device comprising:

a. a fluorescent light emitting layer comprising at least one blue fluorescent emitter and one host material;
b. a phosphorescent light emitting layer comprising at least one phosphorescent emitter and one host material;
c. a spacer layer interposed between the fluorescent LEL and the phosphorescent LEL

**characterized in that**, the triplet energy of the fluorescent host is less than or not more than 0.2 eV greater than that of the fluorescent emitter, and greater than or
not more than 0.2 eV below both the triplet energy of the spacer material, and the phosphorescent host, and wherein the triplet energy of the spacer material is greater than or not more than 0.2 eV below that of the phosphorescent host material.

10. An OLED device of claim 9 wherein the fluorescent emissive layer host, the spacer layer material, and the phosphorescent emitting layer host are each electron-transporting; and
the fluorescent emissive layer contacts a hole transport material on the anode side; and
the spacer layer and phosphorescent light emitting are between the cathode and the fluorescent emissive layer.

## Patentansprüche

1. OLED-Vorrichtung, umfassend:

a. eine fluoreszierendes Licht emittierende Schicht, umfassend mindestens einen blau fluoreszierenden Emitter und ein Basismaterial;
b. eine phosphoreszierendes Licht emittierende Schicht, umfassend mindestens einen Emitter und ein Basismaterial; und
c. eine Abstandsschicht, die zwischen der fluoreszierendes LEL und der phosphoreszierendes LEL eingefügt ist,

**dadurch gekennzeichnet, dass** die Triplet Energie des fluoreszierenden Emitters größer ist als oder nicht mehr als 0,2 eV unterhalb der Triplet Energie von sowohl dem Abstandsmaterial als auch dem phosphoreszierenden Basismaterial ist; und
wobei die Triplet Energie des Abstandsmaterials größer ist als oder nicht mehr als 0,2 eV unterhalb der des phosphoreszierenden Basismaterials ist.

2. OLED-Vorrichtung nach Anspruch 1, wobei die fluoreszierendes Licht emittierende Schicht ein Basismaterial und einen fluoreszierenden Emitter, der eine Triplet Energie aufweist die gleich oder größer ist als das Abstandsmaterial und das phosphoreszierende Basismaterial, einschließt.

3. OLED-Vorrichtung nach Anspruch 2, wobei das Abstandsmaterial das Gleiche ist wie das Basismaterial in der fluoreszierenden Schicht.

4. OLED-Vorrichtung nach Anspruch 2, wobei das Abstandsmaterial das Gleiche ist wie das Basismaterial in der phosphoreszierenden Schicht.

5. OLED-Vorrichtung nach Anspruch 1, wobei das Abstandsmaterial ausgewählt ist aus den Folgenden:

a) Komplexe dargestellt durch die Formel (MCOH-b)

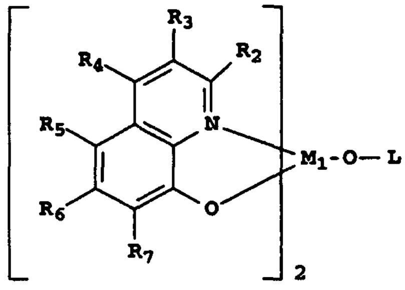

(MCOH-b)

wobei:

$M_1$ Al oder Ga darstellt; und
$R_2$-$R_7$ Wasserstoff oder einen unabhängig ausgewählten Substituenten darstellen; und
L ein aromatischer Rest ist, der mit dem Aluminium durch Sauerstoff verknüpft ist, der so mit Substituentengruppen substituiert sein kann, das L von 6 bis 30 Kohlenstoffatome aufweist;

b) Verbindungen dargestellt durch die Formel (TADA):

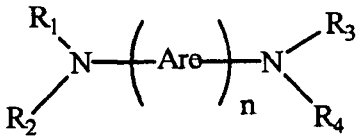

(TADA)

wobei:

Are eine unabhängig ausgewählte Arylengruppe ist; und
n von 1 bis 4 ausgewählt ist; und
$R_1$-$R_4$ unabhängig ausgewählte Arylgruppen sind; oder c) Verbindungen dargestellt durch die Formel (FAH):

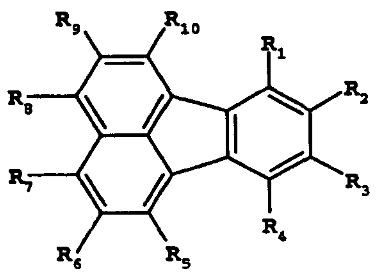

(FAH)

wobei:

$R_1$-$R_{10}$ einen oder mehrere Substituenten auf jedem Ring darstellen, wobei jeder Substituent individuell ausgewählt ist aus den folgenden Gruppen:

Gruppe 1: Wasserstoff, oder Alkyl mit von 1 bis 24 Kohlenstoffatomen;
Gruppe 2: Aryl oder substituiertes Aryl mit von 5 bis 20 Kohlenstoffatomen;
Gruppe 3: Kohlenstoffatome von 4 bis 24, die erforderlich sind einen fusionierten oder anelierten aromatischen Ring zu vervollständigen;
Gruppe 4: Heteroaryl oder substituiertes Heteroaryl mit von 5 bis 24 Kohlenstoffatomen, wie erforderlich um einen fusionierten heteroaromatischen Ring zu vervollständigen;
Gruppe 5: Alkoxylamino, Alkylamino, oder Arylamino mit von 1 bis 24 Kohlenstoffatomen; und
Gruppe 6: Fluor, Chlor, Brom oder Cyano.

6. OLED-Vorrichtung nach Anspruch 1, wobei der fluoreszierende Lichtemitter eine Triplet Energie von 2,2 eV oder größer aufweist.

7. OLED-Vorrichtung nach Anspruch 1, umfassend eine Licht emittierende Einheit, bestehend aus einer ersten phosphoreszierend emissiven Schicht, die am nächsten zu der Anode liegt, einer ersten Abstandsschicht, einer fluoreszierend emissiven Schicht, einer zweiten Abstandsschicht und einer zweiten phosphoreszierend emissiven Schicht, die am nächsten zu der Kathode liegt, Anordnung.

8. OLED-Vorrichtung nach Anspruch 7, wobei die Basis der ersten phosphoreszierenden Schicht und das Material der ersten Abstandsschicht jeweils ein Iochtransportierendes Material sind und die Basis der zweiten phosphoreszierenden Schicht und das Material der zweiten Abstandsschicht jeweils ein elektronentransportierendes Material sind.

9. OLED-Vorrichtung, umfassend:

a. eine fluoreszierendes Licht emittierende Schicht, umfassend mindestens einen blau fluoreszierenden Emitter und ein Basismaterial;
b. eine phosphoreszierendes Licht emittierende Schicht, umfassend mindestens einen phosphoreszierenden Emitter und ein Basismaterial;
c. eine Abstandsschicht, die zwischen der fluoreszierendes LEL und der phosphoreszierendes LEL eingefügt ist,

**dadurch gekennzeichnet, dass** die Triplet Energie der fluoreszierenden Basis kleiner ist als oder nicht mehr als 0,2 eV größer ist als die des fluoreszierenden Emitters, und größer ist als oder nicht mehr als 0,2 eV unterhalb sowohl der Triplet Energie des Abstandsmaterials als auch der der phosphoreszierenden Basis ist, und
wobei die Triplet Energie des Abstandsmaterials größer ist als oder nicht mehr als 0,2 eV unterhalb der des phosphoreszierenden Basismaterials ist.

10. OLED-Vorrichtung nach Anspruch 9, wobei die Basis der fluoreszierend emissiven Schicht, das Abstandsschichtmaterial und die Basis der phosphoreszierend emittierenden Schicht jeweils elektronentransportierend sind; und die fluoreszierend emissive Schicht an ein lochtransportierendes Material auf der Anodenseite anknüpft; und
die Abstandsschicht und die phosphoreszierendes Licht Emittierende zwischen der Kathode und der fluoreszierend emissiven Schicht liegen.

## Revendications

1. Dispositif OLED comprenant :

a. une couche électroluminescente fluorescente comprenant au moins un émetteur fluorescent bleu et un matériau hôte ;
b. une couche électroluminescente phosphorescente comprenant au moins un émetteur et un matériau hôte ; et
c. une couche d'espacement interposée entre la CEL fluorescente et la CEL phosphorescente,

**caractérisé en ce que** l'énergie de triplet de l'émetteur fluorescent est supérieure à ou de pas plus de 0,2 eV inférieure à l'énergie de triplet d'à la fois le matériau d'espacement et le matériau hôte phosphorescent ; et
dans lequel l'énergie de triplet du matériau d'espacement est supérieure à ou de pas plus de 0,2 eV inférieure à celle du matériau hôte phosphorescent.

2. Dispositif OLED selon la revendication 1, dans lequel la couche électroluminescente fluorescente inclut un matériau hôte et un émetteur fluorescent qui a une énergie de triplet qui est égale ou supérieure à celle du matériau d'espacement et du matériau hôte phosphorescent.

3. Dispositif OLED selon la revendication 2, dans lequel le matériau d'espacement est le même que le matériau hôte dans la couche fluorescente.

4. Dispositif OLED selon la revendication 2, dans lequel le matériau d'espacement est le même que le matériau hôte dans la couche phosphorescente.

**5.** Dispositif OLED selon la revendication 1, dans lequel le matériau d'espacement est choisi parmi les suivants :

a) des complexes représentés par la Formule (MCOH-b)

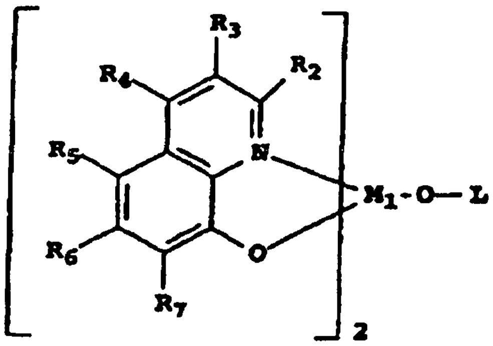

(MCOH-b)

dans laquelle :

$M_1$ représente Al ou Ga ; et
$R_2$-$R_7$ représentent un hydrogène ou un substituant choisi indépendamment ; et
L est un groupe caractéristique aromatique lié à l'aluminium par un oxygène, qui peut être substitué avec des groupes substituants de telle sorte que L a de 6 à 30 atomes de carbone ;

b) des composés représentés par la formule (TADA) :

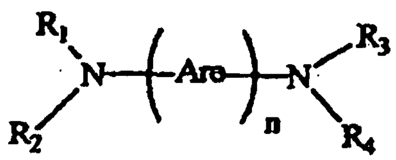

(TADA)

dans laquelle :

Are est un groupe arylène choisi indépendamment ; et
n est choisi parmi 1 à 4 ; et
$R_1$-$R_4$ sont des groupes aryle choisis indépendamment ; ou

c) des composés représentés par la formule (FAH) :

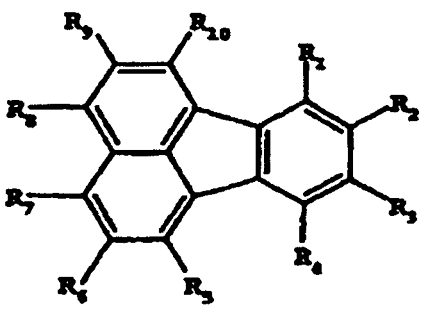

(FAH)

dans laquelle :

$R_1$-$R_{10}$ représentent un ou plusieurs substituant(s) sur chaque noyau, où chaque substituant est individuellement choisi parmi les groupes suivants :

Groupe 1 : un hydrogène, ou un alkyle de 1 à 24 atomes de carbone ;
Groupe 2 : un aryle ou un aryle substitué de 5 à 20 atomes de carbone ;
Groupe 3 : des atomes de carbone de 4 à 24 nécessaires pour réaliser un noyau aromatique fusionné ou annelé ;
Groupe 4 : un hétéroaryle ou un hétéroaryle substitué de 5 à 24 atomes de carbone, tel que nécessaires pour réaliser un noyau hétéroaromatique fusionné ;
Groupe 5 : un alcoxylamino, un alkylamino, ou un arylamino de 1 à 24 atomes de carbone ; et
Groupe 6 : un fluor, un chlore, un brome ou un cyano.

**6.** Dispositif OLED selon la revendication 1, dans lequel l'émetteur de lumière fluorescente a une énergie de triplet de 2,2 eV ou plus.

**7.** Dispositif OLED selon la revendication 1, comprenant une unité électroluminescente consistant en un agencement d'une première couche émissive phosphorescente, qui est la plus proche de l'anode, d'une première couche d'espacement, d'une couche émissive fluorescente, d'une deuxième couche d'espacement et d'une deuxième couche émissive phosphorescente, qui est la plus proche de la cathode.

**8.** Dispositif OLED selon la revendication 7, dans lequel l'hôte de la première couche phosphorescente et le matériau de la première couche d'espacement sont chacun un matériau de transport de trous et l'hôte de la deuxième couche phosphorescente et le matériau de la deuxième couche d'espacement sont chacun un matériau de transport d'électrons.

**9.** Dispositif OLED comprenant :

a. une couche électroluminescente fluorescente comprenant au moins un émetteur fluorescent bleu et un matériau hôte ;
b. une couche électroluminescente phosphorescente comprenant au moins un émetteur phosphorescent et un matériau hôte ;
c. une couche d'espacement interposée entre la CEL fluorescente et la CEL phosphorescente,

**caractérisé en ce que** l'énergie de triplet de l'hôte fluorescent est inférieure à ou de pas plus de 0,2 eV supérieure à celle de l'émetteur fluorescent, et supérieure à ou de pas plus de 0,2 eV inférieure à l'énergie de triplet d'à la fois le matériau d'espacement et l'hôte phosphorescent ; et
dans lequel l'énergie de triplet du matériau d'espacement est supérieure à ou de pas plus de 0,2 eV inférieure à celle du matériau hôte phosphorescent.

**10.** Dispositif OLED selon la revendication 9, dans lequel l'hôte de couche émissive fluorescente, le matériau de couche d'espacement, et l'hôte de couche émissive phosphorescente sont chacun de transport d'électrons ; et
la couche émissive fluorescente est au contact d'un matériau de transport de trous sur le côté d'anode ; et
la couche d'espacement et la couche électroluminescente phosphorescente sont entre la cathode et la couche émissive fluorescente.

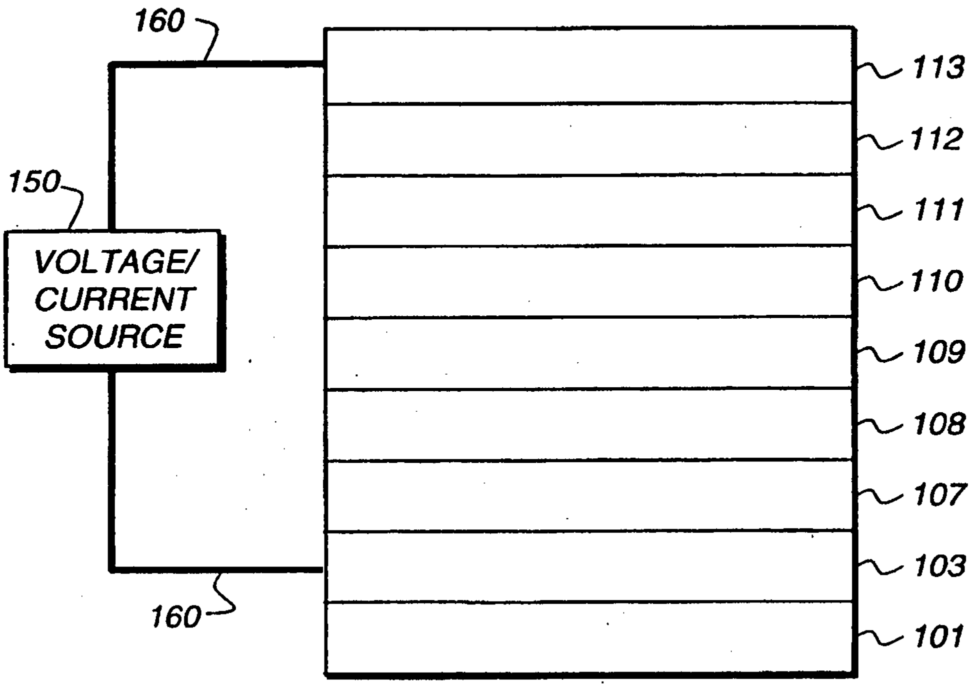
160
150
VOLTAGE/
CURRENT
SOURCE
160
113
112
111
110
109
108
107
103
101

FIG. 1

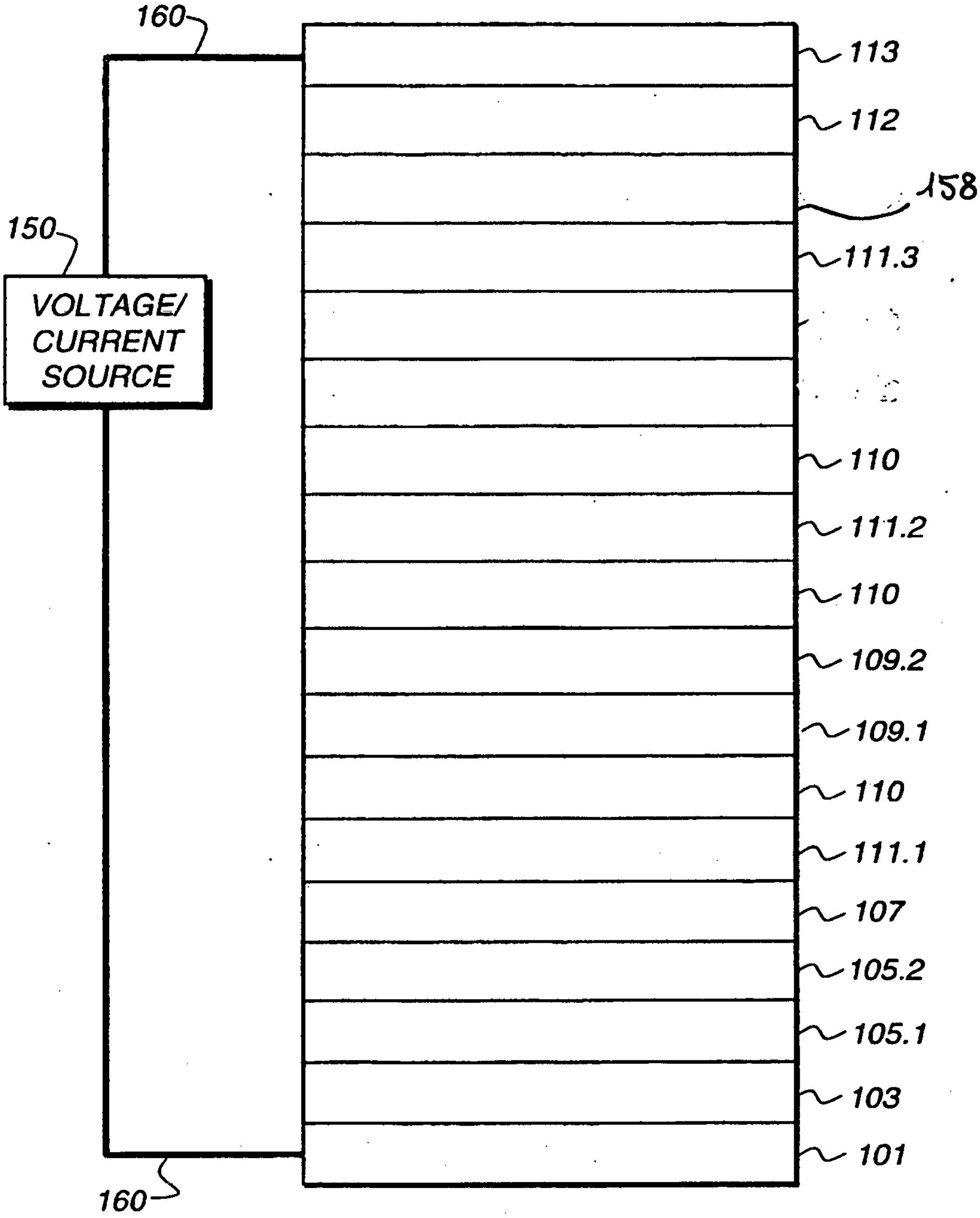
160
150
VOLTAGE/
CURRENT
SOURCE
160
113
112
158
111.3
110
111.2
110
109.2
109.1
110
111.1
107
105.2
105.1
103
101

FIG. 2

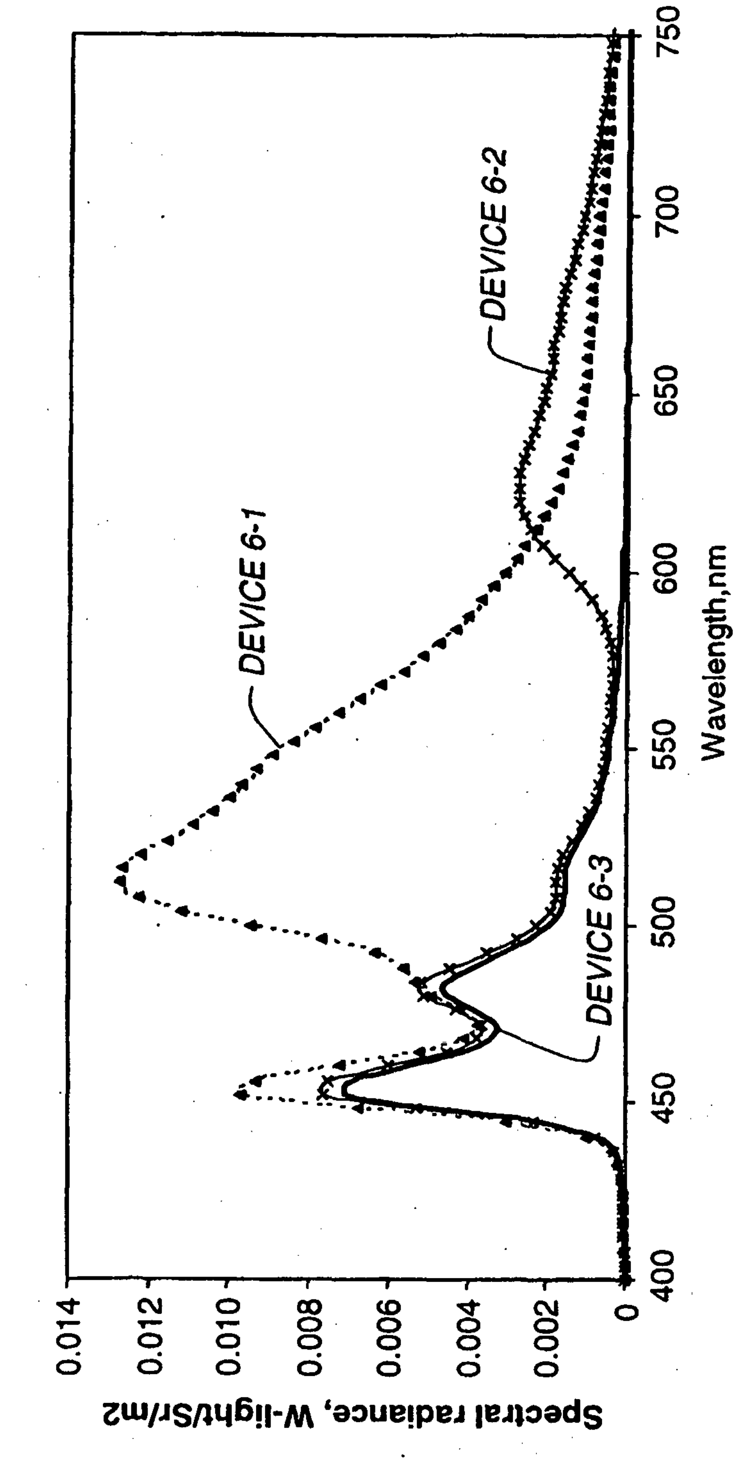
DEVICE 6-1
DEVICE 6-2
DEVICE 6-3
Spectral radiance, W-light/Sr/m2
0.014
0.012
0.010
0.008
0.006
0.004
0.002
0
400
450
500
550
600
650
700
750
Wavelength,nm

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 3172862 A, Gurnee
- US 3173050 A, Gurnee
- US 3710167 A, Dresner
- US 4356429 A
- US 4769292 A
- US 6303238 B1
- WO 200057676 A
- WO 200070655 A
- WO 200141512 A1
- WO 200202714 A2
- WO 2003040256 A2
- WO 2004016711 A1
- WO 2006097064 A, Pfeiffer
- US 20060232194 A1, Y.J. Tung
- US 20060125380 A1, Nagara
- JP 2007027620 A
- US 6936961 B2, Tang
- US 5935721 A
- US 4768292 A
- US 5141671 A
- US 5150006 A
- US 5151629 A
- US 5405709 A
- US 5484922 A
- US 5593788 A
- US 5645948 A
- US 5683823 A
- US 5755999 A
- US 5928802 A
- US 5935720 A
- US 6020078 A
- US 5121029 A
- JP 08333569 B
- WO 2005026088 A
- WO 2005033051 A
- US 2006141287 A
- EP 1719748 A
- JP 2003238516 B
- JP 2005320286 B
- US 20040076853 A
- US 6929871 B
- US 200502711899 A
- US 2002022151 A
- US 2006183042 A
- US 6824895 B1
- US 10729238 B
- WO 0057676 A
- WO 0070655 A
- WO 0141512 A1
- US 20020182441 A1
- US 20030017361 A1
- US 20030072964 A1
- US 6413656 B1
- US 6687266 B1
- US 20040086743 A1
- US 20040121184 A1
- US 20030059646 A1
- US 20030054198 A1
- EP 1239526 A2
- EP 1238981 A2
- EP 1244155 A2
- US 20020100906 A1
- US 20030068526 A1
- US 20030068535 A1
- JP 2003073387 A
- JP 2003073388 A
- US 6677060 B2
- US 20030235712 A1
- US 20040013905 A1
- US 6733905 B2
- US 6780528 B2
- US 20030040627 A1
- JP 2003059667 A
- JP 2003073665 A
- US 20020121638 A1
- EP 1371708 A1
- US 2003010877 A1
- WO 03040256 A2
- US 20030096138 A1
- US 20030173896 A1
- US 6670645 B2
- US 20040068132 A1
- WO 2004015025 A1
- US 20040072018 A1
- US 20020134984 A1
- WO 03079737 A2
- WO 2004020448 A1
- WO 03091355 A2
- US 10729402 B
- US 10729712 B
- US 10729738 B
- US 10729207 B
- US 10729263 B
- US 5766779 A
- US 3180730 A, Klupfel
- US 3567450 A, Brantley
- US 3658520 A
- US 4720432 A

- US 5061569 A
- WO 2006115700A2 A
- US 20040209115 A1
- US 20040209116 A1
- US 7175922 B
- US 20050106415 A
- AP 2004076853
- JP 2002359081 B
- US 5552678 A
- US 4885221 A
- US 5677572 A
- US 5059861 A
- US 5059862 A
- US 6140763 A
- US 4885211 A
- US 5247190 A
- JP 3234963 B
- US 5703436 A
- US 5608287 A
- US 5837391 A
- US 5776622 A
- US 5776623 A
- US 5714838 A
- US 5969474 A
- US 5739545 A
- US 5981306 A
- US 6137223 A
- US 6172459 B
- EP 1076368 A
- US 6278236 B
- US 62843936 B
- US 5276380 A
- EP 0732868 A
- US 6208075 B
- EP 0891121 A1
- EP 1029909 A1
- EP 1009041 A
- US 20060134460 A
- US 20020008233 A
- WO 0070655 A2
- WO 0141512 A
- WO 0193642 A1
- US 20030068528 A
- US 20030175553 A1
- US 4539507 A
- EP 1187235 A
- US 20020025419 A
- EP 1182244 A
- US 5503910 A
- US 5283182 A
- US 6337492 B
- US 7126267 B2
- US 6237529 B
- US 5294870 A
- US 5688551 A
- US 5851709 A
- US 6066357 A
- US 6226890 B

**Non-patent literature cited in the description**


- **DRESNER.** Double Injection Electroluminescence in Anthracene. *RCA Review,* 1969, vol. 30, 322
- **C. TANG et al.** *J. Applied Physics,* 1989, vol. 65, 3610
- **J. G. CALVERT ; J. N. PITTS, JR.** Photochemistry. Wiley, 1966
- **S. R. FORREST ; M. A. BALDO ; D. F. O'BRIEN ; M. E. THOMPSON ; S. R. FORREST.** *Phys. Rev. B,* 1999, vol. 60, 14422
- **M. A. BALDO ; S. R. FORREST.** *Phys. Rev. B,* 2000, vol. 62, 10956
- **K.A. KING ; P.J. SPELLANE ; R.J. WATTS.** *J. Am. Chem. Soc.,* 1985, vol. 107, 1431
- **M.G. COLOMBO ; T.C. BRUNOLD ; T. REIDENER ; H.U. GÜDEL ; M. FORTSCH ; H.-B. BÜRGI.** *Inorg. Chem.,* 1994, vol. 33, 545
- **Y. SUN et al.** *Nature,* 2006, vol. 440, 908-912
- Energy Transfer and Organic Photochemistry. **A. LAMOLA ; N. TURRO.** Technique of Organic Chemistry. Interscience Publishers, 1969, vol. XIV
- **J. BIRKS.** Photophysics of Aromatic Molecules. Wiley-Interscience, 1970
- **BALDO et al.** *Phys. Rev. B,* 2000, vol. 62, 10958-10966
- **S. L. MUROV ; I. CARMICHAEL ; G. L. HUG.** Handbook of Photochemistry. Marcel Dekker, 1993
- **C.E. JOHNSON et al.** *J. Am. Chem. Soc.,* 1983, vol. 105, 1795-1802
- **M. WRIGHTON ; D.L. MORSE.** *J. Am. Chem. Soc.,* 1974, vol. 96, 998-1003
- **D.J. STUFKENS.** *Comments Inorg. Chem.,* 1992, vol. 13, 359-385
- **V.W.W. YAM.** *Chem. Commun.,* 2001, 789-796
- **Y. MA et al.** *Synthetic Metals,* 1998, vol. 94, 245-248
- **J. KIDO et al.** *Chem Lett.,* 1990, vol. 657
- *J Alloys and Compounds,* 1993, vol. 192, 30-33
- *Jpn J Appl Phys,* 1996, vol. 35, L394-6
- *Appl. Phys. Lett.,* 1994, vol. 65, 2124
- **C. ADACHI ; R. KWONG ; S.R. FORREST.** *Organic Electronics,* 2001, vol. 2, 37-43
- Lange's handbook of Chemistry. McGraw Hill, 1979, 3-1343-138